# EUROPEAN PATENT APPLICATION

(11) **EP 4 215 535 A1**
(43) Date of publication of application: **26.07.2023**
(21) Application number: 22152963.9
(22) Date of filing: 24.01.2022
(51) Int. Cl.: C07F 5/02, C09K 11/00, H01L 51/50

(54) **COMPOUND AND AN ORGANIC ELECTROLUMINESCENCE DEVICE COMPRISING THE COMPOUND**

(71) Applicant: Idemitsu Kosan Co.,Ltd., Tokyo 100-8321 (JP)
(72) Inventor: Nishimae, Yuichi, 4058 Basel (CH)
(74) Representative: Hollah, Dorothee

(57) **Abstract**

The present invention relates to specific compounds, a material, preferably an emitter material, for an organic electroluminescence device comprising said specific compounds, an organic electroluminescence device comprising said specific compounds, an electronic equipment comprising said organic electroluminescence device, a light emitting layer comprising at least one host and at least one dopant, wherein the dopant comprises at least one of said specific compounds, and the use of said compounds in an organic electroluminescence device. 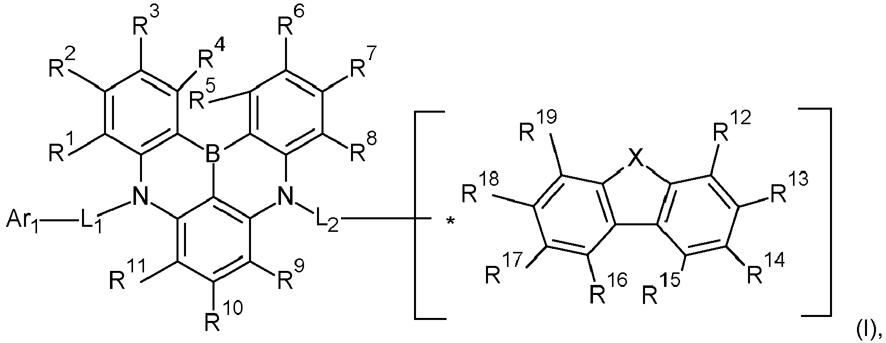 wherein at least one of R¹, R², R³, R⁴, R⁵, R⁶, R⁷, R⁸, R⁹ and R¹¹, represents an amino group NR⁸⁴R⁸⁵.

## Description

The present invention relates to specific compounds, a material, preferably an emitter material, for an organic electroluminescence device comprising said specific compounds, an organic electroluminescence device comprising said specific compounds, an electronic equipment comprising said organic electroluminescence device, a light emitting layer comprising at least one host and at least one dopant, wherein the dopant comprises at least one of said specific compounds, and the use of said compounds in an organic electroluminescence device.

When a voltage is applied to an organic electroluminescence device (hereinafter may be referred to as an organic EL device), holes are injected to an emitting layer from an anode and electrons are injected to an emitting layer from a cathode. In the emitting layer, injected holes and electrons are re-combined and excitons are formed.

An organic EL device comprises an emitting layer between the anode and the cathode. Further, there may be a case where it has a stacked layer structure comprising an organic layer such as a hole-injecting layer, a hole-transporting layer, an electron-injecting layer, an electron-transporting layer, etc.

WO2019132028 A1 relates to a compound represented by formula (1) and an organic electroluminescent device using the same.

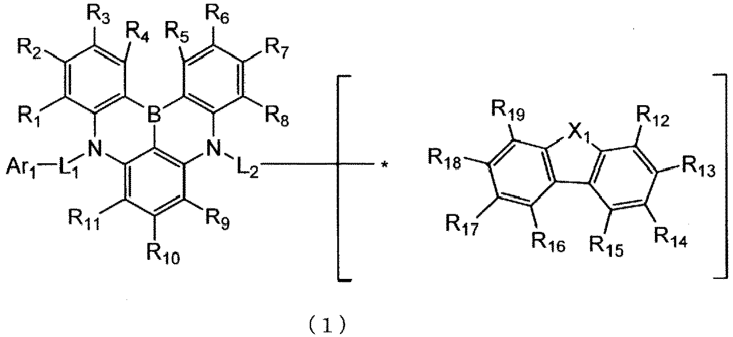

JP2021014446 A relates to a multimer of a polycyclic aromatic compound represented by the following general formula (1) or a polycyclic aromatic compound having a plurality of structures represented by the following general formula (1). 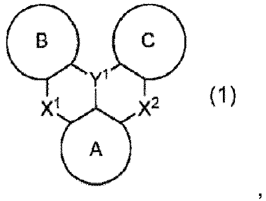 wherein at least one hydrogen in at least one ring of the C ring is substituted with a group represented by the above formula (Am), 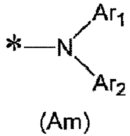 in which Ar₁ and Ar₂ are independently aryl or hetero, respectively.

WO2021049889 A1 relates to a compound represented by the following formula (1): 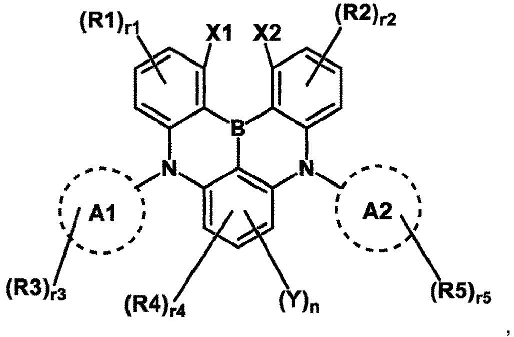 wherein Y is an alkyl group having 1 to 3 carbon atoms substituted with deuterium; or represented by the following formula (2), 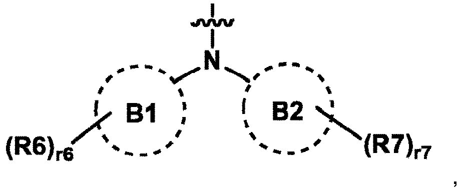 wherein when Y is represented by Formula 2, at least one of X1, X2 and R1 to R7 is an alkyl group having 1 to 3 carbon atoms substituted with deuterium.

US20200176679 A1 relates to a compound represented by formula 1 as an organic compound having narrow light emission spectrum and full width half the maximum and capable of suppressing the concentration quenching phenomenon in spite of high doping concentration. 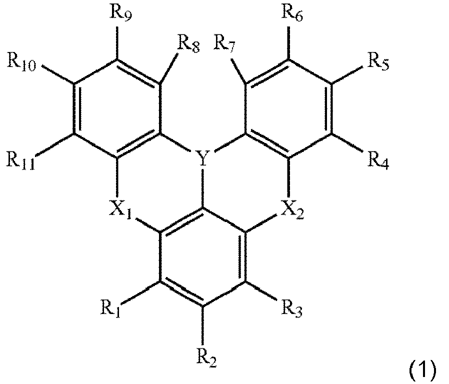 wherein Y is B, P(=O) or P(=S) and X₁ and X₂ are the same as or different from each other, and are each independently selected from the group consisting of O, S, Se and N(R₁₂).

The compound of formula 1 includes at least one or more substituted or unsubstituted cycloalkyl groups having 1 to 20 carbon atoms.

The specific structure and substitution pattern of compounds has a significant impact on the performance of the compounds in organic electronic devices.

Notwithstanding the developments described above, there remains a need for organic electroluminescence devices comprising new materials, especially dopant (= emitter) materials, to provide improved performance of electroluminescence devices.

Accordingly, it is an object of the present invention, with respect to the aforementioned related art, to provide materials suitable for providing organic electroluminescence devices which ensure good performance of the organic electroluminescence devices, especially good EQEs and/or a long lifetime. More particularly, it should be possible to provide dopant (= emitter) materials, especially blue light emitting dopant materials having a narrow spectrum (small FWHM), i.e. good color purity when used as dopant in organic electroluminescence devices.

Said object is according to one aspect of the present invention solved by a compound represented by formula (I): 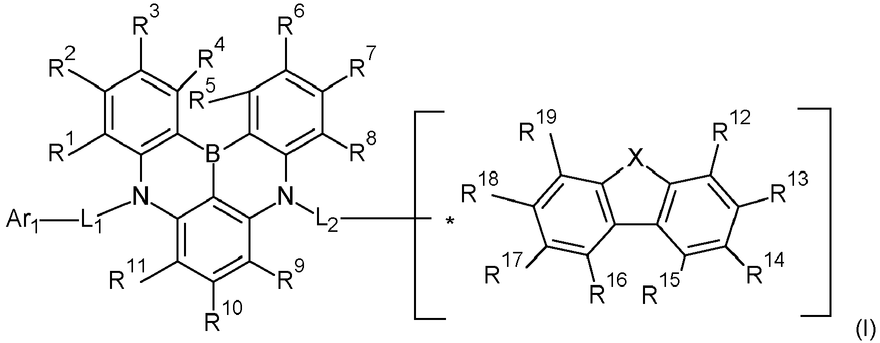 wherein
R¹, R², R³, R⁴, R⁵, R⁶, R⁷, R⁸, R⁹, R¹⁰ and R¹¹ each independently represents hydrogen; an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; NO₂; OR²⁰; SR²¹; C(=O)R²²; COOR²³; SiR²⁴R²⁵R²⁶; NR⁸⁴R⁸⁵, or halogen; preferably hydrogen; an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; NO₂; OR²⁰; SR²¹; C(=O)R²²; COOR²³; SiR²⁴R²⁵R²⁶; NR⁸⁴R⁸⁵, or halogen; or
two adjacent residues together form a ring structure which is unsubstituted or substituted; wherein at least one of R¹, R², R³, R⁴, R⁵, R⁶, R⁷, R⁸, R⁹ and R¹¹, preferably at least one of R¹, R², R³, R⁴, R⁵, R⁶, R⁷ and R⁸, represents an amino group NR⁸⁴R⁸⁵;
R⁸⁴ and R⁸⁵ each independently represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;
R¹², R¹³, R¹⁴, R¹⁵, R¹⁶, R¹⁷, R¹⁸ and R¹⁹ each independently represents hydrogen; an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; NO₂; OR²⁰; SR²¹; C(=O)R²²; COOR²³; SiR²⁴R²⁵R²⁶; NR⁸⁴R⁸⁵, or halogen; or
two adjacent residues together form a ring structure which is unsubstituted or substituted: wherein one of R¹², R¹³, R¹⁴, R¹⁵, R¹⁶, R¹⁷, R¹⁸ and R¹⁹ is a bonding site to L₂;
X is O or S;
L₁ represents a direct bond, an unsubstituted or substituted divalent aromatic hydrocarbon group containing 6 to 30 ring atoms, an unsubstituted or substituted divalent alkyl group having 1 to 20 carbon atoms or an unsubstituted or substituted divalent heteroaromatic group containing 3 to 30 ring atoms;
L₂ represents an unsubstituted or substituted divalent aromatic hydrocarbon group containing 6 to 30 ring atoms, an unsubstituted or substituted divalent alkyl group having 1 to 20 carbon atoms or an unsubstituted or substituted divalent heteroaromatic group containing 3 to 30 ring atoms;
Ar₁ represents an aryl group having from 6 to 60 ring carbon atoms which is unsubstituted or substituted; a heteroaryl group having from 5 to 60 ring atoms which is unsubstituted or substituted or an alkyl group having from 1 to 20 carbon atoms which is unsubstituted or substituted; R²⁰, R²¹, R²² and R²³ each independently represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;
R²⁴, R²⁵ and R²⁶ each independently represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted.

The compounds of formula (I) can be in principal used in any layer of an EL device. Preferably, the compound of formula (I) is a dopant (= emitter) in organic EL elements, especially in the light-emitting layer, more preferably a fluorescent dopant. Particularly, the compounds of formula (I) are used as fluorescent dopants in organic EL devices, especially in the light-emitting layer.

The term organic EL device (organic electroluminescence device) is used interchangeably with the term organic light-emitting diode (OLED) in the present application.

It has been found that the specific compounds of formula (I) show a narrow emission characteristic, preferably a narrow fluorescence, more preferably a narrow blue fluorescence. Such a narrow emission characteristic is suitable to prevent energy losses by outcoupling. The compounds of formula (I) according to the present invention preferably have a Full width at half maximum (FWHM) of lower than 30 nm, more preferably lower than 25 nm.

It has further been found that organic EL devices comprising the compounds of the present invention are generally characterized by high external quantum efficiencies (EQE) and long lifetimes, especially when the specific compounds of formula (I) are used as dopants (light emitting material), especially fluorescent dopants in organic electroluminescence devices.

Examples of the optional substituent(s) indicated by "substituted or unsubstituted" and "may be substituted" referred to above or hereinafter include an aryl group having from 6 to 60, preferably from 6 to 30, more preferably from 6 to 18 ring carbon atoms which is in turn unsubstituted or substituted, a heteroaryl group having from 5 to 60, preferably 5 to 30, more preferably 5 to 18 ring atoms which is in turn unsubstituted or substituted, an alkyl group having 1 to 20, preferably 1 to 8 carbon atoms, a cycloalkyl group having 3 to 20, preferably 3 to 6 carbon atoms, a group OR²⁰, an alkylhalide group having 1 to 20, preferably 1 to 8 carbon atoms, a halogen atom (fluorine, chlorine, bromine, iodine), CN, C(=O)R²², COOR²³, a carboxamidalkyl group having 1 to 20 carbon atoms, preferably 1 to 8 carbon atoms, a silyl group SiR²⁴R²⁵R²⁶, B(R²¹)₂, a group SR²¹, NO₂ and a carboxamidaryl group having 6 to 18 ring carbon atoms in the aryl residue;
or
two adjacent substituents together form a ring structure which is in turn unsubstituted or substituted;
R²⁰, R²¹, R²², R²³, R²⁴, R²⁵ and R²⁶ are defined above.

The terms hydrogen, halogen, an alkyl group having from 1 to 20 carbon atoms which is unsubstituted or substituted, an alkylhalide group having from 1 to 20 carbon atoms which is unsubstituted or substituted, a cycloalkyl group having from 3 to 20 ring carbon atoms which is unsubstituted or substituted, a substituted or unsubstituted aryl group having 6 to 60, preferably from 6 to 30, more preferably from 6 to 18 ring carbon atoms; a substituted or unsubstituted heteroaryl group having 5 to 60, preferably 5 to 30, more preferably 5 to 18 ring atoms, C(=O)R²², a carboxamidalkyl group having 1 to 20 carbon atoms, preferably 1 to 8 carbon atoms, a carboxamidaryl group having 6 to 18 ring carbon atoms in the aryl residue, OR²⁰, SR²¹, C(=O)R²², COOR²³, SiR²⁴R²⁵R²⁶, an aralkyl group having from 7 to 60 carbon atoms which is unsubstituted or substituted, an alkenyl group having from 2 to 20 carbon atoms which is unsubstituted or substituted and an alkynyl group having from 2 to 20 carbon atoms which is unsubstituted or substituted
are known in the art and generally have the following meaning, if said groups are not further specified in specific embodiments mentioned below:
In the invention, hydrogen includes isomers differing in the number of neutrons, i.e. protium, deuterium and tritium.

The substituted or unsubstituted aryl group having 6 to 60, preferably from 6 to 30, more preferably from 6 to 18 ring carbon atoms most preferably having from 6 to 13 ring carbon atoms, may be a non-condensed aromatic group or a condensed aromatic group. Specific examples thereof include phenyl group, naphthyl group, phenanthryl group, biphenyl group, terphenyl group, fluoranthenyl group, triphenylenyl group, phenanthrenyl group, fluorenyl group, indenyl group, anthracenyl, chrysenyl, spirofluorenyl group, benzo[c]phenanthrenyl group, with phenyl group, naphthyl group, biphenyl group, terphenyl group, phenanthryl group, triphenylenyl group, fluorenyl group, indenyl group and fluoranthenyl group being preferred, phenyl group, 1-naphthyl group, 2-naphthyl group, biphenyl-2-yl group, biphenyl-3-yl group, biphenyl-4-yl group, phenanthrene-9-yl group, phenanthrene-3-yl group, phenanthrene-2-yl group, triphenylene-2-yl group, fluorene-2-yl group, especially a 9,9-di-C₁₋₂₀alkylfluorene-2-yl group, like a 9,9-dimethylfluorene-2-yl group, a 9,9-di-e₆₋₁₈arylfluorene-2-yl group, like a 9,9-diphenylfluorene-2-yl group, or a 9,9-di-C₅₋₁₈heteroarylfluorene-2-yl group, 1,1-dimethylindenyl group, fluoranthene-3-yl group, fluoranthene-2-yl group and fluoranthene-8-yl group being more preferred, and phenyl group being most preferred.

The substituted or unsubstituted heteroaryl group having 5 to 60, preferably 5 to 30, more preferably 5 to 18 ring atoms, most preferably having from 5 to 13 ring atoms, may be a non-condensed heteroaromatic group or a condensed heteroaromatic group. Specific examples thereof include the residues of pyrrole ring, isoindole ring, benzofuran ring, isobenzofuran ring, benzothiophene, dibenzothiophene ring, isoquinoline ring, quinoxaline ring, quinazoline, phenanthridine ring, phenanthroline ring, pyridine ring, pyrazine ring, pyrimidine ring, pyridazine ring, indole ring, quinoline ring, acridine ring, carbazole ring, furan ring, thiophene ring, benzoxazole ring, benzothiazole ring, benzimidazole ring, dibenzofuran ring, triazine ring, oxazole ring, oxadiazole ring, thiazole ring, thiadiazole ring, triazole ring, imidazole ring, indolidine ring, imidazopyridine ring, 4-imidazo[1,2-a]benzimidazoyl, 5-benzimidazo[1,2-a]benzimidazoyl, and benzimidazolo[2,1-b][1,3]benzothiazolyl, with the residues of benzofuran ring, indole ring, benzothiophene ring, dibenzofuran ring, carbazole ring, and dibenzothiophene ring being preferred, and the residues of benzofuran ring, 1-phenylindol ring, benzothiophene ring, dibenzofuran-1-yl group, dibenzofuran-3-yl group, dibenzofuran-2-yl group, dibenzofuran-4-yl group, 9-phenyl-carbazole-3-yl group, 9-phenylcarbazole-2-yl group, 9-phenylcarbazole-4-yl group, dibenzothiophene-2-yl group, and dibenzothiophene-4-yl, dibenzothiophene-1-yl group, and dibenzothiophene-3-yl group being more preferred.

Examples of the alkyl group having from 1 to 20 carbon atoms which is unsubstituted or substituted include methyl group, ethyl group, n-propyl group, isopropyl group, n-butyl group, s-butyl group, isobutyl group, t-butyl group, n-pentyl group, n-hexyl group, n-heptyl group, n-octyl group, n-nonyl group, n-decyl group, n-undecyl group, n-dodecyl group, n-tridecyl group, n-tetradecyl group, n-pentadecyl group, n-hexadecyl group, n-heptadecyl group, n-octadecyl group, neopentyl group, 1-methylpentyl group, with methyl group, ethyl group, n-propyl group, isopropyl group, n-butyl group, s-butyl group, isobutyl group, t-butyl group being preferred. Preferred are alkyl groups having 1 to 8 carbon atoms, more preferably 1 to 4 carbon atoms. Suitable examples for alkyl groups having 1 to 8 carbon atoms respectively 1 to 4 carbon atoms are mentioned before.

Examples of the alkylhalide group having from 1 to 20 carbon atoms which is unsubstituted or substituted include those disclosed as alkyl groups wherein the hydrogen atoms thereof are partly or entirely substituted by halogen atoms. Preferred alkylhalide groups are fluoroalkyl groups having 1 to 20 carbon atoms including the alkyl groups mentioned above wherein the hydrogen atoms thereof are partly or entirely substituted by fluorine atoms, for example CF₃.

Examples of the alkenyl group having from 2 to 20 carbon atoms which is unsubstituted or substituted include ethene group, n-propene group, isopropene group, n-butene group, isobutene group, n-pentene group, n-hexene group, n-heptene group, n-octene group, n-nonene group, n-decene group, n-undecene group, n-dodecene group, n-tridecene group, n-tetradecene group, n-pentadecene group, n-hexadecene group, n-heptadecene group, n-octadecene group, with ethene group, n-propene group, isopropene group, n-butene group, isobutene group being preferred. Preferred are alkenyl groups having 2 to 8 carbon atoms, more preferably 2 to 4 carbon atoms. Suitable examples for alkenyl groups having 2 to 8 carbon atoms respectively 2 to 4 carbon atoms are mentioned before.

Examples of the alkynyl group having from 2 to 20 carbon atoms which is unsubstituted or substituted include ethynyl group, n-propynyl group, n-butynyl group, n-pentynyl group, n-hexynyl group, n-heptynyl group, n-octynyl group, with ethynyl group, n-propynyl group, n-butynyl group being preferred. Preferred are alkynyl groups having 2 to 8 carbon atoms, more preferably 2 to 4 carbon atoms. Suitable examples for alkynyl groups having 2 to 8 carbon atoms respectively 2 to 4 carbon atoms are mentioned before.

Examples of the cycloalkyl group having from 3 to 20 ring carbon atoms which is unsubstituted or substituted include cyclopropyl group, cyclobutyl group, cyclopentyl group, cyclohexyl group, cyclooctyl group, and adamantyl group, with cyclopentyl group, and cyclohexyl group being preferred. Preferred are cycloalkyl groups having 3 to 6 carbon atoms. Suitable examples for cycloalkyl groups having 3 to 6 carbon atoms are mentioned before.

An example for an aralkyl group having from 7 to 60 carbon atoms which is unsubstituted or substituted includes a benzyl group.

Examples of halogen atoms include fluorine, chlorine, bromine, and iodine, with fluorine being preferred.

The group OR²⁰ is preferably a C₁₋₂₀alkoxy group or a C₆₋₁₈aryloxy group. Examples of an alkoxy group having 1 to 20 carbon atoms, preferably 1 to 8 carbon atoms, include those having an alkyl portion selected from the alkyl groups mentioned above. Examples of an aryloxy group having 6 to 18 ring carbon atoms include those having an aryl portion selected from the aryl groups mentioned above, for example -OPh.

The group SR²¹ is preferably a C₁₋₂₀alkylthio group or a C₆₋₁₈arylthio group. Examples of an alkylthio group having 1 to 20 carbon atoms, preferably 1 to 8 carbon atoms, include those having an alkyl portion selected from the alkyl groups mentioned above. Examples of an arylthio group having 6 to 18 ring carbon atoms include those having an aryl portion selected from the aryl groups mentioned above, for example -SPh.

The group SiR²⁴R²⁵R²⁶ is preferably a C₁₋₂₀alkyl and/or C₆₋₁₈aryl substituted silyl group. Preferred examples of C₁₋₂₀alkyl and/or C₆₋₁₈aryl substituted silyl groups include alkylsilyl groups having 1 to 8 carbon atoms in each alkyl residue, preferably 1 to 4 carbon atoms, including trimethylsilyl group, triethylsilyl group, tributylsilyl group, dimethylethylsilyl group, t-butyldimethylsilyl group, propyldimethylsilyl group, dimethylisopropylsilyl group, dimethylpropylsilyl group, dimethylbutylsilyl group, dimethyltertiarybutylsilyl group, diethylisopropylsilyl group, and arylsilyl groups having 6 to 18 ring carbon atoms in each aryl residue, preferably triphenylsilyl group, and alkyl/arylsilyl groups, preferably phenyldimethylsilyl group, diphenylmethylsilyl group, and diphenyltertiarybutylsilyl group, with diphenyltertiarybutylsilyl group and t-butyldimethylsilyl group being preferred.

Examples of a carboxamidalkyl group (alkyl substituted amide group) having 1 to 20 carbon atoms, preferably 1 to 8 carbon atoms include those having an alkyl portion selected from the alkyl groups mentioned above.

Examples of a carboxamidaryl group (aryl substituted amide group) having 6 to 18 carbon atoms, preferably 6 to 13 carbon atoms, include those having an aryl portion selected from the aryl groups mentioned above.

The optional substituents preferably each independently represents an aryl group having from 6 to 18 ring carbon atoms which is unsubstituted or substituted; a heteroaryl group having from 5 to 18 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; halogen, CN; SiR²⁴R²⁵R²⁶, SR²¹ or OR²⁰;
or
two adjacent substituents together form a ring structure which is in turn unsubstituted or substituted.

More preferably, the optional substituents each independently represents an aryl group having from 6 to 18 ring carbon atoms which is unsubstituted or substituted; a heteroaryl group having from 5 to 18 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted; halogen, SiR²⁴R²⁵R²⁶ or CN;
or
two adjacent substituents together form a ring structure which is in turn unsubstituted or substituted.

Most preferably, the optional substituents each independently represents an alkyl group having 1 to 4 carbon atoms which is unsubstituted or substituted; a cycloalkyl group having from 3 to 6 ring carbon atoms which is unsubstituted or substituted; an aryl group having 6 to 13 ring carbon atoms which is unsubstituted or substituted; a heteroaryl group having from 5 to 13 ring atoms which is unsubstituted or substituted; halogen, SiR²⁴R²⁵R²⁶ or CN.

R²⁰, R²¹ and R²² each independently represents an aryl group having from 6 to 18 ring carbon atoms which is unsubstituted or substituted; a heteroaryl group having from 5 to 18 ring atoms which is unsubstituted or substituted and which is linked via a carbon atom to N or O or S; an alkyl group having from 1 to 20 carbon atoms which is unsubstituted or substituted; or a cycloalkyl group having from 3 to 20 ring carbon atoms which is unsubstituted or substituted, preferably an aryl group having from 6 to 18 ring carbon atoms which is unsubstituted or substituted; or an alkyl group having from 1 to 20 carbon atoms which is unsubstituted or substituted.

R²⁴, R²⁵ and R²⁶ represents an aryl group having from 6 to 18 ring carbon atoms which is unsubstituted or substituted; a heteroaryl group having from 5 to 18 ring atoms which is unsubstituted or substituted; an alkyl group having from 1 to 20 carbon atoms which is unsubstituted or substituted; a cycloalkyl group having from 3 to 20 ring carbon atoms which is unsubstituted or substituted.

The optional substituents mentioned above may be further substituted by one or more of the optional substituents mentioned above.

The number of the optional substituents depends on the group which is substituted by said substituent(s). The maximum number of possible substituents is defined by the number of hydrogen atoms present. Preferred are 1, 2, 3, 5, 6, 7, 8 or 9 optional substituents per group which is substituted, more preferred are 1, 2, 3, 5, 5, 6 or 7 optional substituents, most preferred are 1, 2, 3, 4 or 5 optional substituents, further most preferred are 1, 2, 3, 4 or 5 optional substituents, even further most preferred are 1, 2, 3 or 4 optional substituents and even more further most preferred are 1 or 2 optional substituents per group which is substituted. In a further preferred embodiment, some or all of the groups mentioned above are unsubstituted.

In a further preferred embodiment, the total number of substituents in the compound of formula (I) is 0, 1, 2, 3, 4, 5, 6, 7 or 8, preferably 0, 1, 2, 3, 4, 5, or 6, i.e. the remaining residues are hydrogen.

The "carbon number of a to b" in the expression of "substituted or unsubstituted X group having a to b carbon atoms" is the carbon number of the unsubstituted X group and does not include the carbon atom(s) of an optional substituent.

The term "unsubstituted" referred to by "unsubstituted or substituted" means that a hydrogen atom is not substituted by one the groups mentioned above.

An index of 0 in the definition in any formula mentioned above and below means that a hydrogen atom is present at the position defined by said index.

Examples for ring structures formed by two adjacent substituents are shown below: 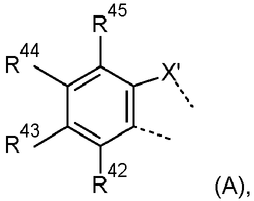 e.g. 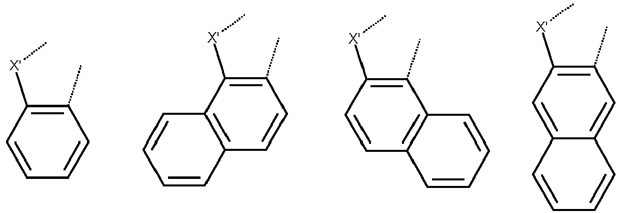 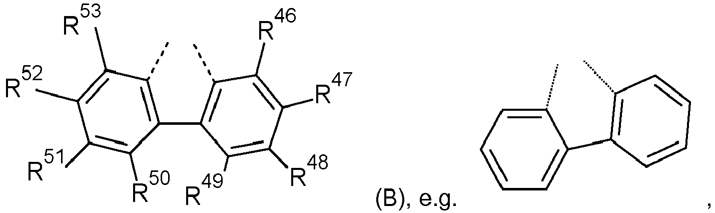 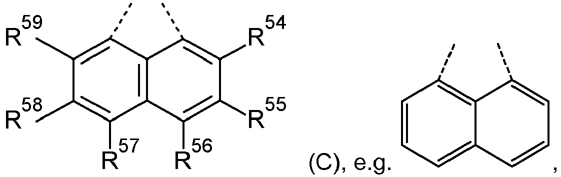 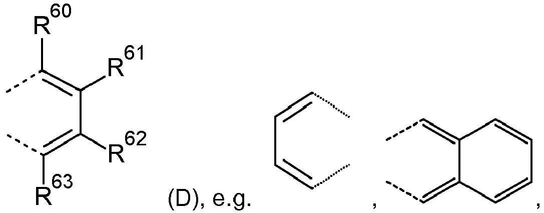 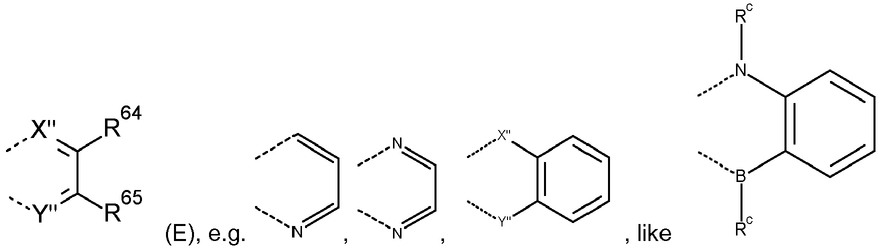 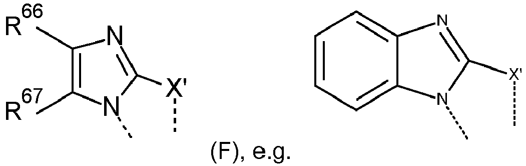 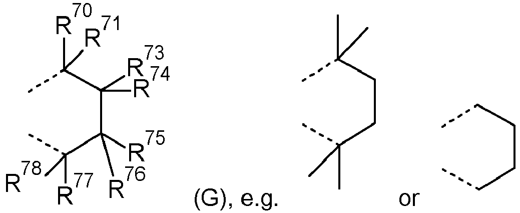 wherein
X' represents O, S or CR⁶⁸R⁶⁹;
R⁴², R⁴³, R⁴⁴, R⁴⁵, R⁴⁶, R⁴⁷, R⁴⁸, R⁴⁹, R⁵⁰, R⁵¹, R⁵², R⁵³, R⁵⁴, R⁵⁵, R⁵⁶, R⁵⁷, R⁵⁸, R⁵⁹, R⁶⁰, R⁶¹, R⁶², R⁶³, R⁶⁴, R⁶⁵, R⁶⁶ and R⁶⁷, R⁷⁰, R⁷¹, R⁷², R⁷³, R⁷⁴, R⁷⁵, R⁷⁶, R⁷⁷ and R⁷⁸ each independently represents hydrogen, an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted; or
two adjacent residues together form a ring structure which is unsubstituted or substituted, wherein the dotted lines are bonding sites;
R⁶⁸ and R⁶⁹ each independently represents hydrogen; an aryl group having from 6 to 60 ring carbon atoms which is unsubstituted or substituted; a heteroaryl group having from 5 to 60 ring atoms which is unsubstituted or substituted or an alkyl group having from 1 to 20 carbon atoms which is unsubstituted or substituted;
or
R⁶⁸ and R⁶⁹ together form an aromatic ring structure having from 3 to 13 ring atoms which is unsubstituted or substituted or an aliphatic ring structure having from 3 to 9 ring atoms which is unsubstituted or substituted;
X" and Y" each independently represents O, CR^{c}R^{d}, S, BR^{e} or NR^{e},
R^{c} and R^{d} each independently represents C₁ to C₈ alkyl or substituted or unsubstituted C₆ to C₁₈ aryl, preferably C₁ to C₄ alkyl or substituted or unsubstituted C₆ to C₁₀ aryl, more preferably methyl or unsubstituted or substituted phenyl,
R^{e} represents C₁ to C₈ alkyl, preferably C₁ to C₄ alkyl, or substituted or unsubstituted C₆ to C₁₀ aryl, preferably unsubstituted or substituted phenyl,
and
the dotted lines are bonding sites.

Preferred examples for ring structures formed by two adjacent substituents are the ring structures (A), (D) and (G), more preferred ring structures formed by two adjacent substituents are

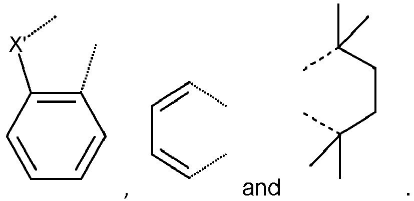

### The compounds of formula (I)

In the compounds represented by formula (I)
at least one of, preferably one of R¹, R², R³, R⁴, R⁵, R⁶, R⁷, R⁸, R⁹, R¹⁰ and R¹¹, preferably at least one, preferably one of of R¹, R², R³, R⁴, R⁵, R⁶, R⁷ and R⁸ represents an amino group NR⁸⁴R⁸⁵, preferably an amino group NAr₂Ar₃. More preferably, R² and/or R⁷ represents an amino group NR⁸⁴R⁸⁵, preferably an amino group NAr₂Ar₃, most preferably R⁷ or R² represents an amino group NR⁸⁴R⁸⁵, preferably an amino group NAr₂Ar₃, further most preferably R⁷ represents an amino group NR⁸⁴R⁸⁵, preferably an amino group NAr₂Ar₃,and the remaining residues do not represent an amino group NR⁸⁴R⁸⁵.

In the amino group NR⁸⁴R⁸⁵:
R⁸⁴ and R⁸⁵ each independently represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted, preferably an aryl group having from 6 to 60 ring carbon atoms which is unsubstituted or substituted; a heteroaryl group having from 5 to 60 ring atoms which is unsubstituted or substituted; or an alkyl group having from 1 to 20 carbon atoms which is unsubstituted or substituted; more preferably an aryl group having from 6 to 18 ring carbon atoms which IK21/740072EP is unsubstituted or substituted; a heteroaryl group having from 5 to 18 ring atoms which is unsubstituted or substituted; or an alkyl group having from 1 to 8 carbon atoms which is unsubstituted or substituted.

Preferably, the amino group NR⁸⁴R⁸⁵ is represented by the following formula NAr₂Ar₃, wherein
Ar₂ and Ar₃ each independently represents an aryl group having from 6 to 60 ring carbon atoms which is unsubstituted or substituted; a heteroaryl group having from 5 to 60 ring atoms which is unsubstituted or substituted, preferably, Ar₂ and Ar₃ each independently represents an aryl group having from 6 to 18 ring carbon atoms which is unsubstituted or substituted; a heteroaryl group having from 5 to 18 ring atoms which is unsubstituted or substituted.

More preferably, the the amino group NAr₂Ar₃ is represented by the following formula (II): 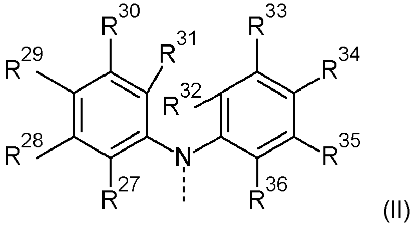 wherein
R²⁷, R²⁸, R²⁹, R³⁰, R³¹, R³², R³³, R³⁴, R³⁵ and R³⁶ each independently represents hydrogen, an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted, halogen, SiR²⁴R²⁵R²⁶ or CN;
or
two adjacent residues R²⁷, R²⁸, R²⁹, R³⁰ and R³¹ and/or two adjacent residues R³², R³³, R³⁴, R³⁵ and R³⁶ together form a ring structure which is unsubstituted or substituted, preferably
R²⁷, R²⁸, R²⁹, R³⁰, R³¹, R³², R³³, R³⁴, R³⁵ and R³⁶ each independently represents hydrogen, an aryl group having from 6 to 10 ring carbon atoms which is unsubstituted or substituted, or
two adjacent residues R²⁷, R²⁸, R²⁹, R³⁰ and R³¹ and/or two adjacent residues R³², R³³, R³⁴, R³⁵ and R³⁶ together form a ring structure of the following formula (A) or (D), preferably of the following formula (A) 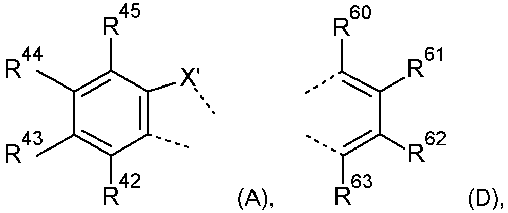 wherein
   X' represents O, S or CR⁶⁸R⁶⁹, NR⁸⁶;
   R⁴², R⁴³, R⁴⁴, R⁴⁵, R⁶⁰, R⁶¹, R⁶² and R⁶³ each independently represents hydrogen, an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or halogen, SiR²⁴R²⁵R²⁶ or CN;
   or
   two adjacent residues together form a ring structure which is unsubstituted or substituted, wherein the dotted lines are bonding sites;
   R⁶⁸ and R⁶⁹ each independently represents hydrogen; an aryl group having from 6 to 60 ring carbon atoms which is unsubstituted or substituted; a heteroaryl group having from 5 to 60 ring atoms which is unsubstituted or substituted or an alkyl group having from 1 to 20 carbon atoms which is unsubstituted or substituted;
   or
   R⁶⁸ and R⁶⁹ together form an aromatic ring structure having from 3 to 13 ring atoms which is unsubstituted or substituted or an aliphatic ring structure having from 3 to 9 ring atoms which is unsubstituted or substituted;
   R⁸⁶ represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted, preferably an aryl group having from 6 to 60 ring carbon atoms which is unsubstituted or substituted; a heteroaryl group having from 5 to 60 ring atoms which is unsubstituted or substituted or an alkyl group having from 1 to 20 carbon atoms which is unsubstituted or substituted.

Preferably, 0, 1 or 2 of R²⁷, R²⁸, R²⁹, R³⁰ and R³¹ and/or 0, 1 or 2 of R³², R³³, R³⁴, R³⁵ and R³⁶ each independently represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted, preferably an aryl group having from 6 to 10 ring carbon atoms which is unsubstituted or substituted or an alkyl group having from 1 to 4 carbon atoms,
or
two adjacent residues R²⁷, R²⁸, R²⁹, R³⁰ and R³¹ and/or two adjacent residues R³², R³³, R³⁴, R³⁵ and R³⁶ together form a ring structure which is unsubstituted or substituted, preferably a ring structure of the following formula (A) or (D), more preferably of the following formula (A) 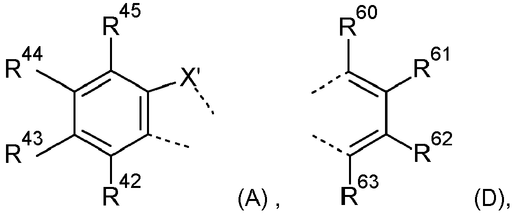
X' represents O, S or CR⁶⁸R⁶⁹, NR⁸⁶, preferably O;
R⁴², R⁴³, R⁴⁴, R⁴⁵, R⁶⁰, R⁶¹, R⁶² and R⁶³ each independently represents hydrogen, an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted; preferably hydrogen, an aryl group having from 6 to 13 ring carbon atoms which is unsubstituted or substituted; a heteroaryl group having from 5 to 13 ring atoms which is unsubstituted or substituted; an alkyl group having from 1 to 4 carbon atoms which is unsubstituted or substituted; more preferably, R⁴², R⁴³, R⁴⁴ and R⁴⁵ are hydrogen; and
R⁶⁸ and R⁶⁹ each independently represents hydrogen; an aryl group having from 6 to 13 ring carbon atoms which is unsubstituted or substituted; a heteroaryl group having from 5 to 13 ring atoms which is unsubstituted or substituted or an alkyl group having from 1 to 4 carbon atoms which is unsubstituted or substituted;
R⁸⁶ represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted, preferably an aryl group having from 6 to 60 ring carbon atoms which is unsubstituted or substituted; a heteroaryl group having from 5 to 60 ring atoms which is unsubstituted or substituted or an alkyl group having from 1 to 20 carbon atoms which is unsubstituted or substituted;
and
the remaining residues of R²⁷, R²⁸, R²⁹, R³⁰, R³¹, R³², R³³, R³⁴, R³⁵ and R³⁶ are hydrogen, an aryl group having from 6 to 10 ring carbon atoms which is unsubstituted or substituted or an alkyl group having from 1 to 4 carbon atoms,
or
two adjacent residues R²⁷, R²⁸, R²⁹, R³⁰ and R³¹ and/or two adjacent residues R³², R³³, R³⁴, R³⁵ and R³⁶ together form a ring structure of the abovementioned formula (A) or (D), more preferably of the following formula (A).

More preferably, R²⁷, R²⁸, R²⁹, R³⁰, R³¹, R³², R³³, R³⁴, R³⁵ and R³⁶ are hydrogen, an aryl group having from 6 to 10 ring carbon atoms which is unsubstituted or substituted or an alkyl group having from 1 to 4 carbon atoms,
or
two adjacent residues R²⁷, R²⁸, R²⁹, R³⁰ and R³¹ and/or two adjacent residues R³², R³³, R³⁴, R³⁵ and R³⁶ together form a ring structure of the abovementioned formula (A) or (D), more preferably of the formula (A).

L₁ represents a direct bond, an unsubstituted or substituted divalent aromatic hydrocarbon group containing 6 to 30 ring atoms, an unsubstituted or substituted divalent alkyl group having 1 to 20 carbon atoms or an unsubstituted or substituted divalent heteroaromatic group containing 3 to 30 ring atoms;
preferably, L₁ represents a direct bond, an unsubstituted or substituted divalent aromatic hydrocarbon group containing 6 to 30 ring atoms, an unsubstituted or substituted divalent heteroaromatic group containing 3 to 30 ring atoms;
more preferably, L₁ represents a direct bond, an unsubstituted or substituted divalent aromatic hydrocarbon group containing 6 to 24 ring atoms, preferably 6 to 18 ring atoms, or an unsubstituted or substituted divalent heteroaromatic group containing 3 to 24 ring atoms, preferably 3 to 18 ring atoms;
further more preferably, L₁ represents a direct bond, an unsubstituted or substituted divalent phenyl group, an unsubstituted or substituted divalent naphthyl group, an unsubstituted or substituted divalent anthryl group, an unsubstituted or substituted phenanthryl group, an unsubstituted or substituted triphenylenyl group, a 9,9-dimethyl fluorene group, an unsubstituted or substituted 9,9-diphenyl fluorene group, or an unsubstituted or substituted divalent heteroaromatic group containing 3 to 24 ring atoms, preferably 3 to 14 ring atoms;
most preferably, L₁ represents a direct bond, unsubstituted 1,4-phenylene, unsubstituted 1,3-phenylene, 1,4-phenylene substituted with phenyl, naphthyl or phenanthryl, 1,3-phenylene substituted with phenyl, naphthyl or phenanthryl, unsubstituted 1,4-naphthalene, unsubstituted 1,5-naphthalene, unsubstituted 1,6-naphthalene, unsubstituted 2,6-naphthalene, unsubstituted 2,7-9,9-diphenyl-fluorene, unsubstituted 2,5-9,9-diphenyl-fluorene, unsubstituted 2,7-9,9-dimethyl-fluorene, unsubstituted 2,5-9,9-dimethyl-fluorene, unsubstituted 2,7-triphenylene, unsubstituted 9,10-anthryl, substituted 9,6-anthryl, substituted 9,7-anthryl, or an unsubstituted divalent heteroaromatic group containing 3 to 24 ring atoms, preferably 3 to 14 ring atoms;
further most preferably, L₁ represents a direct bond.

Ar₁ represents an aryl group having from 6 to 60 ring carbon atoms which is unsubstituted or substituted; a heteroaryl group having from 5 to 60 ring atoms which is unsubstituted or substituted or an alkyl group having from 1 to 20 carbon atoms which is unsubstituted or substituted; preferably an aryl group having from 6 to 60 ring carbon atoms which is unsubstituted or substituted or a heteroaryl group having from 5 to 60 ring atoms which is unsubstituted or substituted; more preferably an aryl group having from 6 to 60 ring carbon atoms which is unsubstituted or substituted.

Most preferably, Ar₁ represents a group of formula (III) 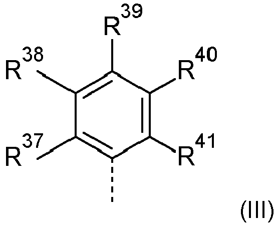 wherein
R³⁷, R³⁸, R³⁹, R⁴⁰ and R⁴¹ each independently represents hydrogen, an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted, halogen, SiR²⁴R²⁵R²⁶, or CN,
or
two adjacent residues together form a ring structure which is unsubstituted or substituted, wherein the dotted line is a bonding site.

Preferably, R³⁷, R³⁸, R³⁹, R⁴⁰ and R⁴¹ each independently represents hydrogen, an aryl group having from 6 to 13 ring carbon atoms which is unsubstituted or substituted; a heteroaryl group having from 5 to 13 ring atoms which is unsubstituted or substituted; an alkyl group having from 1 to 8 carbon atoms which is unsubstituted or substituted.

In a preferred embodiment of the present invention the group ---L₁-Ar₁ is therefore 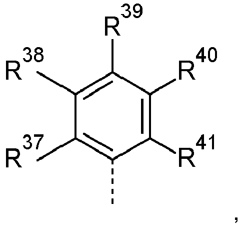 wherein L₁ is a direct bond and Ar₁ is a group of formula (III).

More preferably, 0, 1, 2 or 3, preferably 0, 1 or 2 residues R³⁷, R³⁸, R³⁹, R⁴⁰and R⁴¹ represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted, halogen, SiR²⁴R²⁵R²⁶ or CN,
or
two adjacent residues together form a ring structure which is unsubstituted or substituted, wherein the dotted line is a bonding site;
preferably an aryl group having from 6 to 13 ring carbon atoms which is unsubstituted or substituted; a heteroaryl group having from 5 to 13 ring atoms which is unsubstituted or substituted; an alkyl group having from 1 to 8 carbon atoms which is unsubstituted or substituted, halogen, SiR²⁴R²⁵R²⁶ or CN;
and the remaining residues are hydrogen.

Most preferably, Ar₁ represents a group of formula (IIIA) 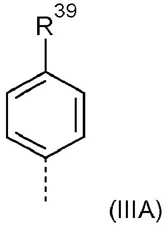 wherein
R³⁹ represents hydrogen, an aryl group having from 6 to 60 ring carbon atoms which is unsubstituted or substituted; a heteroaryl group having from 5 to 60 ring atoms which is unsubstituted or substituted or an alkyl group having from 1 to 20 carbon atoms which is unsubstituted or substituted; preferably an aryl group having from 6 to 13 ring carbon atoms which is unsubstituted or substituted; a heteroaryl group having from 5 to 13 ring atoms which is unsubstituted or substituted; an alkyl group having from 1 to 8 carbon atoms which is unsubstituted or substituted, halogen, SiR²⁴R²⁵R²⁶, or CN;
wherein the dotted line is a bonding site.

L₂ represents an unsubstituted or substituted divalent aromatic hydrocarbon group containing 6 to 30 ring atoms, an unsubstituted or substituted divalent alkyl group having 1 to 20 carbon atoms or an unsubstituted or substituted divalent heteroaromatic group containing 3 to 30 ring atoms;
preferably, L₂ represents an unsubstituted or substituted divalent aromatic hydrocarbon group containing 6 to 30 ring atoms, an unsubstituted or substituted divalent heteroaromatic group containing 3 to 30 ring atoms;
more preferably, L₂ represents an unsubstituted or substituted divalent aromatic hydrocarbon group containing 6 to 24 ring atoms, preferably 6 to 18 ring atoms, or an unsubstituted or substituted divalent heteroaromatic group containing 3 to 24 ring atoms, preferably 3 to 18 ring atoms; further more preferably, L₂ represents an unsubstituted or substituted divalent phenyl group, an unsubstituted or substituted divalent naphthyl group, an unsubstituted or substituted divalent anthryl group, an unsubstituted or substituted phenanthryl group, an unsubstituted or substituted triphenylenyl group, a 9,9-dimethyl fluorene group, an unsubstituted or substituted 9,9-diphenyl fluorene group, or an unsubstituted or substituted divalent heteroaromatic group containing 3 to 24 ring atoms, preferably 3 to 14 ring atoms;
most preferably, L₂ represents unsubstituted or substituted phenylene, e.g. unsubstituted or substituted 1,2-phenylene, unsubstituted or substituted 1,4-phenylene, unsubstituted or substituted 1,3-phenylene, unsubstituted or substituted naphthalene, e.g. unsubstituted or substituted 1,4-naphthalene, unsubstituted or substituted 1,5-naphthalene, unsubstituted or substituted 1,6-naphthalene, unsubstituted or substituted 2,6-naphthalene, unsubstituted 2,7-9,9-diphenyl-fluorene, unsubstituted 2,5-9,9-diphenyl-fluorene, unsubstituted 2,7-9,9-dimethyl-fluorene, unsubstituted 2,5-9,9-dimethyl-fluorene, unsubstituted 2,7-triphenylene, or an unsubstituted or substituted divalent heteroaromatic group containing 3 to 24 ring atoms, preferably 3 to 14 ring atoms;
further most preferably, L₂ represents unsubstituted or substituted phenylene, e.g. unsubstituted 1,2-phenylene, unsubstituted 1,4-phenylene, unsubstituted 1,3-phenylene, 1,2-phenylene substituted with phenyl, naphthyl or phenanthryl, 1,4-phenylene substituted with phenyl, naphthyl or phenanthryl, 1,3-phenylene substituted with phenyl, naphthyl or phenanthryl, unsubstituted or substituted naphthalene, e.g. unsubstituted 1,4-naphthalene, unsubstituted 1,5-naphthalene, unsubstituted 1,6-naphthalene, unsubstituted 2,6-naphthalene, unsubstituted 2,7-9,9-diphenyl-fluorene, unsubstituted 2,5-9,9-diphenyl-fluorene, unsubstituted 2,7-9,9-dimethyl-fluorene, unsubstituted 2,5-9,9-dimethyl-fluorene, unsubstituted 2,7-triphenylene, or an unsubstituted divalent heteroaromatic group containing 3 to 24 ring atoms, preferably 3 to 14 ring atoms;
even further most preferably, L₂ represents unsubstituted or substituted phenylene, e.g. unsubstituted 1,2-phenylene, unsubstituted 1,4-phenylene, unsubstituted 1,3-phenylene, 1,2-phenylene substituted with phenyl, naphthyl or phenanthryl, 1,4-phenylene substituted with phenyl, naphthyl or phenanthryl, or 1,3-phenylene substituted with phenyl, naphthyl or phenanthryl. even further most preferably, L₂ represents unsubstituted phenylene, e.g. unsubstituted 1,2-phenylene, unsubstituted 1,4-phenylene, or unsubstituted 1,3-phenylene, even further most preferably, L₂ represents unsubstituted 1,4-phenylene.

R¹, R², R³, R⁴, R⁵, R⁶, R⁷, R⁸, R⁹, R¹⁰ and R¹¹ each independently represents hydrogen; an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; NO₂; OR²⁰; SR²¹; C(=O)R²²; COOR²³; SiR²⁴R²⁵R²⁶, NR⁸⁴R⁸⁵ or halogen; preferably hydrogen; an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; NO₂; OR²⁰; SR²¹; C(=O)R²²; COOR²³; SiR²⁴R²⁵R²⁶, NR⁸⁴R⁸⁵ or halogen; or
two adjacent residues together form a ring structure which is unsubstituted or substituted; wherein at least one of, preferably one of R¹, R², R³, R⁴, R⁵, R⁶, R⁷, R⁸, R⁹, R¹⁰ and R¹¹, preferably at least one, preferably one of of R¹, R², R³, R⁴, R⁵, R⁶, R⁷ and R⁸ represents an amino group NR⁸⁴R⁸⁵, preferably an amino group NAr₂Ar₃. More preferably, R² and/or R⁷ represents an amino group NR⁸⁴R⁸⁵, preferably an amino group NAr₂Ar₃, most preferably R⁷ or R² represents an amino group NR⁸⁴R⁸⁵, preferably an amino group NAr₂Ar₃, further most preferably R⁷ represents an amino group NR⁸⁴R⁸⁵, preferably an amino group NAr₂Ar₃, and the remaining residues do not represent an amino group NR⁸⁴R⁸⁵. Preferred groups
NR⁸⁴R⁸⁵ and its positions in the structure of formula (I) and its occurrence are mentioned above and below.

Preferably, R¹, R², R³, R⁴, R⁵, R⁶, R⁷, R⁸, R⁹, R¹⁰ and R¹¹ each independently represents hydrogen; an aryl group having from 6 to 18 ring carbon atoms which is unsubstituted or substituted; a heteroaryl group having from 5 to 18 ring atoms which is unsubstituted or substituted; an aralkyl group having from 7 to 19 carbon atoms which is unsubstituted or substituted; an alkyl group having from 1 to 8 carbon atoms which is unsubstituted or substituted; an alkylhalide group having from 1 to 8 carbon atoms which is unsubstituted or substituted; CN; OR²⁰; SR²¹; SiR²⁴R²⁵R²⁶, NR⁸⁴R⁸⁵ or halogen;
or
two adjacent residues together form a ring structure which is unsubstituted or substituted, preferably a ring structure of formula (A), (D) and (G), more preferably of formula (G) described above;
wherein at least one of, preferably one of R¹, R², R³, R⁴, R⁵, R⁶, R⁷, R⁸, R⁹, R¹⁰ and R¹¹, preferably at least one, preferably one of of R¹, R², R³, R⁴, R⁵, R⁶, R⁷ and R⁸ represents an amino group NR⁸⁴R⁸⁵, preferably an amino group NAr₂Ar₃. More preferably, R² and/or R⁷ represents an amino group NR⁸⁴R⁸⁵, preferably an amino group NAr₂Ar₃, most preferably R⁷ or R² represents an amino group NR⁸⁴R⁸⁵, preferably an amino group NAr₂Ar₃, further most preferably R⁷ represents an amino group NR⁸⁴R⁸⁵, preferably an amino group NAr₂Ar₃, and the remaining residues do not represent an amino group NR⁸⁴R⁸⁵. Preferred groups NR⁸⁴R⁸⁵ and its positions in the structure of formula (I) and its occurrence are mentioned above and below.

More preferably, R¹, R², R³, R⁴, R⁵, R⁶, R⁷, R⁸, R⁹, R¹⁰ and R¹¹ each independently represents hydrogen; an aryl group having from 6 to 18 ring carbon atoms which is unsubstituted or substituted; an alkyl group having from 1 to 8 carbon atoms which is unsubstituted or substituted; NR⁸⁴R⁸⁵ or SiR²⁴R²⁵R²⁶;
or
two adjacent residues together form a ring structure of formula (G) described above; wherein at least one of, preferably one of R¹, R², R³, R⁴, R⁵, R⁶, R⁷, R⁸, R⁹, R¹⁰ and R¹¹, preferably at least one, preferably one of of R¹, R², R³, R⁴, R⁵, R⁶, R⁷ and R⁸ represents an amino group NR⁸⁴R⁸⁵, preferably an amino group NAr₂Ar₃. More preferably, R² and/or R⁷ represents an amino group NR⁸⁴R⁸⁵, preferably an amino group NAr₂Ar₃, most preferably R⁷ or R² represents an amino group NR⁸⁴R⁸⁵, preferably an amino group NAr₂Ar₃, further most preferably R⁷ represents an amino group NR⁸⁴R⁸⁵, preferably an amino group NAr₂Ar₃, and the remaining residues do not represent an amino group NR⁸⁴R⁸⁵. Preferred groups
NR⁸⁴R⁸⁵ and its positions in the structure of formula (I) and its occurrence are mentioned above and below.

Preferably, 0, 1, 2, 3 or 4, more preferably 0, 1 or 2 of R¹, R², R³, R⁴, R⁵, R⁶, R⁷, R⁸, R⁹, R¹⁰ and R¹¹ each independently represents an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; NO₂; OR²⁰; SR²⁰; C(=O)R²¹; COOR²²; SiR²⁴R²⁵R²⁶ or halogen; preferably an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; NO₂; OR²⁰; SR²⁰; C(=O)R²¹; COOR²²; SiR²⁴R²⁵R²⁶, NR⁸⁴R⁸⁵ or halogen
or
two adjacent residues together form a ring structure which is unsubstituted or substituted, and the remaining residues of R¹, R², R³, R⁴, R⁵, R⁶, R⁷, R⁸, R⁹, R¹⁰ and R¹¹ are hydrogen. Preferred residues R¹, R², R³, R⁴, R⁵, R⁶, R⁷, R⁸, R⁹, R¹⁰ and R¹¹ which are not hydrogen are mentioned above,
wherein at least one of, preferably one of R¹, R², R³, R⁴, R⁵, R⁶, R⁷, R⁸, R⁹, R¹⁰ and R¹¹, preferably at least one, preferably one of of R¹, R², R³, R⁴, R⁵, R⁶, R⁷ and R⁸ represents an amino group NR⁸⁴R⁸⁵, preferably an amino group NAr₂Ar₃. More preferably, R² and/or R⁷ represents an amino group NR⁸⁴R⁸⁵, preferably an amino group NAr₂Ar₃, most preferably R⁷ or R² represents an amino group NR⁸⁴R⁸⁵, preferably an amino group NAr₂Ar₃, further most preferably R⁷ represents an amino group NR⁸⁴R⁸⁵, preferably an amino group NAr₂Ar₃, and the remaining residues do not represent an amino group NR⁸⁴R⁸⁵.

In one preferred embodiment, R⁶ and/or R¹⁰ each independently represents hydrogen, an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; NO₂; OR²⁰; SR²⁰; C(=O)R²¹; COOR²²; SiR²⁴R²⁵R²⁶, NR⁸⁴R⁸⁵ or halogen; preferably hydrogen, an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; NO₂; OR²⁰; SR²⁰; C(=O)R²¹; COOR²²; SiR²⁴R²⁵R²⁶, NR⁸⁴R⁸⁵ or halogen; and the remaining residues of R¹, R², R³, R⁴, R⁵, R⁶, R⁷, R⁸, R⁹, R¹⁰ and R¹¹ are hydrogen. Preferred residues R¹, R², R³, R⁴, R⁵, R⁶, R⁷, R⁸, R⁹, R¹⁰ and R¹¹ which are not hydrogen are mentioned above,
wherein at least one of, preferably one of R¹, R², R³, R⁴, R⁵, R⁶, R⁷, R⁸, R⁹, R¹⁰ and R¹¹, preferably at least one, preferably one of of R¹, R², R³, R⁴, R⁵, R⁶, R⁷ and R⁸ represents an amino group NR⁸⁴R⁸⁵, preferably an amino group NAr₂Ar₃. More preferably, R² and/or R⁷ represents an amino group NR⁸⁴R⁸⁵, preferably an amino group NAr₂Ar₃, most preferably R⁷ or R² represents an amino group NR⁸⁴R⁸⁵, preferably an amino group NAr₂Ar₃, further most preferably R⁷ represents an amino group NR⁸⁴R⁸⁵, preferably an amino group NAr₂Ar₃, and the remaining residues do not represent an amino group NR⁸⁴R⁸⁵.

Most preferably R¹, R², R³, R⁴, R⁵, R⁶, R⁷, R⁸, R⁹, R¹⁰ and R¹¹ are hydrogen, wherein at least one of, preferably one of R¹, R², R³, R⁴, R⁵, R⁶, R⁷, R⁸, R⁹, R¹⁰ and R¹¹, preferably at least one, preferably one of of R¹, R², R³, R⁴, R⁵, R⁶, R⁷ and R⁸ represents an amino group NR⁸⁴R⁸⁵, preferably an amino group NAr₂Ar₃. More preferably, R² and/or R⁷ represents an amino group NR⁸⁴R⁸⁵, preferably an amino group NAr₂Ar₃, most preferably R⁷ or R² represents an amino group NR⁸⁴R⁸⁵, preferably an amino group NAr₂Ar₃, further most preferably R⁷ represents an amino group NR⁸⁴R⁸⁵, preferably an amino group NAr₂Ar₃, and the remaining residues do not represent an amino group NR⁸⁴R⁸⁵..

R¹², R¹³, R¹⁴, R¹⁵, R¹⁶, R¹⁷, R¹⁸ and R¹⁹ each independently represents hydrogen; an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; NO₂; OR²⁰; SR²¹; C(=O)R²²; COOR²³; SiR²⁴R²⁵R²⁶; NR⁸⁴R⁸⁵ or halogen;
or
two adjacent residues together form a ring structure which is unsubstituted or substituted: wherein one of R¹², R¹³, R¹⁴, R¹⁵, R¹⁶, R¹⁷, R¹⁸ and R¹⁹ is a bonding site to L₂.

Preferably, R¹², R¹³, R¹⁴, R¹⁵, R¹⁶, R¹⁷, R¹⁸ and R¹⁹ each independently represents hydrogen; an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; NO₂; OR²⁰; SR²¹; C(=O)R²²; COOR²³; SiR²⁴R²⁵R²⁶; NR⁸⁴R⁸⁵ or halogen;
or
two adjacent residues together form a ring structure which is unsubstituted or substituted: wherein one of R¹², R¹³, R¹⁴, R¹⁵, R¹⁶, R¹⁷, R¹⁸ and R¹⁹ is a bonding site to L₂.

Preferably, R¹², R¹³, R¹⁴, R¹⁵, R¹⁶, R¹⁷, R¹⁸ and R¹⁹ each independently represents hydrogen; an aryl group having from 6 to 18 ring carbon atoms which is unsubstituted or substituted; a heteroaryl group having from 5 to 18 ring atoms which is unsubstituted or substituted; an aralkyl group having from 7 to 19 carbon atoms which is unsubstituted or substituted; an alkyl group having from 1 to 8 carbon atoms which is unsubstituted or substituted; an alkylhalide group having from 1 to 8 carbon atoms which is unsubstituted or substituted CN; OR²⁰; SR²¹; SiR²⁴R²⁵R²⁶ or halogen;
or
two adjacent residues together form a ring structure which is unsubstituted or substituted, preferably a ring structure of formula (A), (D) or (G) described above; wherein one of R¹², R¹³, R¹⁴, R¹⁵, R¹⁶, R¹⁷, R¹⁸ and R¹⁹ is a bonding site to L₂.

More preferably, R¹², R¹³, R¹⁴, R¹⁵, R¹⁶, R¹⁷, R¹⁸ and R¹⁹ each independently represents hydrogen; an aryl group having from 6 to 18 ring carbon atoms which is unsubstituted or substituted; an alkyl group having from 1 to 8 carbon atoms which is unsubstituted or substituted or SiR²⁴R²⁵R²⁶;
or
two adjacent residues together form a ring structure of formula (A) or (D) described above; wherein one of R¹², R¹³, R¹⁴, R¹⁵, R¹⁶, R¹⁷, R¹⁸ and R¹⁹ is a bonding site to L₂.

Preferably, 0, 1 or 2, more preferably 0 or 1 of R¹², R¹³, R¹⁴, R¹⁵, R¹⁶, R¹⁷, R¹⁸ and R¹⁹ each independently represents an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; NO₂; OR²⁰; SR²⁰; C(=O)R²¹; COOR²²; SiR²⁴R²⁵R²⁶; NR⁸⁴R⁸⁵ or halogen; preferably an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; NO₂; OR²⁰; SR²⁰; C(=O)R²¹; COOR²²; SiR²⁴R²⁵R²⁶; NR⁸⁴R⁸⁵ or halogen;
or
two adjacent residues together form a ring structure which is unsubstituted or substituted, and the remaining residues of R¹², R¹³, R¹⁴, R¹⁵, R¹⁶, R¹⁷, R¹⁸ and R¹⁹ are hydrogen. Preferred residues R¹², R¹³, R¹⁴, R¹⁵, R¹⁶, R¹⁷, R¹⁸ and R¹⁹ which are not hydrogen are mentioned above.

Most preferably R¹², R¹³, R¹⁴, R¹⁵, R¹⁶, R¹⁷, R¹⁸ and R¹⁹ are hydrogen, wherein one of R¹², R¹³, R¹⁴, R¹⁵, R¹⁶, R¹⁷, R¹⁸ and R¹⁹, preferably one of R¹⁶, R¹⁷, R¹⁸ and R¹⁹ is a bonding site to L₂.

X is O or S.

Preferred compounds of formula (I) are shown in the following, wherein the residues are defined above

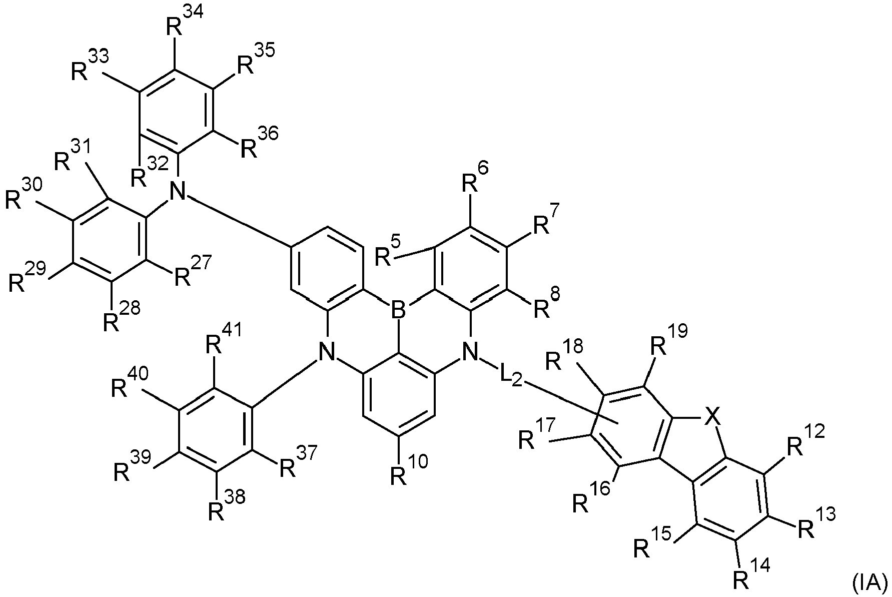

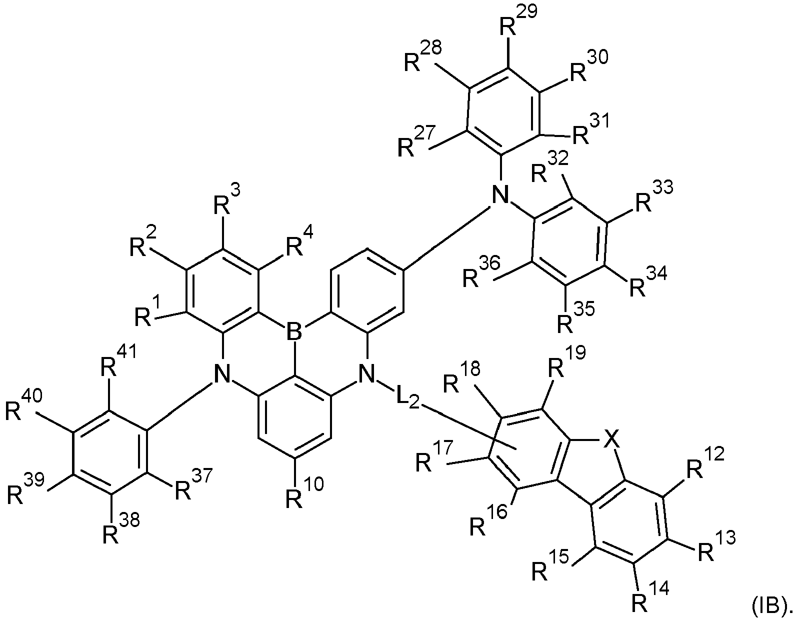

More preferred compounds of formula (I) are the following compounds, wherein the residues are defined above

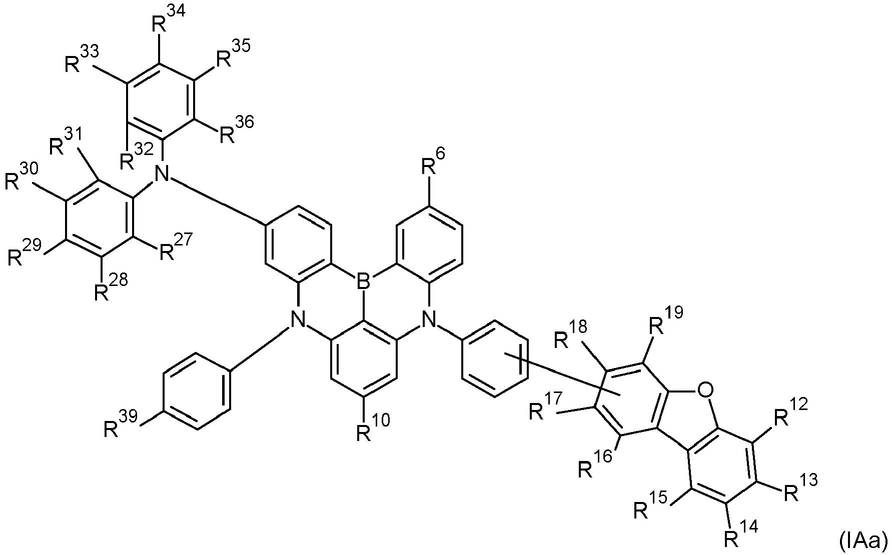

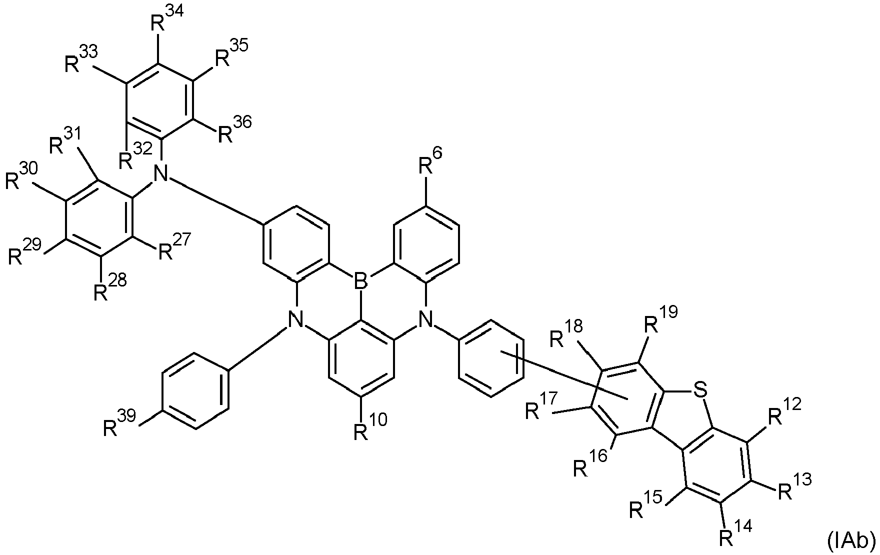

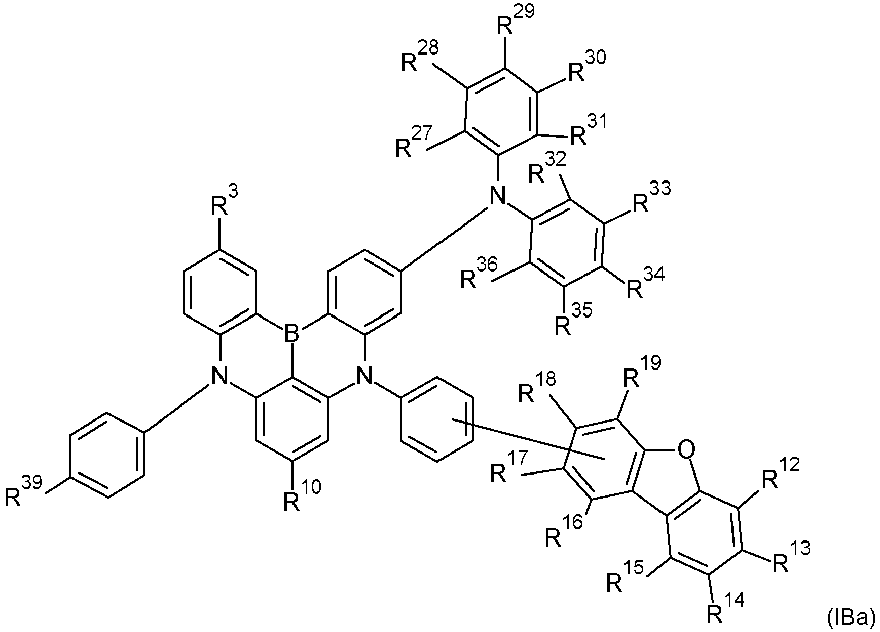

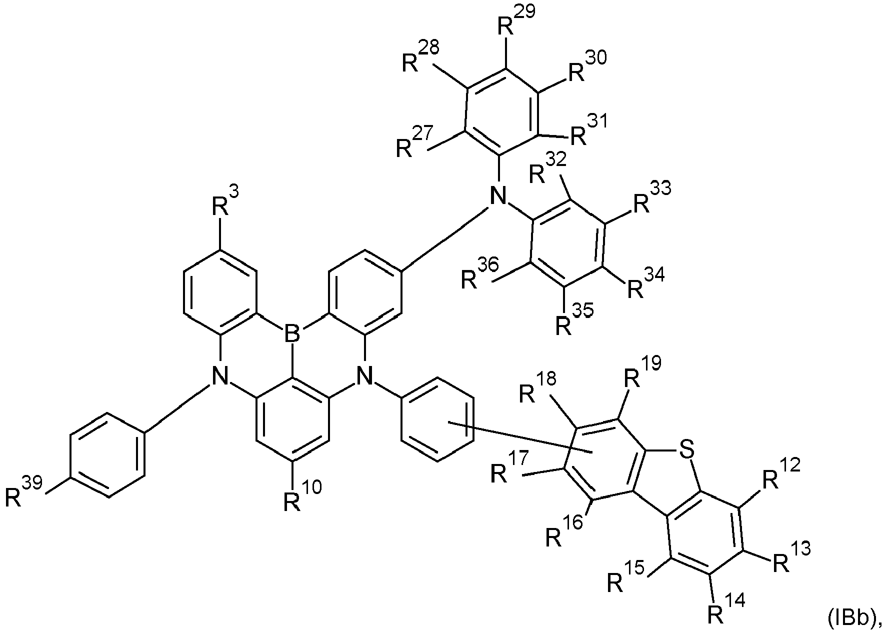

Further more preferred compounds of formula (I) are compounds of formulae (IBa) and (IBb), and even further more preferred are compounds of formula (IBa).

Below, examples for compounds of formula (I) are given:

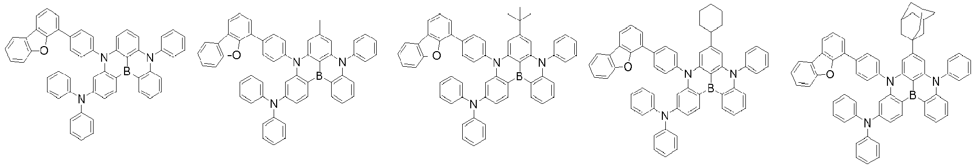

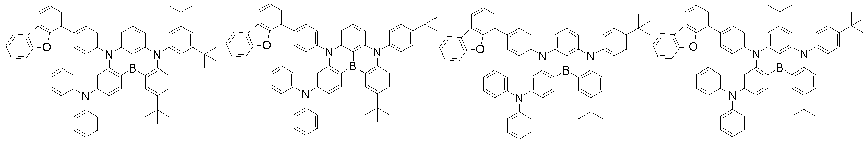

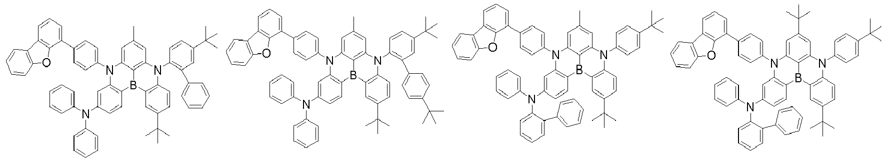

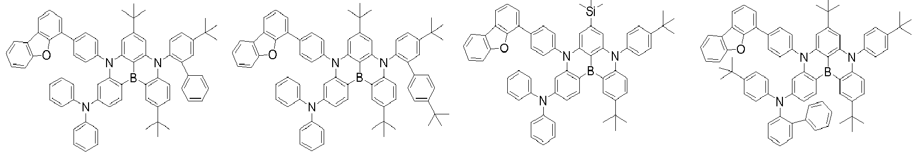

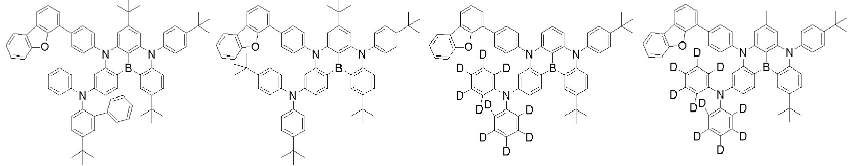

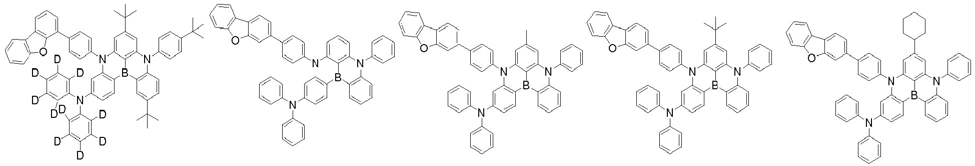

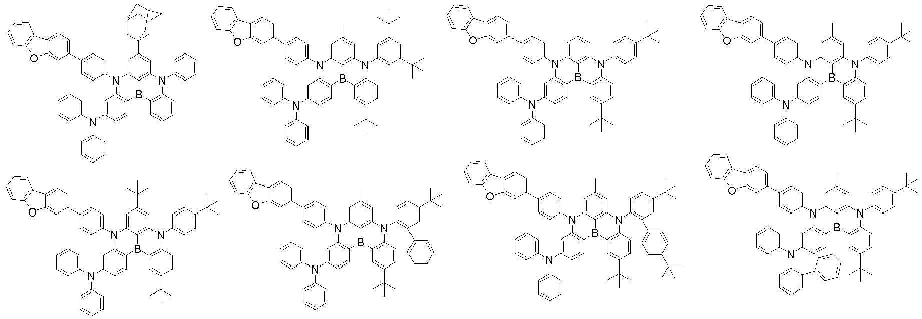

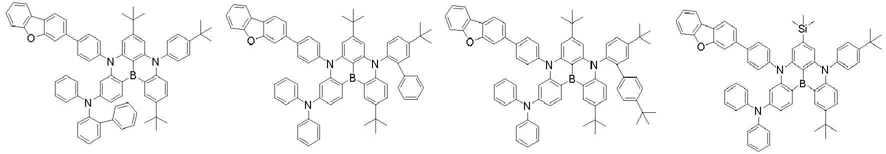

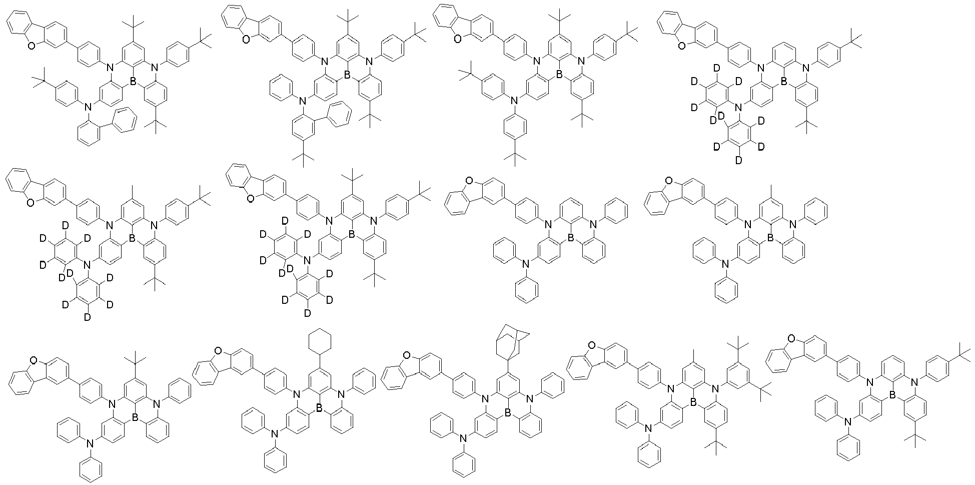

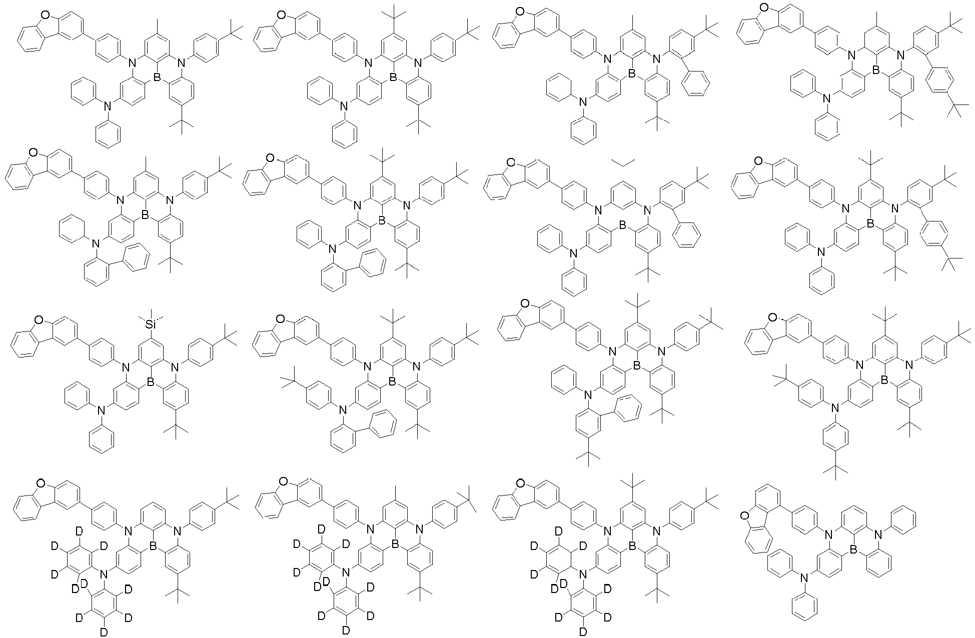

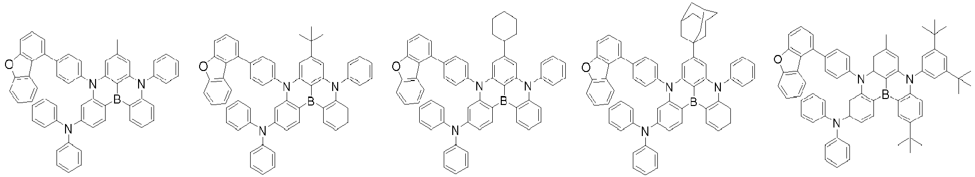

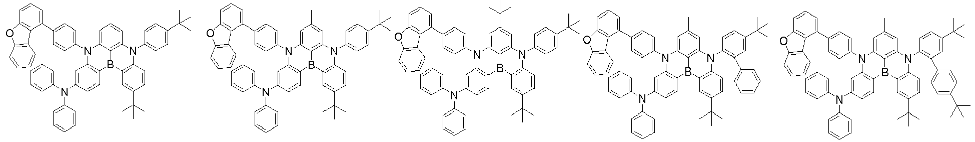

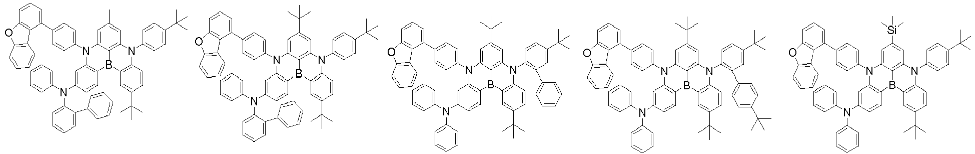

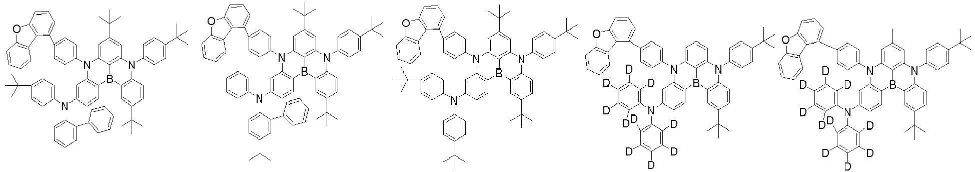

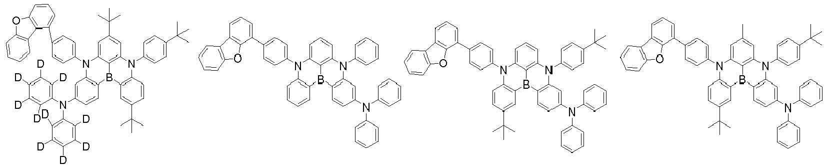

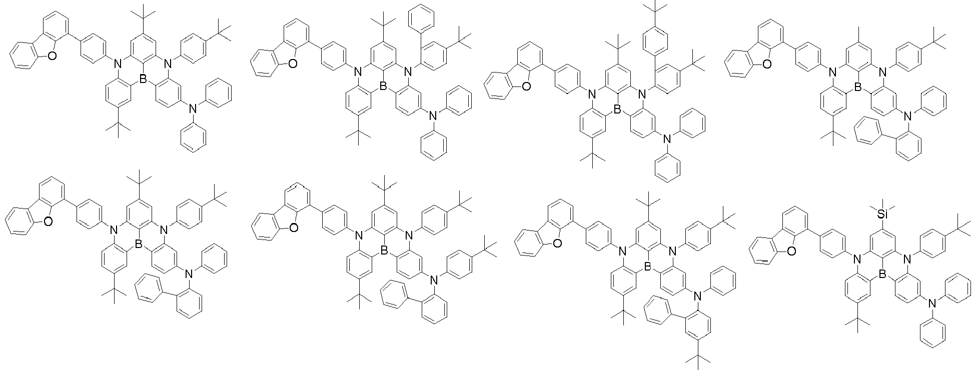

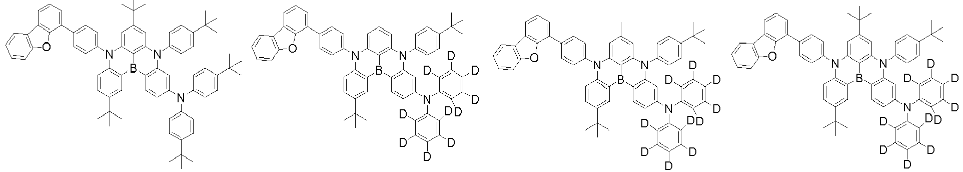

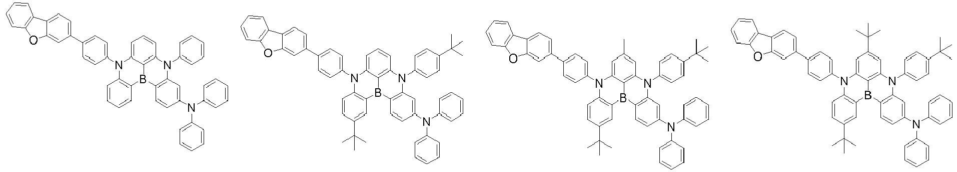

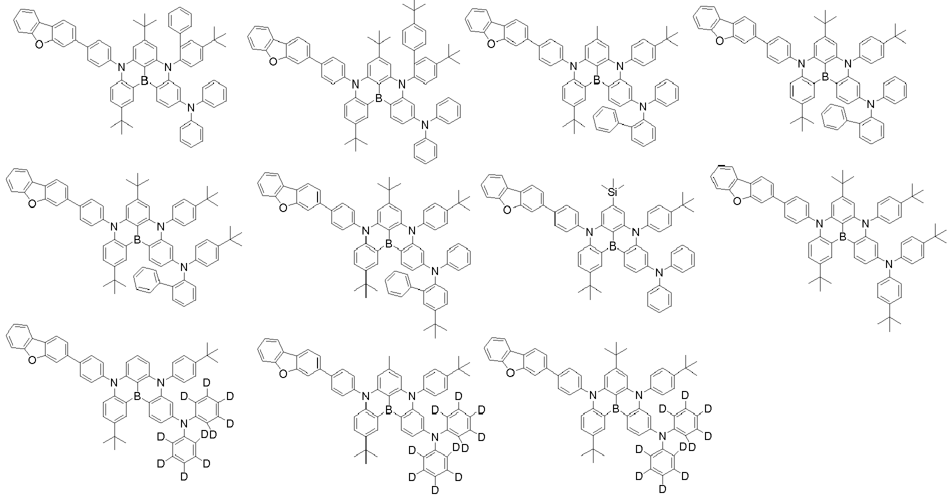

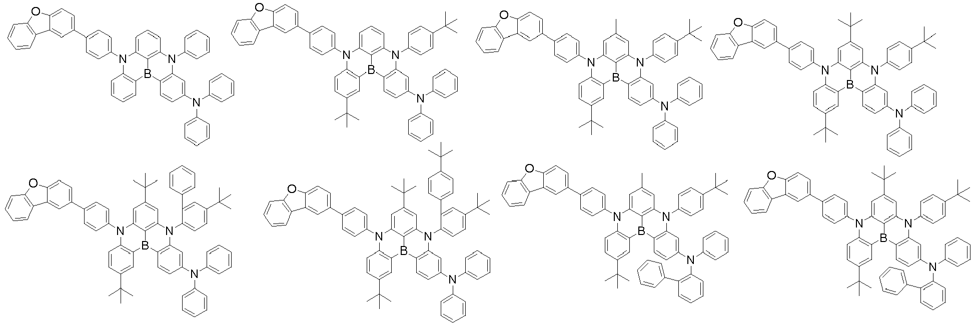

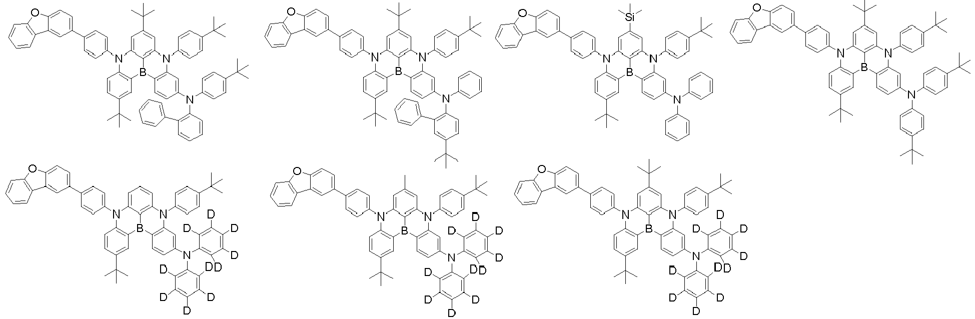

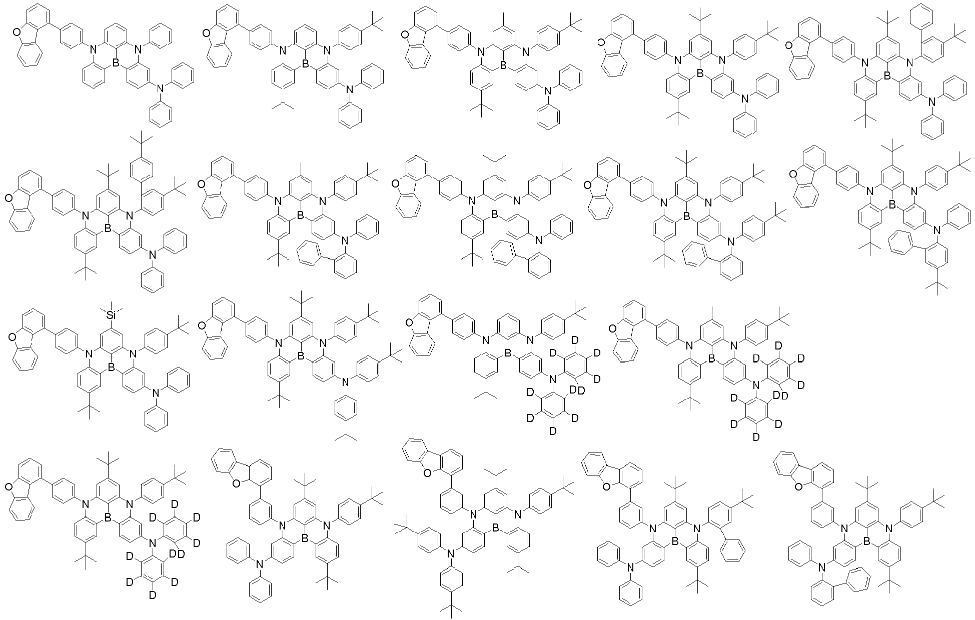

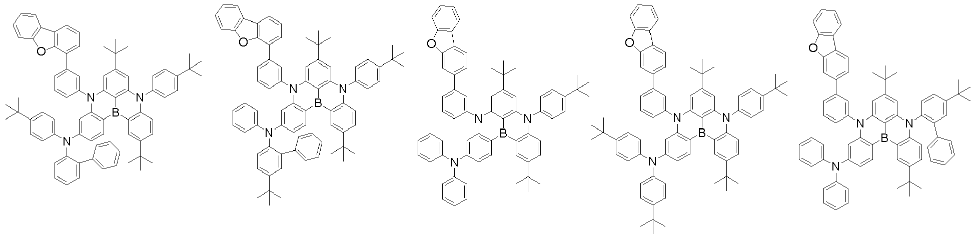

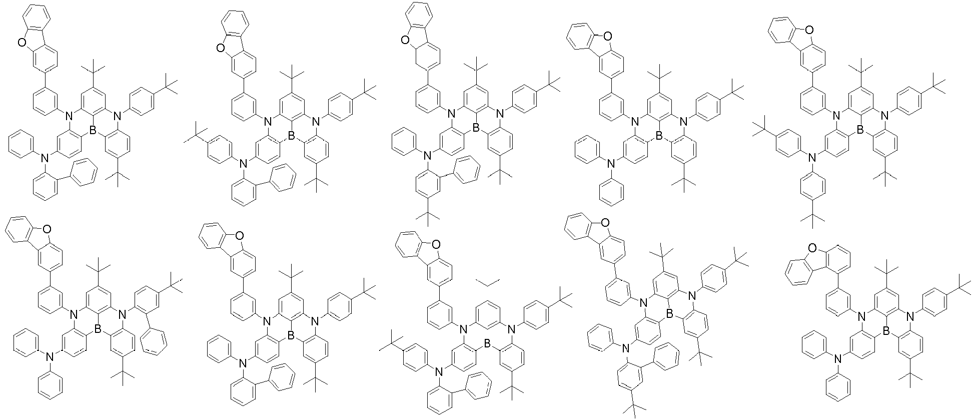

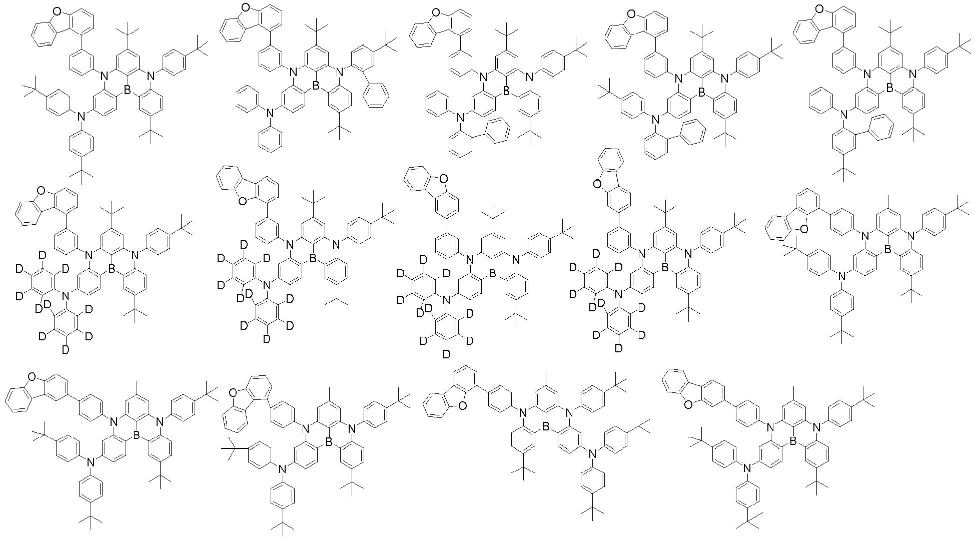

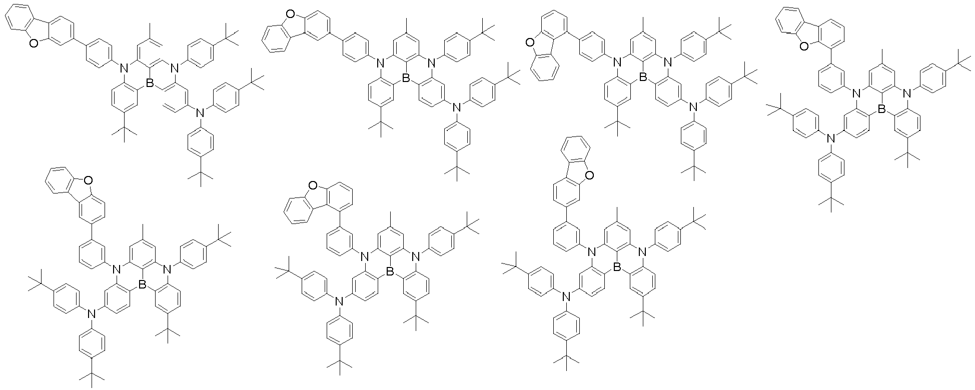

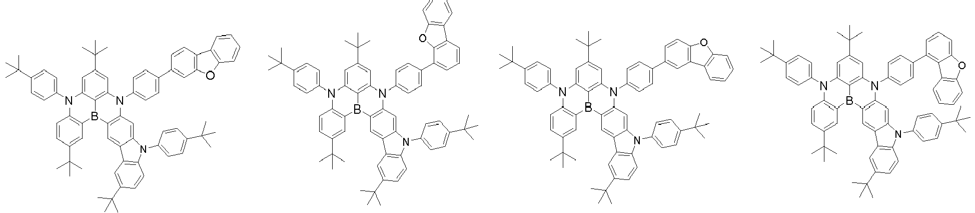

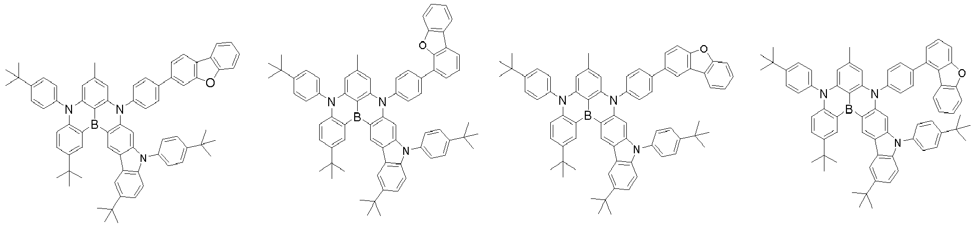

### Preparation of the compounds of formula (I)

The compounds represented by formula (I) can be synthesized in accordance with the reactions conducted in the examples of the present application, and by using alternative reactions or raw materials suited to an intended product, in analogy to reactions and raw materials known in the art.

The compounds of formula (I) are for example prepared by the following step:

Addition of BHal'₃ to the intermediate (IV), whereby the compound of formula (I) is obtained: 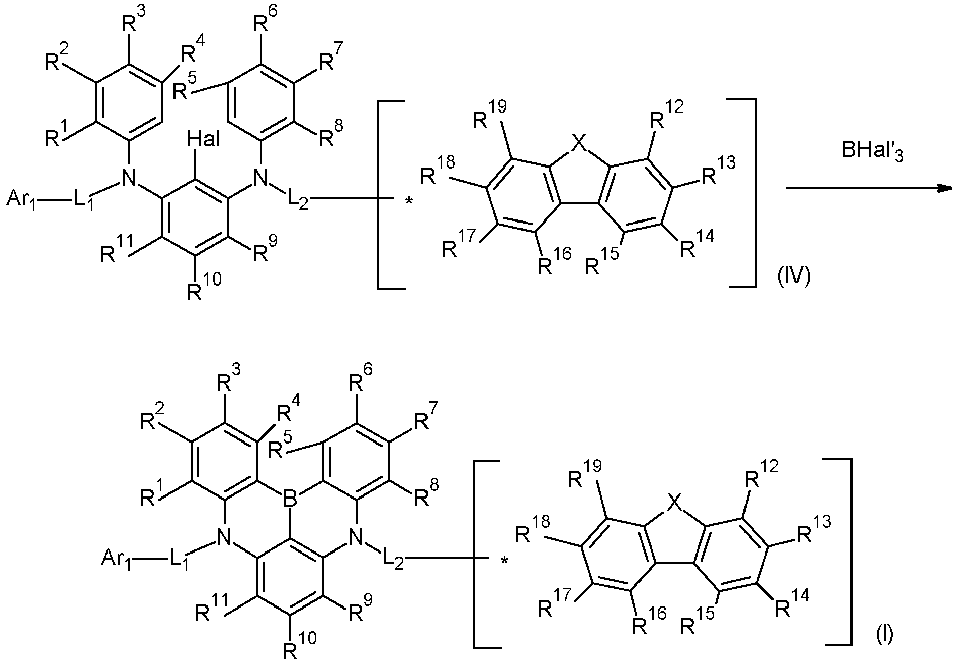 wherein
Hal represents halogen, preferably F, Cl, Br or I, more preferably Cl or Br and most preferably Br;
Hal' represents halogen, preferably F, Cl, Br or I, more preferably Cl or Br and most preferably Br;
all other residues and indices are as defined before.

The intermediate (IV) is for example prepared by the following steps: 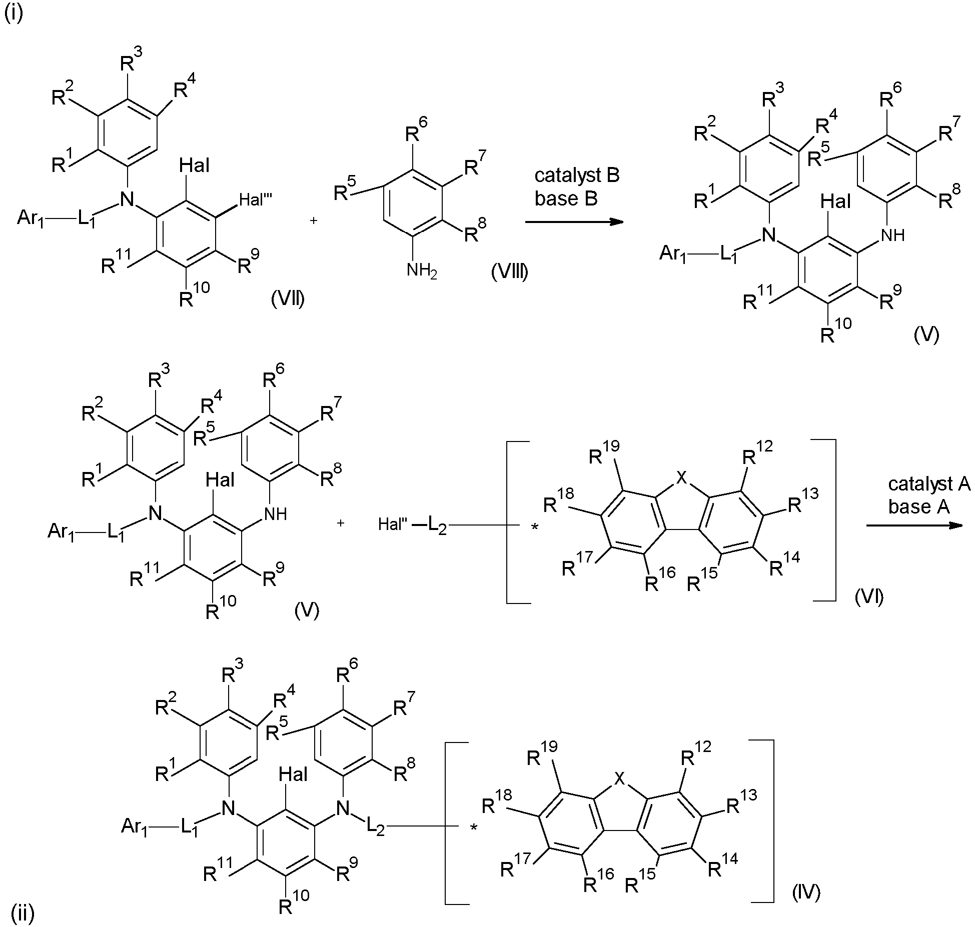 wherein
Hal" represents halogen, preferably F, Cl, Br or I, more preferably I;
Hal‴ represents halogen, preferably F, Cl, Br or I, more preferably Cl or Br and most preferably Br;
base A and base B are each independently any suitable base; preferred bases are alkali metal *tert*-butoxides like KO*t*Bu and NaO*t*Bu);
catalyst A and catalyst B are each independently any suitable catalyst; preferred catalysts are Pd catalysts;
all other residues and indices are as defined before.

Suitable Pd catalysts are for example Pd(0) complexes with bidentate ligands like dba (dibenzylideneacetone), or Pd(II) salts like PdCl₂ or Pd(OAc)₂ in combination with bidentate phosphine ligands such as dppf ((diphenylphosphino)ferrocene), dppp ((diphenylphosphino)propane), BINAP (2,2'-Bis(diphenylphosphino)-1,1'-binaphthyl), Xantphos (4,5-Bis(diphenylphosphino)-9,9-dimethylxanthene), DPEphos (Bis[(2-diphenylphosphino)phenyl] ether) or Josiphos, or in combination with monodentate phosphine-ligands like di-*tert*.-butyl-(4-dimethylaminophenyl)-phosphine (Amphos), triphenylphosphine, tri-ortho-tolyl phosphine, tri-tertbutylphosphine, tricyclohexylphosphine, 2-Dicyclohexylphosphino-2',6'-dimethoxybiphenyl (SPhos), 2-Dicyclohexylphosphino-2',4',6'-triisopropylbiphenyl (XPhos), or N-heterocyclic carbenes such as 1,3-Bis(2,6-diisopropylphenyl)imidazol-2-ylidene (IPr), 1,3-Dimesitylimidazol-2-ylidene (Imes).

Josiphos: 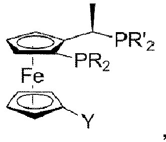 wherein R and R' are generally substituted or unsubstituted phenyl.

Suitable reaction conditions are known by a person skilled in the art.

Details of all reaction steps and process conditions are mentioned in the examples of the present application.

### Organic electroluminescence device

According to one aspect of the present invention a material for an organic electroluminescence device comprising at least one compound of formula (I) is provided.

According to another aspect of the present invention, an organic electroluminescence device comprising at least one compound of formula (I) is provided.

According to another aspect of the invention, the following organic electroluminescence device is provided: An organic electroluminescence device comprising a cathode, an anode, and one or more organic thin film layers comprising a light emitting layer disposed between the cathode and the anode, wherein at least one layer of the organic thin film layers comprises at least one compound of formula (I).

According to another aspect of the invention an organic electroluminescence device is provided, wherein the light emitting layer comprises at least one compound of formula (I).

According to another aspect of the invention an organic electroluminescence device is provided, wherein the light emitting layer comprises at least one compound of formula (I) as a dopant material and an anthracene compound as a host material.

According to another aspect of the invention an electronic equipment provided with the organic electroluminescence device according to the present invention is provided.

According to another aspect of the invention an emitter material is provided comprising at least one compound of formula (I).

According to another aspect of the invention a light emitting layer is provided comprising at least one host and at least one dopant, wherein the dopant comprises at least one compound of formula (I).

According to another aspect of the invention the use of a compound of formula (I) according to the present invention in an organic electroluminescence device is provided.

In one embodiment, the organic EL device comprises a hole-transporting layer between the anode and the emitting layer.

In one embodiment, the organic EL device comprises an electron-transporting layer between the cathode and the emitting layer.

In the present specification, regarding the "one or more organic thin film layers between the emitting layer and the anode", if only one organic layer is present between the emitting layer and the anode, it means that layer, and if plural organic layers are present, it means at least one layer thereof. For example, if two or more organic layers are present between the emitting layer and the anode, an organic layer nearer to the emitting layer is called the "hole-transporting layer", and an organic layer nearer to the anode is called the "hole-injecting layer". Each of the "hole-transporting layer" and the "hole-injecting layer" may be a single layer or may be formed of two or more layers. One of these layers may be a single layer and the other may be formed of two or more layers.

Similarly, regarding the "one or more organic thin film layers between the emitting layer and the cathode", if only one organic layer is present between the emitting layer and the cathode, it means that layer, and if plural organic layers are present, it means at least one layer thereof. For example, if two or more organic layers are present between the emitting layer and the cathode, an organic layer nearer to the emitting layer is called the "electron-transporting layer", and an organic layer nearer to the cathode is called the "electron-injecting layer". Each of the "electron-transporting layer" and the "electron-injecting layer" may be a single layer or may be formed of two or more layers. One of these layers may be a single layer and the other may be formed of two or more layers.

The "one or more organic thin film layers comprising an emitting layer" mentioned above, preferably the emitting layer, comprises a compound represented by formula (I). The compound represented by formula (I) preferably functions as an emitter material, more preferably as a fluorescent emitter material, most preferably as a blue fluorescent emitter material. By the presence of a compound of formula (I) in the organic EL device, preferably in the emitting layer, organic EL devices characterized by high external quantum efficiencies (EQE) and long lifetimes are provided.

According to another aspect of the invention, an emitting layer of the organic electroluminescence device is provided which comprises at least one compound of formula (I).

Preferably, the emitting layer comprises at least one emitting material (dopant material) and at least one host material, wherein the emitting material is at least one compound of formula (I).

In one embodiment, the host is not selected from CBP (4,4'-Bis-(N-carbazolyl)-biphenyl), mCP, mCBP Sif87 (dibenzo[b,d]thiophen-2-yltriphenylsilane), CzSi, Sif88 (dibenzo[b,d]thiophen-2-yl)diphenylsilane), DPEPO (bis[2-(diphenylphosphino)phenylj ether oxide), 9-[3- (dibenzofuran-2-yl)phenyl]-9H-carbazole, 9-[3-(dibenzofuran-2-yl)phenyl]-9H-carbazole, 9-[3- (dibenzothiophen-2-yl)phenyl]-9H-carbazole, 9-[3,5-bis(2-dibenzofuranyl)phenyl]-9H- carbazole, 9-[3,5-bis(2-dibenzothiophenyl)phenyl]-9H-carbazole, T2T (2,4,6-tris(biphenyl-3- yl)-1 ,3,5-triazine), T3T (2,4,6-tris(triphenyl-3-yl)-1 ,3,5-triazine) and/or TST (2,4,6-tris(9,9'- spirobifluorene-2-yl)-1,3,5-triazine).

Preferred host materials are substituted or unsubstituted polyaromatic hydrocarbon (PAH) compounds, substituted or unsubstituted polyheteroaromatic compounds, substituted or unsubstituted anthracene compounds, or substituted or unsubstituted pyrene compounds.

More preferably, the organic electroluminescence device according to the present invention comprises in the emitting layer at least one compound of formula (I) as a dopant material and at least one host material selected from the group consisting of substituted or unsubstituted polyaromatic hydrocarbon (PAH) compounds, substituted or unsubstituted polyheteroaromatic compounds, substituted or unsubstituted anthracene compounds, and substituted or unsubstituted pyrene compounds. Preferably, the at least one host is at least one substituted or unsubstituted anthracene compound.

In a further preferred embodiment, the organic electroluminescence device according to the present invention comprises in the emitting layer at least one compound of formula (I) as a dopant material and at least one host material selected from the group consisting of substituted or unsubstituted polyaromatic hydrocarbon (PAH) compounds, substituted or unsubstituted anthracene compounds, and substituted or unsubstituted pyrene compounds. Preferably, the at least one host is at least one substituted or unsubstituted anthracene compound.

According to another aspect of the invention, an emitting layer of the organic electroluminescence device is provided which comprises at least one compound of formula (I) as a dopant material and an anthracene compound as a host material.

Suitable anthracene compounds are represented by the following formula (10): 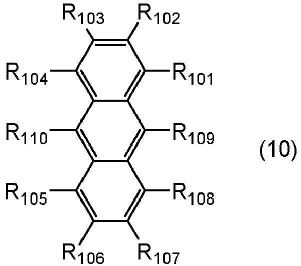 wherein
one or more pairs of two or more adjacent R₁₀₁ to R₁₁₀ may form a substituted or unsubstituted, saturated or unsaturated ring;
R₁₀₁ to R₁₁₀ that do not form the substituted or unsubstituted, saturated or unsaturated ring are independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, -Si(R₁₂₁)(R₁₂₂)(R₁₂₃), -C(=O)R₁₂₄, - COOR₁₂₅, -N(R₁₂₆)(R₁₂₇), a halogen atom, a cyano group, a nitro group, a substituted or unsubstituted aryl group including 6 to 50 ring carbon atoms, a substituted or unsubstituted monovalent heterocyclic group including 5 to 50 ring atoms, or a group represented by the following formula (31);
R₁₂₁ to R₁₂₇ are independently a hydrogen atom, a substituted or unsubstituted alkyl group including 1 to 50 carbon atoms, a substituted or unsubstituted cycloalkyl group including 3 to 50 ring carbon atoms, a substituted or unsubstituted aryl group including 6 to 50 ring carbon atoms or a substituted or unsubstituted monovalent heterocyclic group including 5 to 50 ring atoms; when each of R₁₂₁ to R₁₂₇ is present in plural, each of the plural R₁₂₁ to R₁₂₇ may be the same or different;
provided that at least one of R₁₀₁ to R₁₁₀ that do not form the substituted or unsubstituted, saturated or unsaturated ring is a group represented by the following formula (31). If two or more groups represented by the formula (31) are present, each of these groups may be the same or different;

   -L₁₀₁-Ar₁₀₁ (31)

   wherein in the formula (31),
L₁₀₁ is a single bond, a substituted or unsubstituted arylene group including 6 to 30 ring carbon atoms or a substituted or unsubstituted divalent heterocyclic group including 5 to 30 ring atoms; Ar₁₀₁ is a substituted or unsubstituted aryl group including 6 to 50 ring carbon atoms or a substituted or unsubstituted monovalent heterocyclic group including 5 to 50 ring atoms.

Specific examples of each substituent, substituents for "substituted or unsubstituted" and the halogen atom in the compound (10) are the same as those mentioned above.

An explanation will be given on "one or more pairs of two or more adjacent R₁₀₁ to R₁₁₀ may form a substituted or unsubstituted, saturated or unsaturated ring".

The "one pair of two or more adjacent R₁₀₁ to R₁₁₀" is a combination of R₁₀₁ and R₁₀₂, R₁₀₂ and R₁₀₃, R₁₀₃ and R₁₀₄, R₁₀₅ and R₁₀₆, R₁₀₆ and R₁₀₇, R₁₀₇ and R₁₀₈, R₁₀₈ and R₁₀₉, R₁₀₁ and R₁₀₂ and R₁₀₃ or the like, for example.

The substituent in "substituted" in the "substituted or unsubstituted" for the saturated or unsaturated ring is the same as those for "substituted or unsubstituted" mentioned in the formula (10).

The "saturated or unsaturated ring" means, when R₁₀₁ and R₁₀₂ form a ring, for example, a ring formed by a carbon atom with which R₁₀₁ is bonded, a carbon atom with which R₁₀₂ is bonded and one or more arbitrary elements. Specifically, when a ring is formed by R₁₀₁ and R₁₀₂, when an unsaturated ring is formed by a carbon atom with which R₁₀₁ is bonded, a carbon atom with R₁₀₂ is bonded and four carbon atoms, the ring formed by R₁₀₁ and R₁₀₂ is a benzene ring.

The "arbitrary element" is preferably a C element, a N element, an O element or a S element. In the arbitrary element (C element or N element, for example), atomic bondings that do not form a ring may be terminated by a hydrogen atom, or the like.

The "one or more arbitrary element" is preferably 2 or more and 15 or less, more preferably 3 or more and 12 or less, and further preferably 3 or more and 5 or less arbitrary elements.

For example, R₁₀₁ and R₁₀₂ may form a ring, and simultaneously, R₁₀₅ and R₁₀₆ may form a ring. In this case, the compound represented by the formula (10) is a compound represented by the following formula (10A), for example:

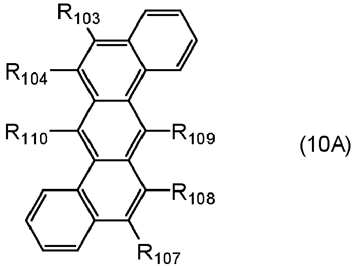

In one embodiment, R₁₀₁ to R₁₁₀ are independently a hydrogen atom, a substituted or unsubstituted alkyl group including 1 to 50 carbon atoms, a substituted or unsubstituted aryl group including 6 to 50 ring carbon atoms, a substituted or unsubstituted heterocyclic group including 5 to 50 ring atoms or a group represented by the formula (31).

Preferably, R₁₀₁ to R₁₁₀ are independently a hydrogen atom, a substituted or unsubstituted aryl group including 6 to 50 ring carbon atoms, a substituted or unsubstituted heterocyclic group including 5 to 50 ring atoms or a group represented by the formula (31).

More preferably, R₁₀₁ to R₁₁₀ are independently a hydrogen atom, a substituted or unsubstituted aryl group including 6 to 18 ring carbon atoms, a substituted or unsubstituted heterocyclic group including 5 to 18 ring atoms or a group represented by the formula (31).

Most preferably, at least one of R₁₀₉ and R₁₁₀ is a group represented by the formula (31).

Further most preferably, R₁₀₉ and R₁₁₀ are independently a group represented by the formula (31).

In one embodiment, the compound (10) is a compound represented by the following formula (10-1): 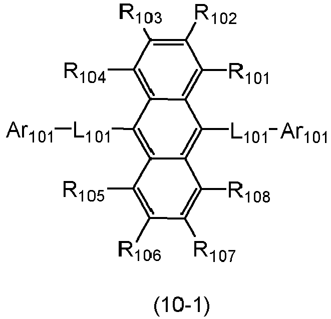 wherein in the formula (10-1), R₁₀₁ to R₁₀₈, L₁₀₁ and Ar₁₀₁ are as defined in the formula (10).

In one embodiment, the compound (10) is a compound represented by the following formula (10-2): 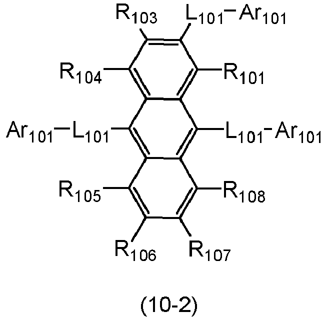 wherein in the formula (10-2), R₁₀₁, R₁₀₃ to R₁₀₈, L₁₀₁ and Ar₁₀₁ are as defined in the formula (10).

In one embodiment, the compound (10) is a compound represented by the following formula (10-3): 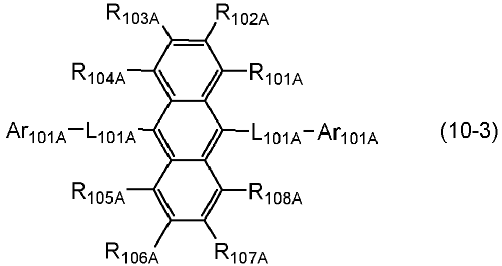 wherein in the formula (10-3),
R_{101A} to R_{108A} are independently a hydrogen atom or a substituted or unsubstituted aryl group including 6 to 50 ring carbon atoms;
L_{101A} is a single bond or a substituted or unsubstituted arylene group including 6 to 30 ring carbon atoms, and the two L_{101A}s may be the same or different;
Ar_{101A} is a substituted or unsubstituted aryl group including 6 to 50 ring carbon atoms, and the two Ar_{101A}s may be the same or different.

In one embodiment, the compound (10) is a compound represented by the following formula (10-4): 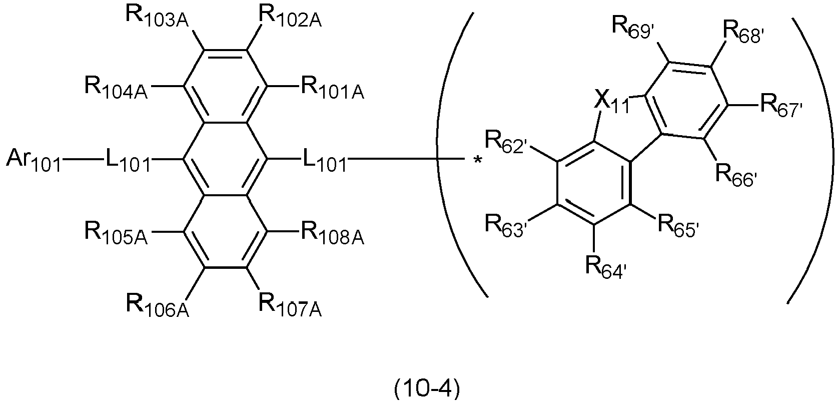 wherein in the formula (10-4),
L₁₀₁ and Ar₁₀₁ are as defined in the formula (10);
R_{101A} to R_{108A} are independently a hydrogen atom or a substituted or unsubstituted aryl group including 6 to 50 ring carbon atoms;
X₁₁ is O, S, or N(R_{61'});
R_{61'} is a hydrogen atom, a substituted or unsubstituted alkyl group including 1 to 50 carbon atoms or a substituted or unsubstituted aryl group including 6 to 50 ring carbon atoms;
one of R_{62'} to R_{69'} is an atomic bonding that is bonded with L₁₀₁;
one or more pairs of adjacent R_{62'} to R_{69'} that are not bonded with L₁₀₁ may be bonded with each other to form a substituted or unsubstituted, saturated or unsaturated ring; and R_{62'} to R_{69'} that are not bonded with L₁₀₁ and do not form the substituted or unsubstituted, saturated or unsaturated ring are independently a hydrogen atom, a substituted or unsubstituted alkyl group including 1 to 50 carbon atoms or a substituted or unsubstituted aryl group including 6 to 50 ring carbon atoms.

In one embodiment, the compound (10) is a compound represented by the following formula (10-4A): 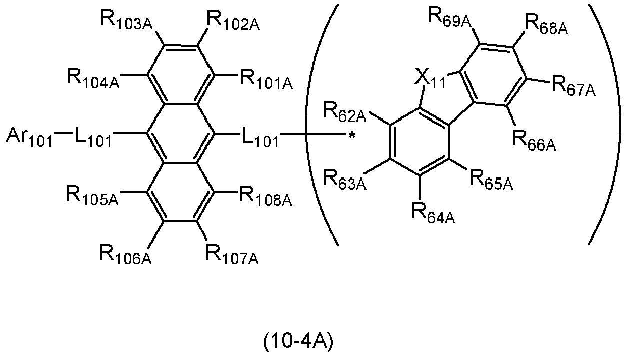 wherein in the formula (10-4A),
L₁₀₁ and Ar₁₀₁ are as defined in the formula (10);
R_{101A} to R_{108A} are independently a hydrogen atom or a substituted or unsubstituted aryl group including 6 to 50 ring carbon atoms;
X₁₁ is O, S or N(R₆₁);
R₆₁ is a hydrogen atom, a substituted or unsubstituted alkyl group including 1 to 50 carbon atoms or a substituted or unsubstituted aryl group including 6 to 50 ring carbon atoms;
one or more pairs of adjacent two or more of R_{62A} to R_{69A} may form a substituted or unsubstituted, saturated or unsaturated ring, and adjacent two of R_{62A} to R_{69A} form a ring represented by the following formula (10-4A-1); and
R_{62A} to R_{69A} that do not form a substituted or unsubstituted, saturated or unsaturated ring are independently a hydrogen atom, a substituted or unsubstituted alkyl group including 1 to 50 carbon atoms or a substituted or unsubstituted aryl group including 6 to 50 ring carbon atoms. 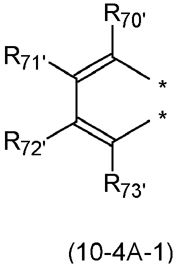
wherein in the formula (10-4A-1),
each of the two atomic bondings * is bonded with adjacent two of R_{62A} to R_{69A};
one of R_{70'} to R_{73'} is an atomic bonding that is bonded with L₁₀₁; and
R_{70'} to R_{73'} that are not bonded with L₁₀₁ are independently a hydrogen atom, a substituted or unsubstituted alkyl group including 1 to 50 carbon atoms or a substituted or unsubstituted aryl group including 6 to 50 ring carbon atoms.

In one embodiment, the compound (10) is a compound represented by the following formula (10-6): 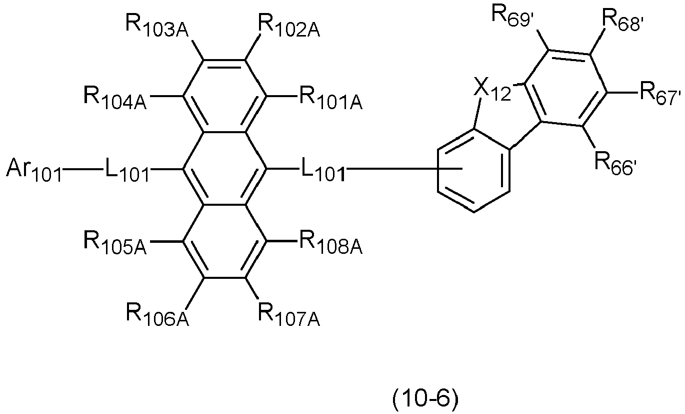 wherein in the formula (10-6),
L₁₀₁ and Ar₁₀₁ are as defined in the formula (10);
R_{101A} to R_{108A} are as defined in the formula (10-4);
R_{66'} to R_{69'} are as defined in the formula (10-4); and
X₁₂ is O or S.

In one embodiment, the compound represented by the formula (10-6) is a compound represented by the following formula (10-6H): 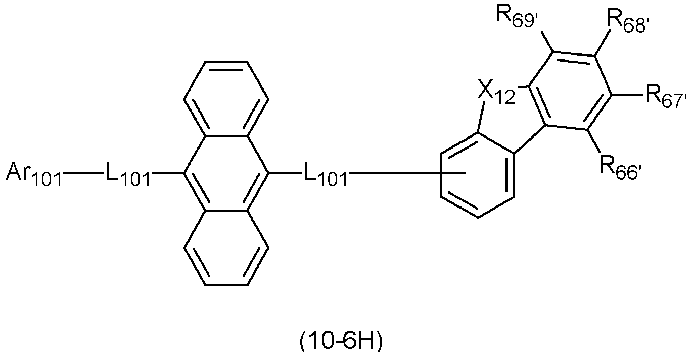 wherein in the formula (10-6H),
L₁₀₁ and Ar₁₀₁ are as defined in the formula (10);
R_{66'} to R_{69'} are as defined in the formula (10-4); and
X₁₂ is O or S.

In one embodiment, the compound represented by the formulae (10-6) and (10-6H) is a compound represented by the following formula (10-6Ha): 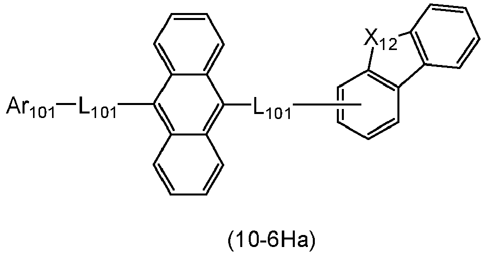 wherein in the formula (10-6Ha),
L₁₀₁ and Ar₁₀₁ are as defined in the formula (10); and
X₁₂ is O or S.

In one embodiment, the compound represented by the formulae (10-6), (10-6H) and (10-6Ha) is a compound represented by the following formula (10-6Ha-1) or (10-6Ha-2): 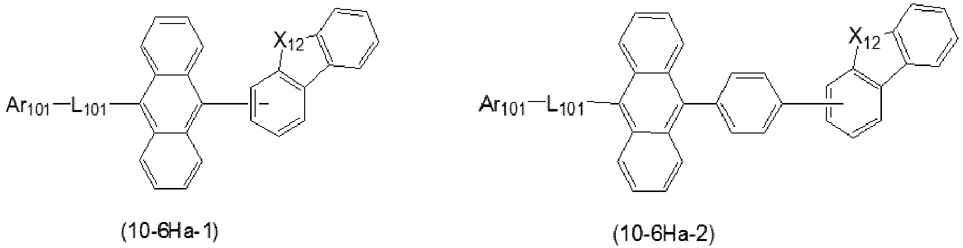 wherein in the formula (10-6Ha-1) and (10-6Ha-2),
L₁₀₁ and Ar₁₀₁ are as defined in the formula (10); and
X₁₂ is O or S.

In one embodiment, the compound (10) is a compound represented by the following formula (10-7): 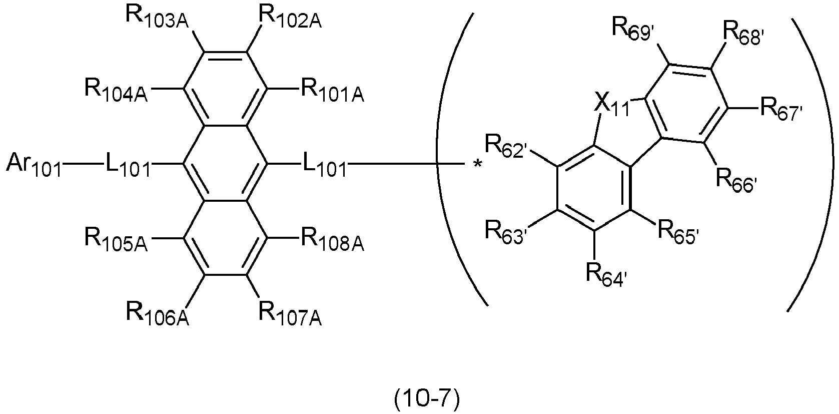 wherein in the formula (10-7),
L₁₀₁ and Ar₁₀₁ are as defined in the formula (10);
R_{101A} to R_{108A} are as defined in the formula (10-4);
X₁₁ is as defined in the formula (10-4); and
R_{62'} to R_{69'} are as defined in the formula (10-4), provided that any one pair of R_{66'} and R_{67'}, R_{67'} and R_{68'}, and R_{68'} and R_{69'} are bonded with each other to form a substituted or unsubstituted, saturated or unsaturated ring.

In one embodiment, the compound (10) is a compound represented by the following formula (10-7H): 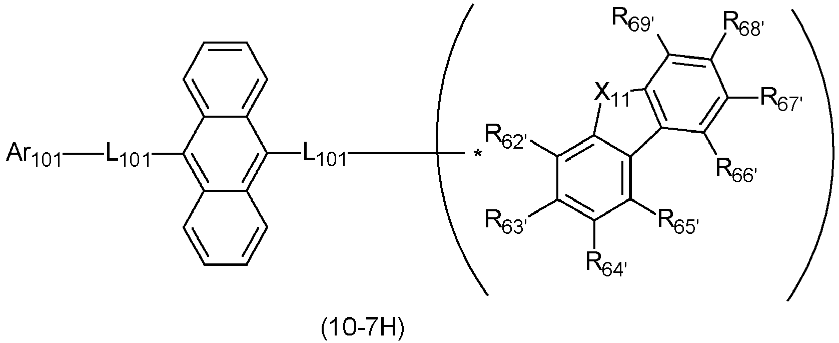 wherein in the formula (10-7H),
L₁₀₁ and Ar₁₀₁ are as defined in the formula (10);
X₁₁ is as defined in the formula (10-4); and
R_{62'} to R_{69'} are as defined in the formula (10-4), provided that any one pair of R_{66'} and R_{67'}, R_{67'} and R_{68'}, and R_{68'} and R_{69'} are bonded with each other to form a substituted or unsubstituted, saturated or unsaturated ring.

In one embodiment, the compound (10) is a compound represented by the following formula (10-8): 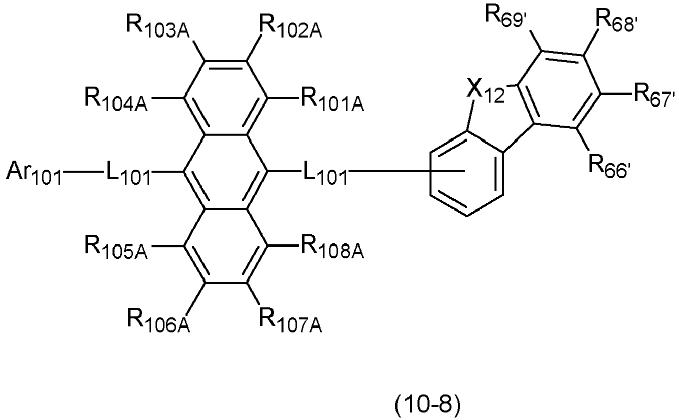 wherein in the formula (10-8),
L₁₀₁ and Ar₁₀₁ are as defined in the formula (10);
R_{101A} to R_{108A} are as defined in the formula (10-4);
X₁₂ is O or S; and
R_{66'} to R_{69'} are as defined in the formula (10-4), provided that any one pair of R_{66'} and R_{67'}, R_{67'} and R_{68'}, as well as R_{68'} and R_{69'} are bonded with each other to form a substituted or unsubstituted, saturated or unsaturated ring.

In one embodiment, the compound represented by the formula (10-8) is a compound represented by the following formula (10-8H):

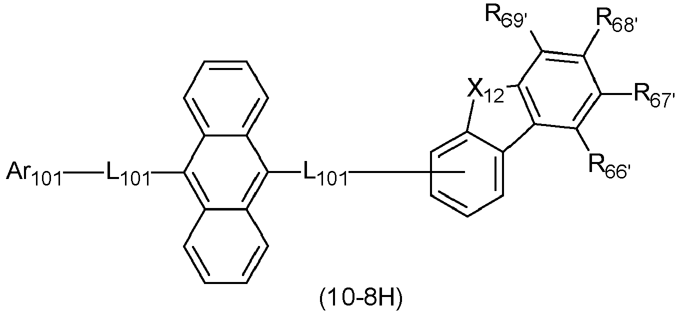

In the formula (10-8H), L₁₀₁ and Ar₁₀₁ are as defined in the formula (10). R_{66'} to R_{69'} are as defined in the formula (10-4), provided that any one pair of R_{66'} and R_{67'}, R_{67'} and R_{68'}, as well as R_{68'} and R_{69'} are bonded with each other to form a substituted or unsubstituted, saturated or unsaturated ring. Any one pair of R_{66'} and R_{67'}, R_{67'} and R_{68'}, as well as R_{68'} and R_{69'} may preferably be bonded with each other to form an unsubstituted benzene ring; and X₁₂ is O or S.

In one embodiment, as for the compound represented by the formula (10-7), (10-8) or (10-8H), any one pair of R_{66'} and R_{67'}, R_{67'} and R_{68'}, as well as R_{68'} and R_{69'} are bonded with each other to form a ring represented by the following formula (10-8-1) or (10-8-2), and R_{66'} to R_{69'} that do not form the ring represented by the formula (10-8-1) or (10-8-2) do not form a substituted or unsubstituted, saturated or unsaturated ring. 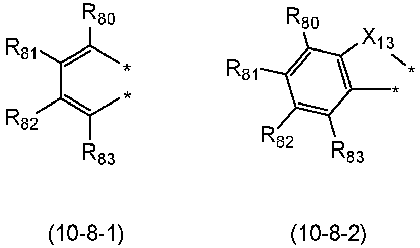 wherein in the formulae (10-8-1) and (10-8-2),
the two atomic bondings * are independently bonded with one pair of R_{66'} and R_{67'}, R_{67'} and R_{68'}, or R_{68'} and R_{69'};
R₈₀ to R₈₃ are independently a hydrogen atom, a substituted or unsubstituted alkyl group including 1 to 50 carbon atoms or a substituted or unsubstituted aryl group including 6 to 50 ring carbon atoms; and
X₁₃ is O or S.

In one embodiment, the compound (10) is a compound represented by the following formula (10-9): 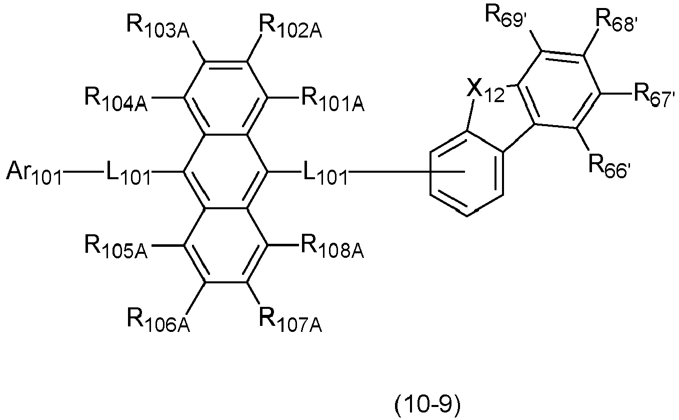 wherein in the formula (10-9),
L₁₀₁ and Ar₁₀₁ are as defined in the formula (10);
R_{101A} to R_{108A} are as defined in the formula (10-4);
R_{66'} to R_{69'} are as defined in the formula (10-4), provided that R_{66'} and R_{67'}, R_{67'} and R_{68'}, as well as R_{68'} and R_{69'} are not bonded with each other and do not form a substituted or unsubstituted, saturated or unsaturated ring; and
X₁₂ is O or S.

In one embodiment, the compound (10) is selected from the group consisting of compounds represented by the following formulae (10-10-1) to (10-10-4).

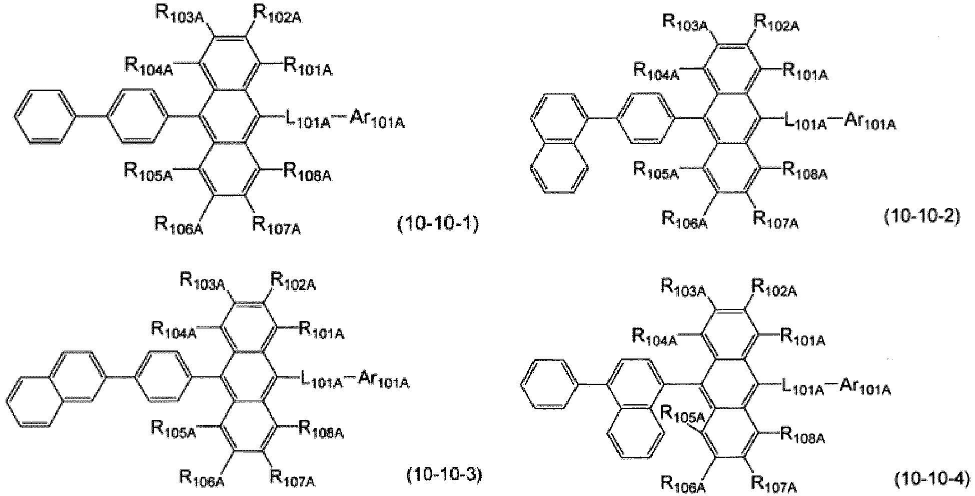

In the formulae (10-10-1H) to (10-10-4H), L_{101A} and Ar_{101A} are as defined in the formula (10-3).

In one embodiment, in the compound represented by the formula (10-1), at least one Ar₁₀₁ is a monovalent group having a structure represented by the following formula (50).

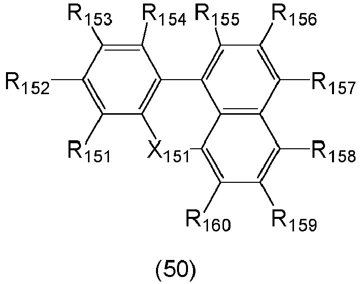

In the formula (50),
X₁₅₁ is O, S, or C(R₁₆₁)(R₁₆₂).

One of R₁₅₁ to R₁₆₀ is a single bond which bonds with L₁₀₁.

One or more sets of adjacent two or more of R₁₅₁ to R₁₅₄ and one or more sets of adjacent two or more of R₁₅₅ to R₁₆₀, which are not a single bond which bonds with L₁₀₁, form a substituted or unsubstituted, saturated or unsaturated ring by bonding with each other, or do not form a substituted or unsubstituted, saturated or unsaturated ring.

R₁₆₁ and R₁₆₂ form a substituted or unsubstituted, saturated or unsaturated ring by bonding with each other, or do not form a substituted or unsubstituted, saturated or unsaturated ring.

R₁₆₁ and R₁₆₂ which do not form the substituted or unsubstituted, saturated or unsaturated ring, and R₁₅₁ to R₁₆₀ which are not a single bond which bonds with L₁₀₁ and do not form the substituted or unsubstituted, saturated or unsaturated ring are independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, -Si(R121)(R122)(R123), -C(=O)R124, -COOR125, -N(R126)(R127), a halogen atom, a cyano group, a nitro group, a substituted or unsubstituted aryl group including 6 to 50 ring carbon atoms, or a substituted or unsubstituted monovalent heterocyclic group including 5 to 50 ring atoms.

Ar₁₀₁, which is not a monovalent group having the structure represented by the formula (50) is a substituted or unsubstituted aryl group including 6 to 50 ring carbon atoms, or a substituted or unsubstituted divalent heterocyclic group including 5 to 50 ring atoms.

The position to be the single bond which bonds with L₁₀₁ in the formula (50) is not particularly limited. In one embodiment, one of R₁₅₁ to R₁₆₀ in the formula (50) is a single bond which bonds with L₁₀₁.

In one embodiment, Ar₁₀₁ is a monovalent group represented by the following formula (50-R₁₅₂), (50-R₁₅₃), (50-R₁₅₄), (50-R₁₅₇), or (50-R₁₅₈).

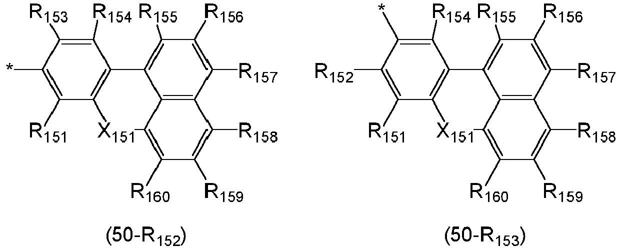

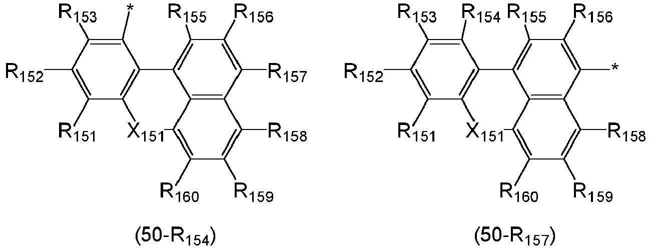

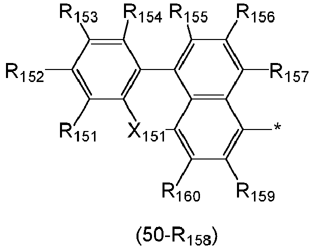

In the formulas (50-R₁₅₂), (50-R₁₅₃), (50-R₁₅₄), (50-R₁₅₇), and (50-R₁₅₈), X₁₅₁, R₁₅₁ to R₁₆₀ are as defined in the formula (50).

* is a single bond which bonds with L₁₀₁.

As for the compound represented by the formula (10), the following compounds can be given as specific examples. The compound represented by the formula (10) is not limited to these specific examples. In the following specific examples, "D" represents a deuterium atom.

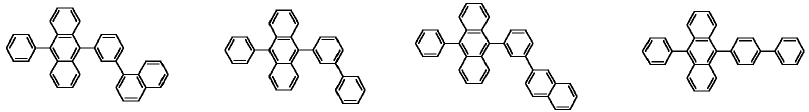

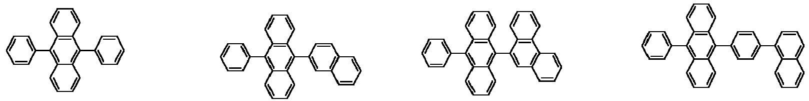

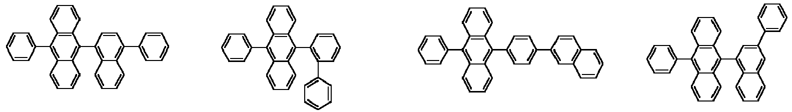

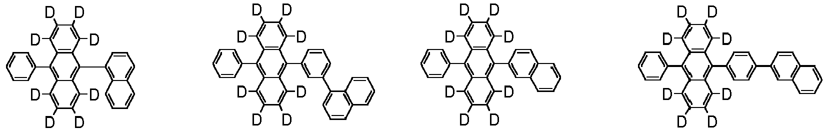

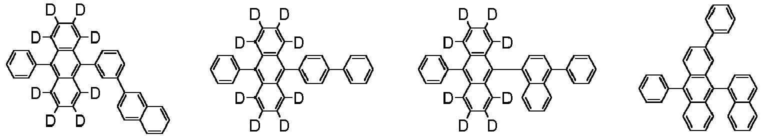

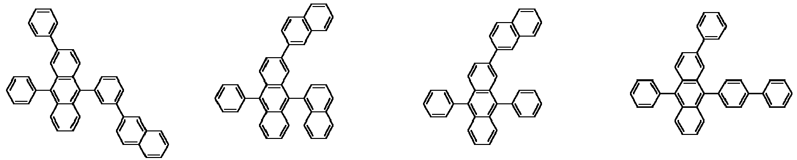

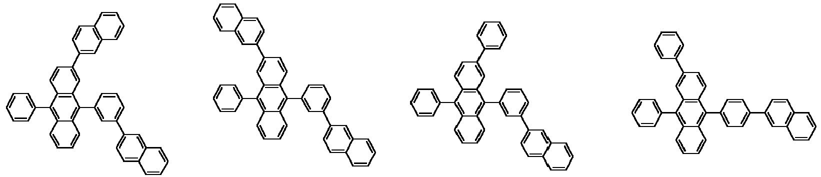

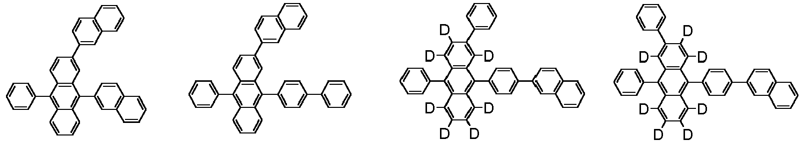

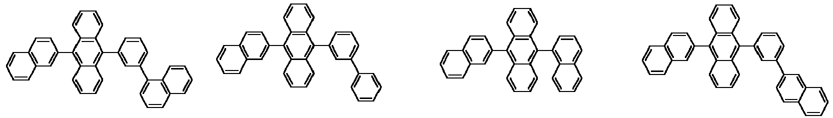

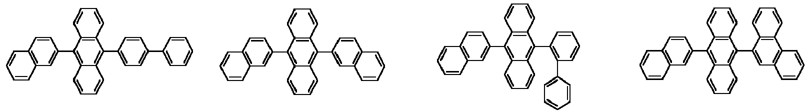

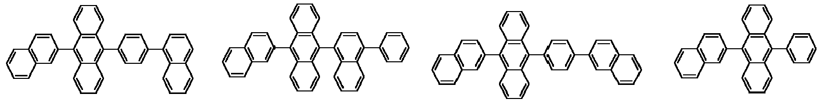

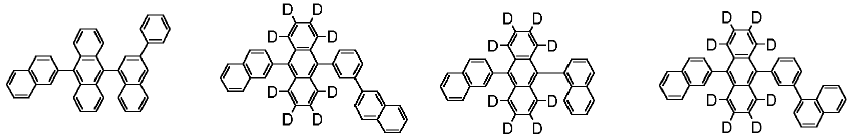

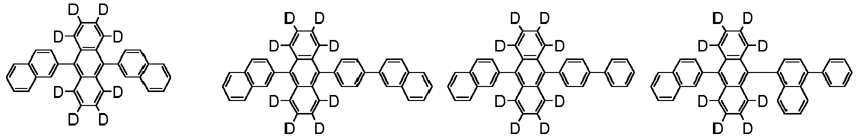

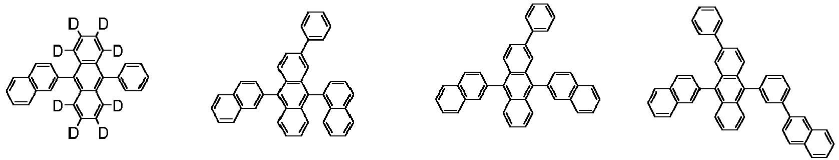

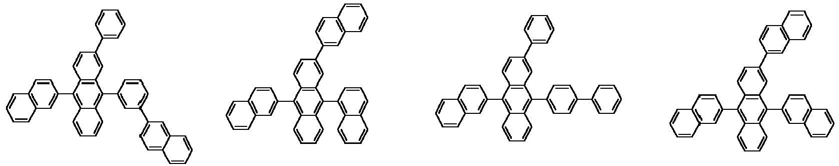

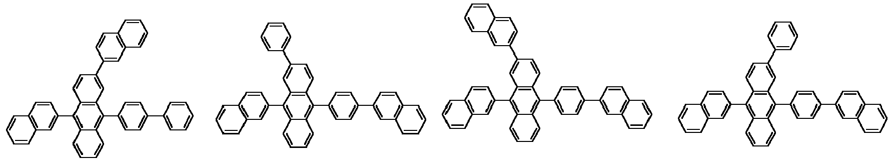

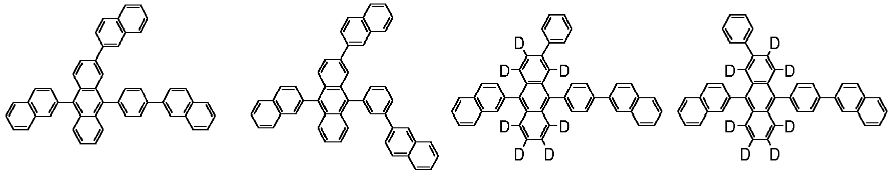

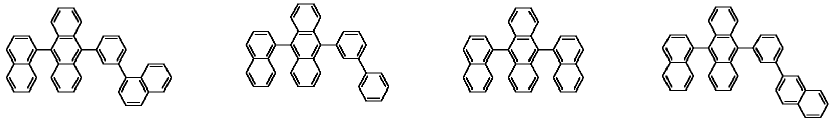

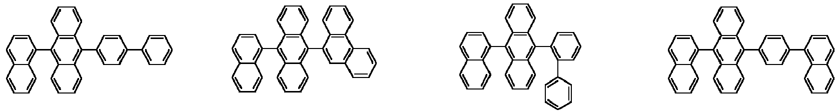

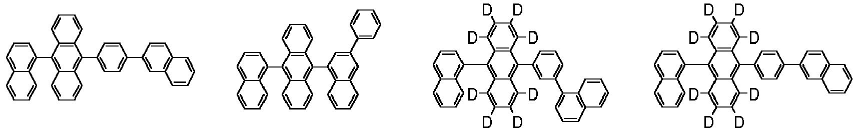

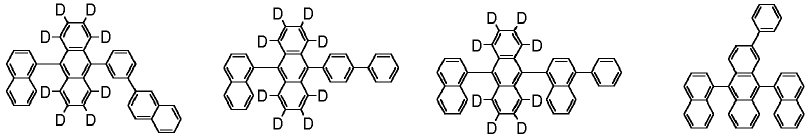

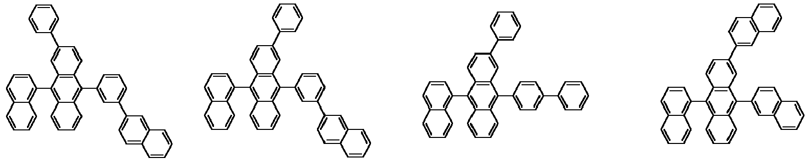

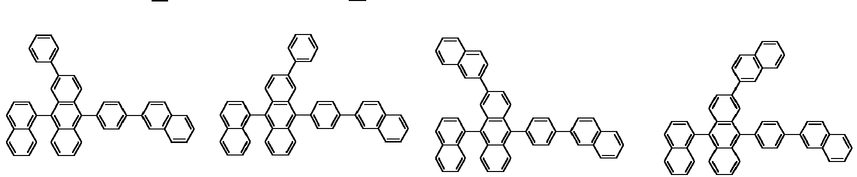

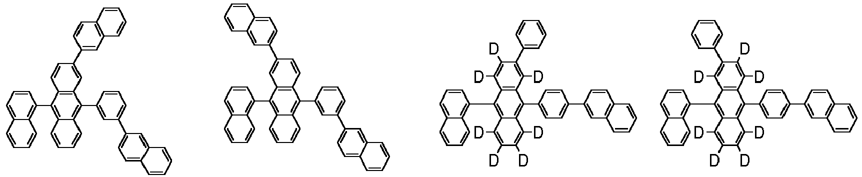

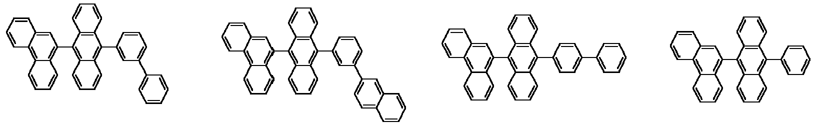

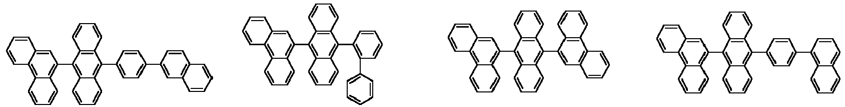

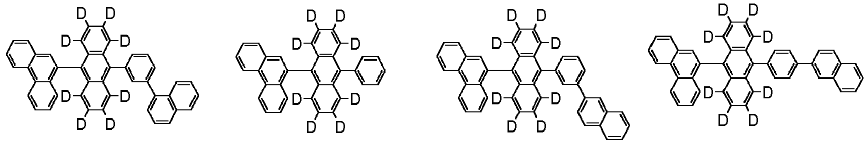

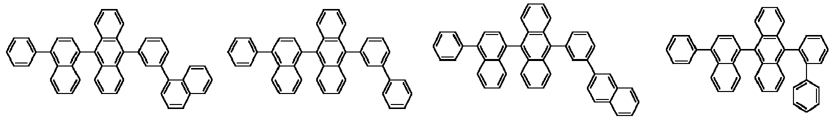

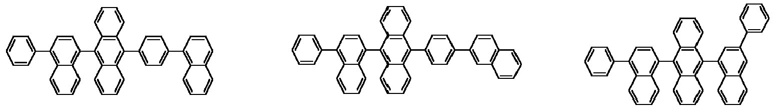

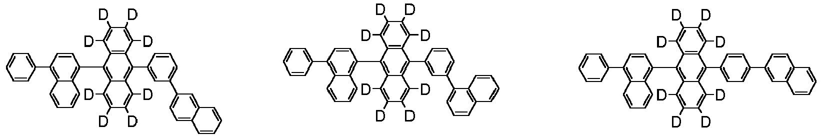

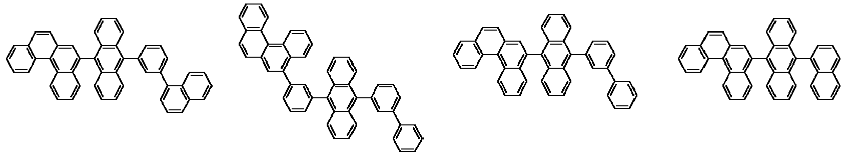

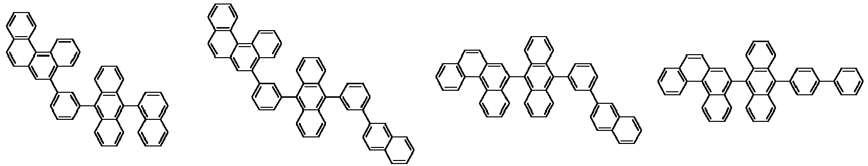

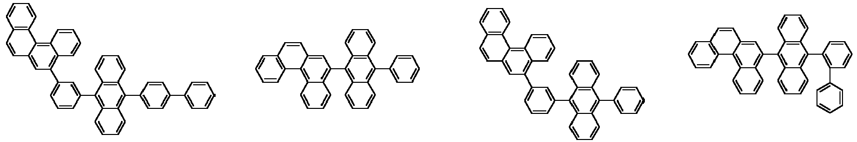

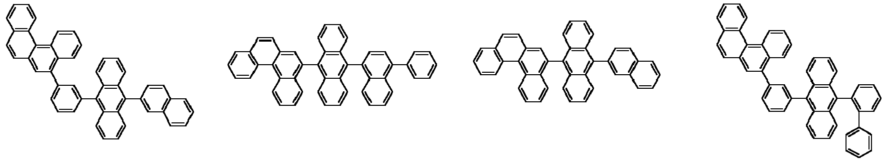

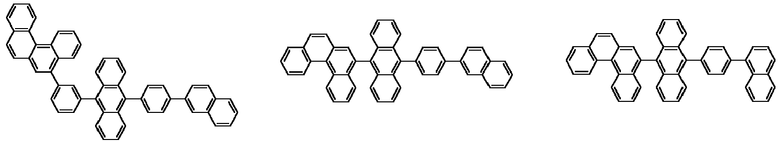

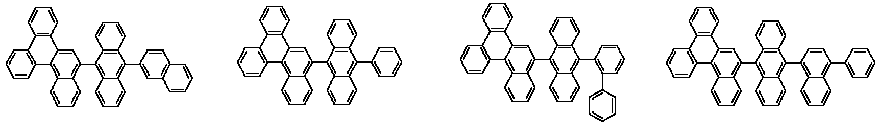

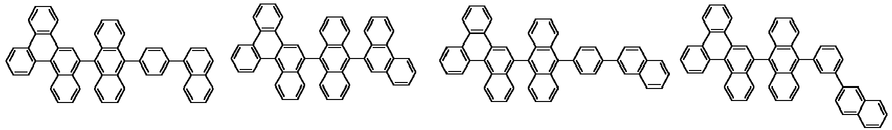

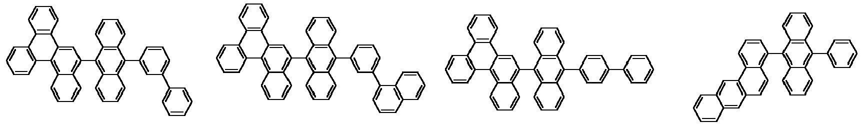

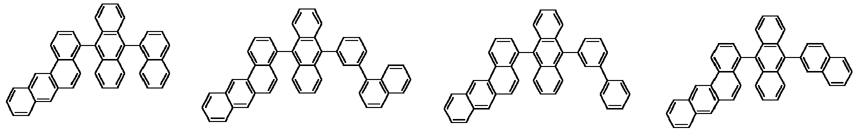

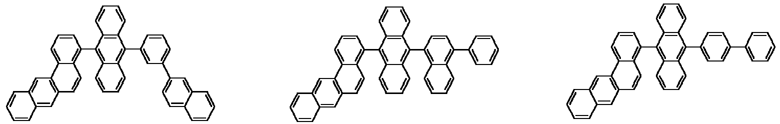

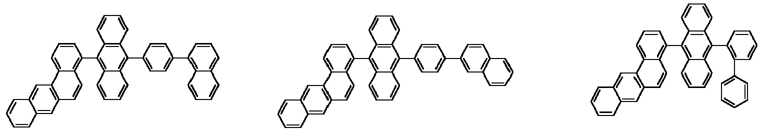

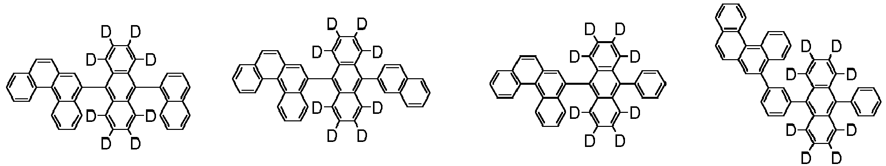

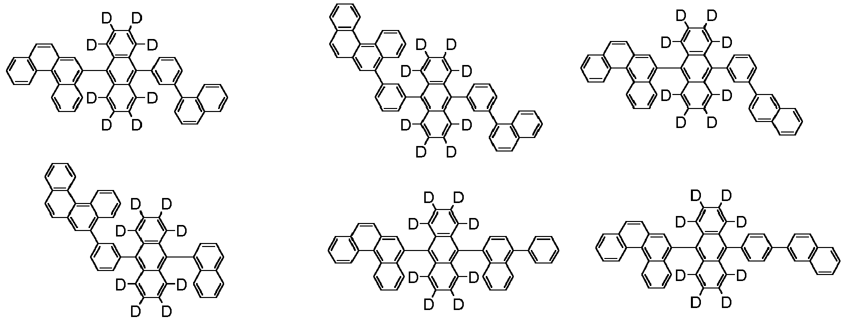

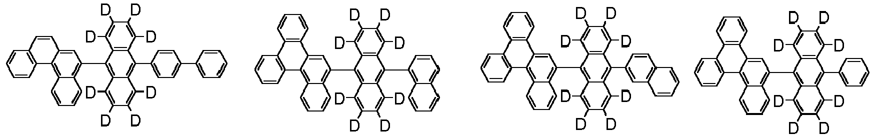

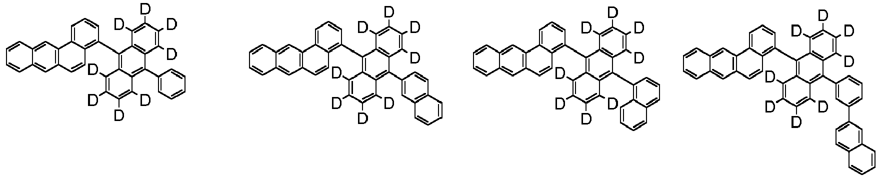

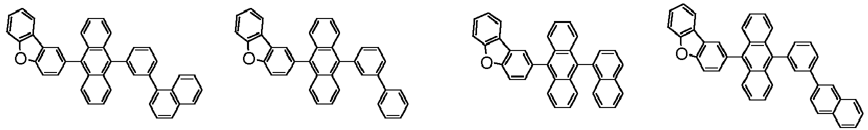

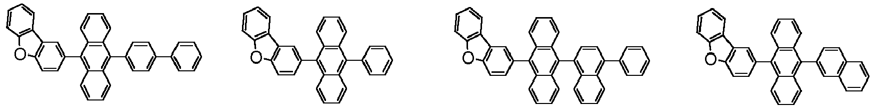

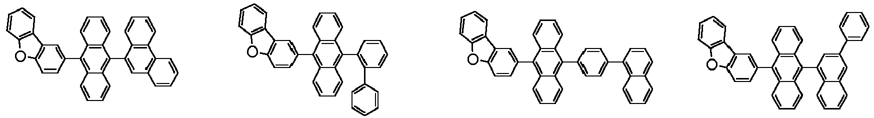

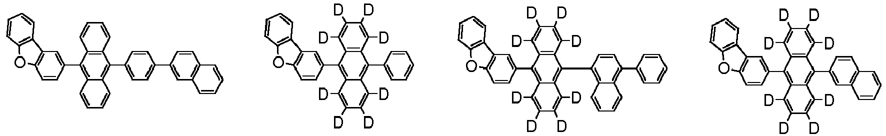

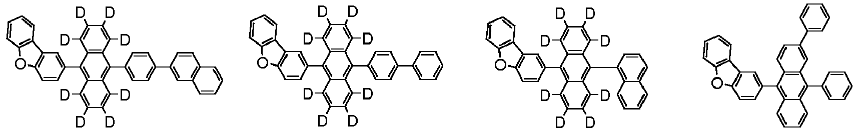

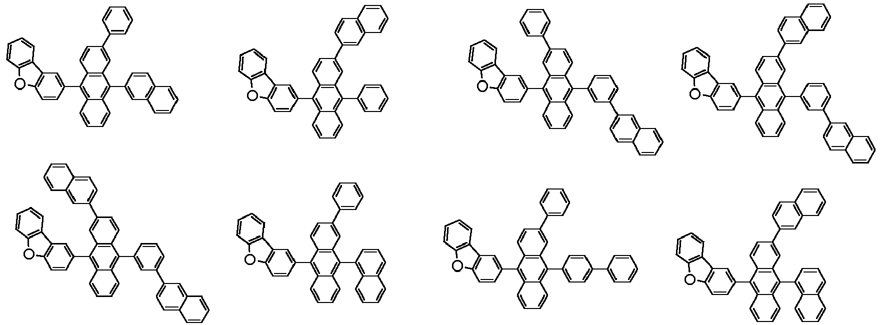

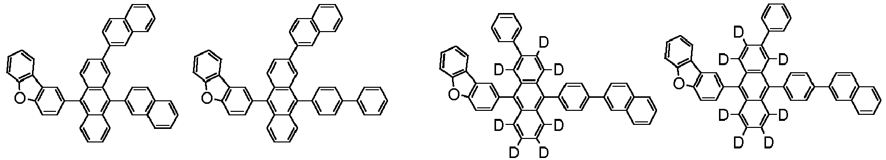

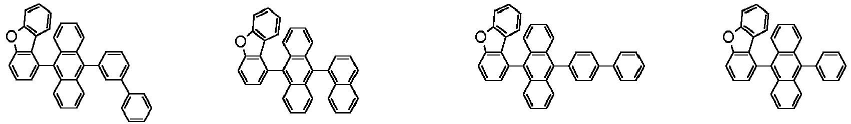

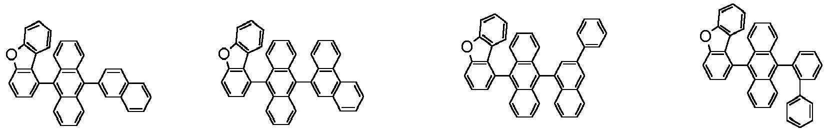

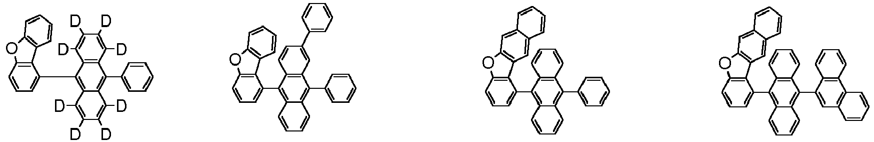

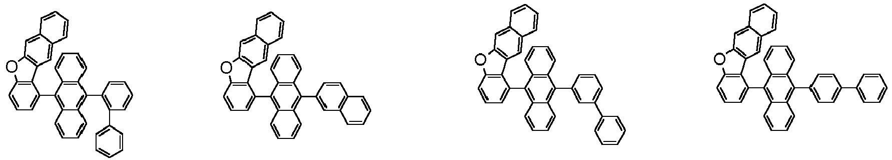

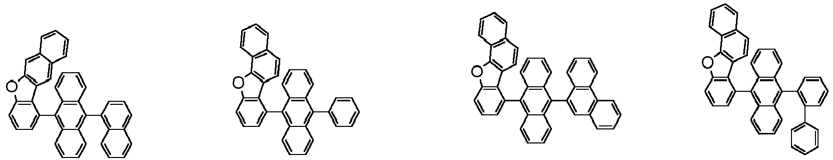

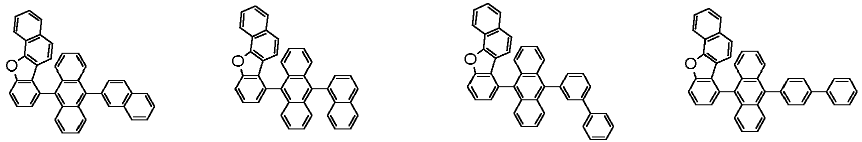

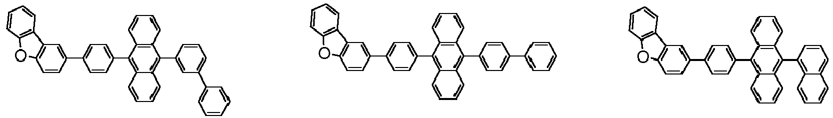

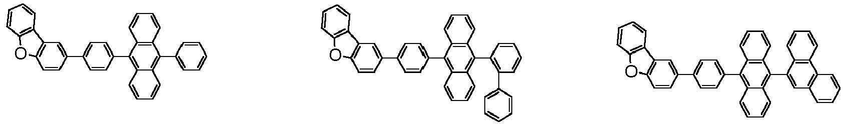

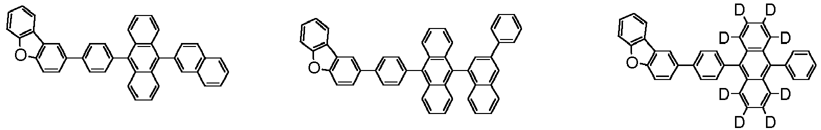

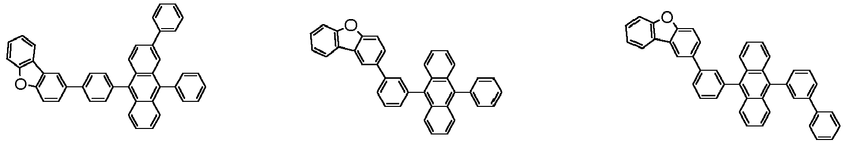

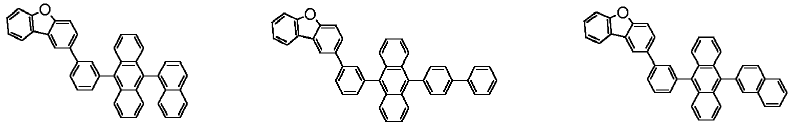

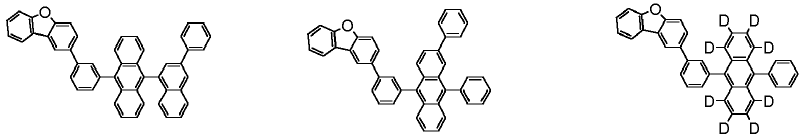

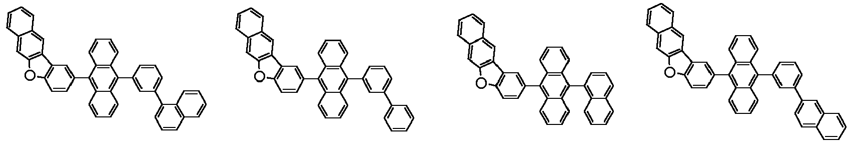

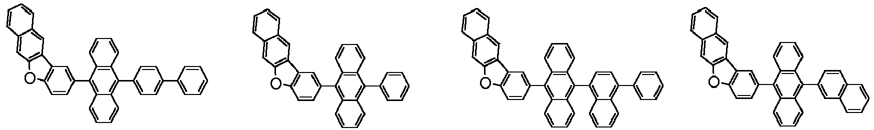

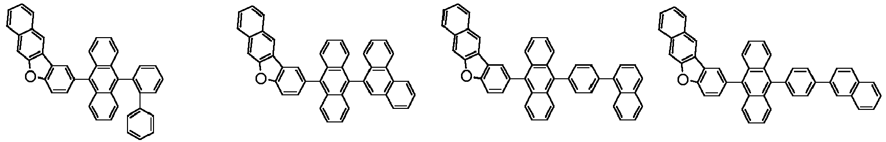

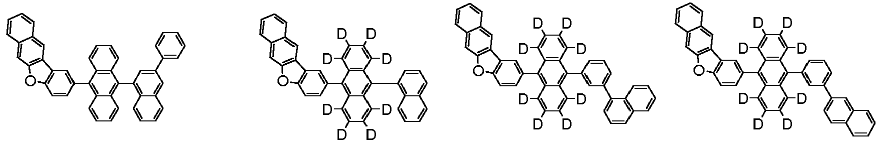

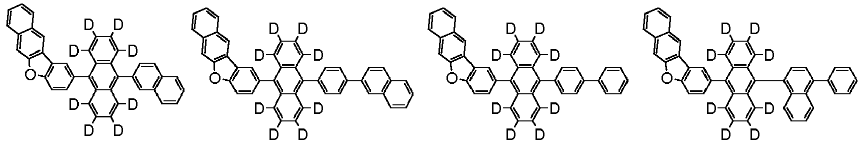

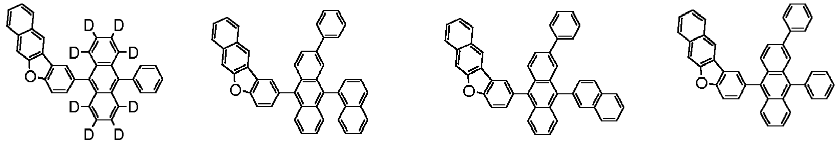

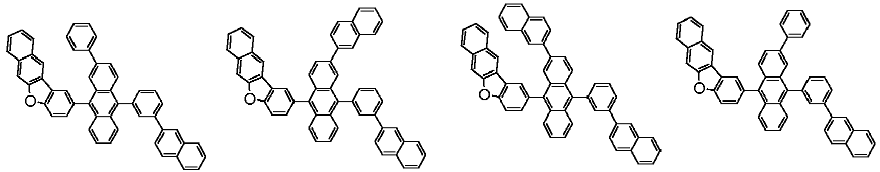

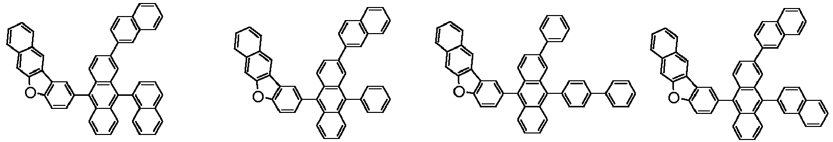

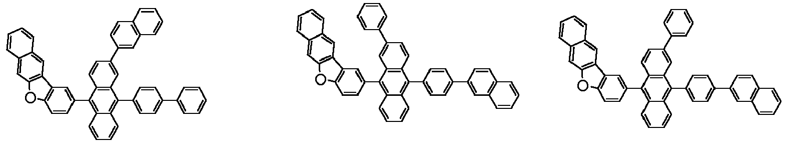

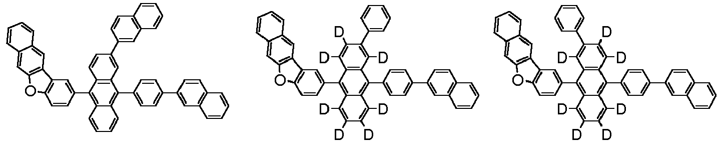

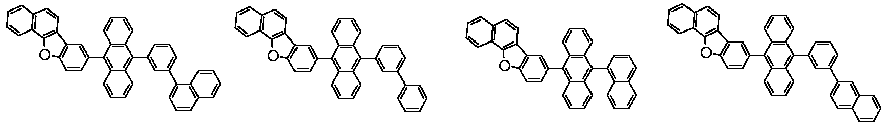

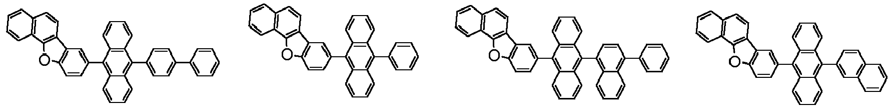

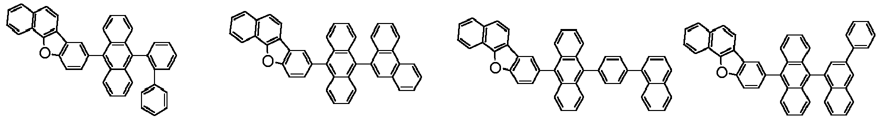

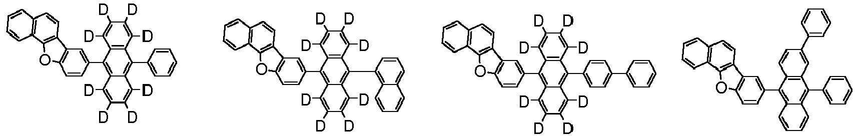

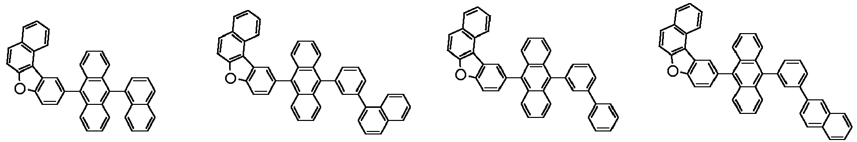

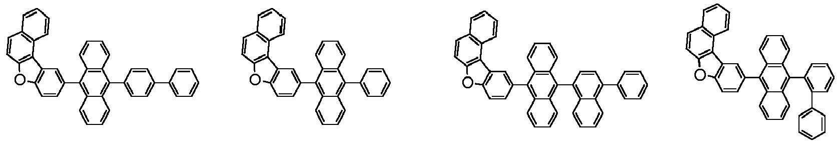

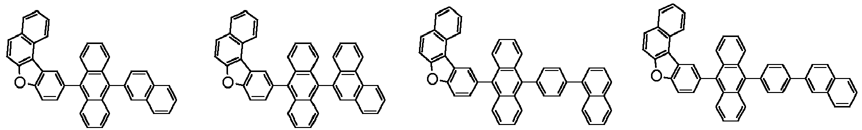

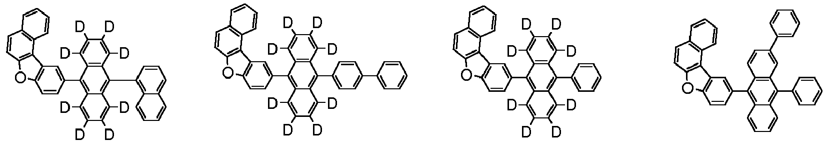

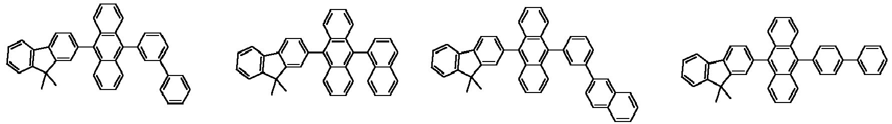

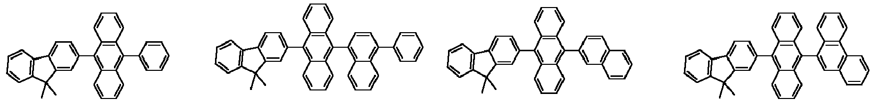

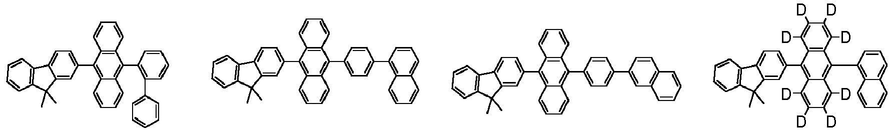

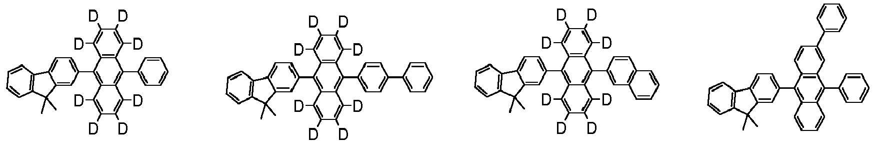

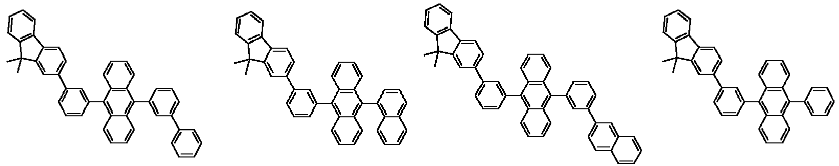

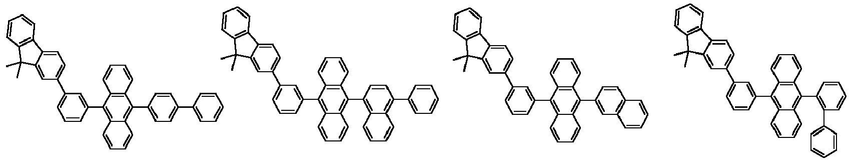

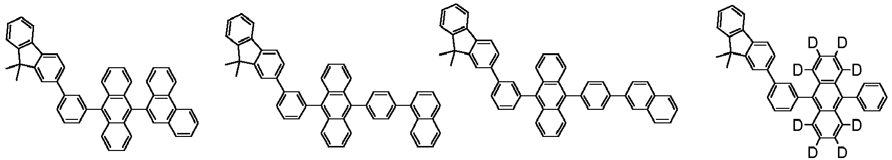

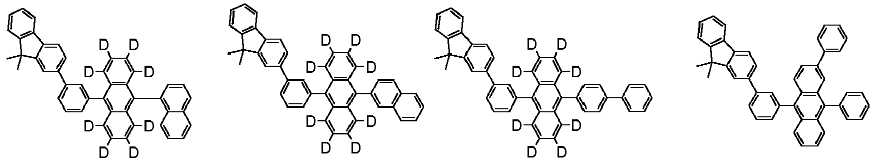

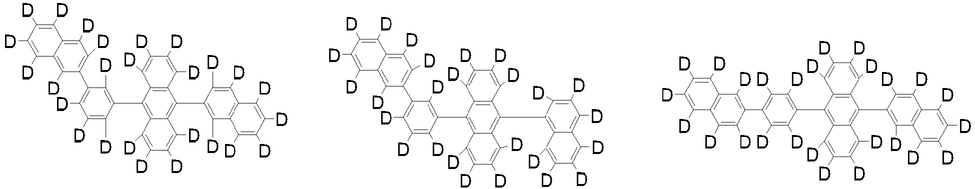

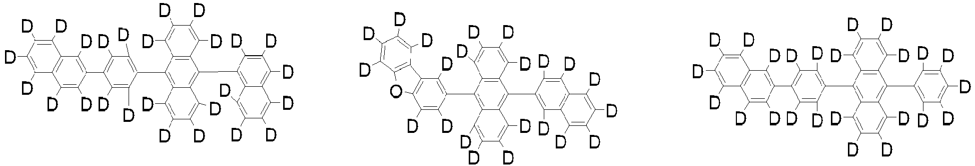

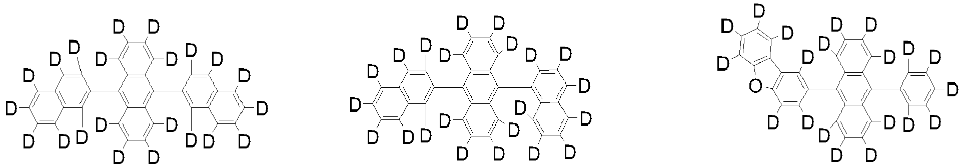

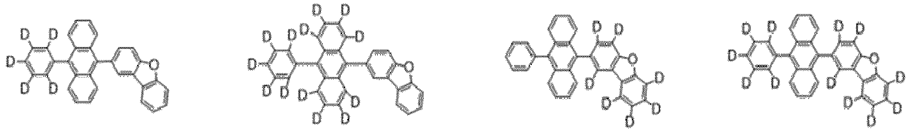

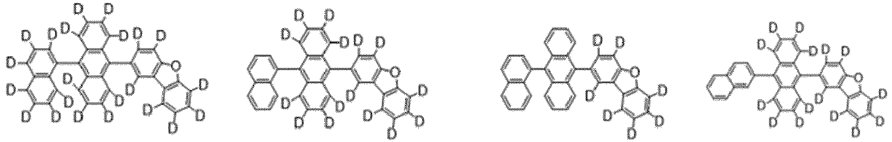

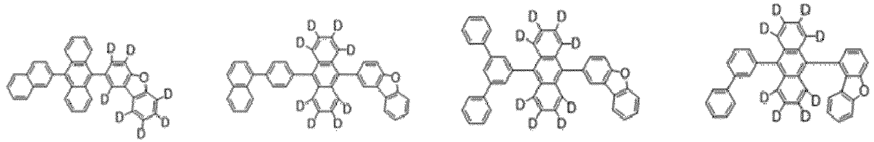

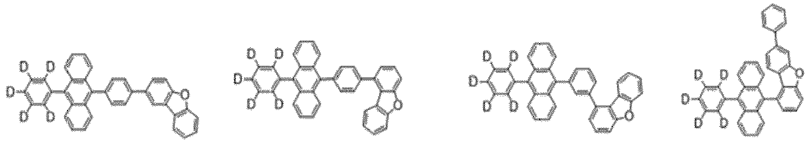

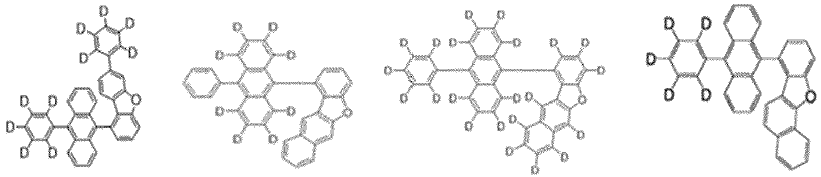

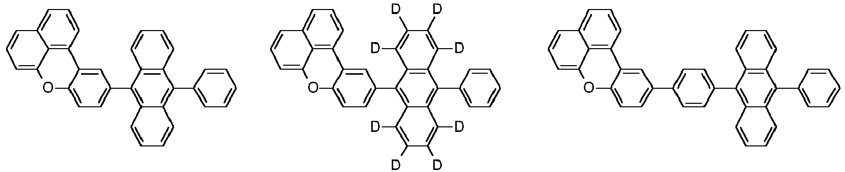

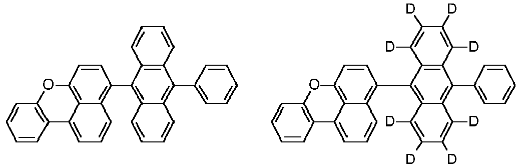

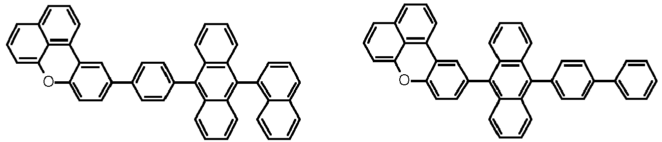

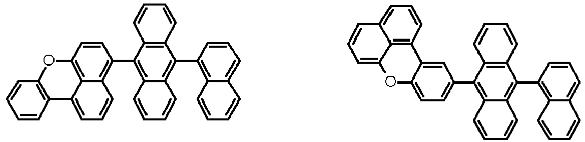

In the case that the emitting layer comprises the compound represented by formula (I) as a dopant and at least one host, wherein preferred hosts are mentioned above, and the host is more preferably at least one compound represented by formula (10), the content of the at least one compound represented by formula (I) is preferably 0.5 mass% to 70 mass%, more preferably 0.5 to 30 mass%, further preferably 1 to 30 mass%, still further preferably 1 to 20 mass%, and particularly preferably 1 to 10 mass%, further particularly preferably 1 to 5 mass%, relative to the entire mass of the emitting layer.

The content of the at least one host, wherein preferred hosts are mentioned above, preferably the at least one compound represented by formula (10) is preferably 30 mass% to 99.9 mass%, more preferably 70 to 99.5 mass%, further preferably 70 to 99 mass%, still further preferably 80 to 99 mass%, and particularly preferably 90 to 99 mass%, further particularly preferably 95 to 99 mass %, relative to the entire mass of the emitting layer.

**An explanation will be made on the layer configuration of the organic EL device according to one aspect of the invention.**

An organic EL device according to one aspect of the invention comprises a cathode, an anode, and one or more organic thin film layers comprising an emitting layer disposed between the cathode and the anode. The organic layer comprises at least one layer composed of an organic compound. Alternatively, the organic layer is formed by laminating a plurality of layers composed of an organic compound. The organic layer may further comprise an inorganic compound in addition to the organic compound.

At least one of the organic layers is an emitting layer. The organic layer may be constituted, for example, as a single emitting layer, or may comprise other layers which can be adopted in the layer structure of the organic EL device. The layer that can be adopted in the layer structure of the organic EL device is not particularly limited, but examples thereof include a hole-transporting zone (comprising at least one hole-transporting layer and preferably in addition at least one of a hole-injecting layer, an electron-blocking layer, an exciton-blocking layer, etc.), an emitting layer, a spacing layer, and an electron-transporting zone (comprising at least one electron-transporting layer and preferably in addition at least one of an electron-injecting layer, a hole-blocking layer, etc.) provided between the cathode and the emitting layer.

The organic EL device according to one aspect of the invention may be, for example, a fluorescent or phosphorescent monochromatic light emitting device or a fluorescent/phosphorescent hybrid white light emitting device. Preferably, the organic EL device is a fluorescent monochromatic light emitting device, more preferably a blue fluorescent monochromatic light emitting device or a fluorescent/phosphorescent hybrid white light emitting device. Blue fluorescence means a fluorescence at 400 to 500 nm (peak maximum), preferably at 430 nm to 490 nm (peak maximum).

Further, it may be a simple type device having a single emitting unit or a tandem type device having a plurality of emitting units.

The "emitting unit" in the specification is the smallest unit that comprises organic layers, in which at least one of the organic layers is an emitting layer and light is emitted by recombination of injected holes and electrons.

In addition, the "emitting layer" described in the present specification is an organic layer having an emitting function. The emitting layer is, for example, a phosphorescent emitting layer, a fluorescent emitting layer or the like, preferably a fluorescent emitting layer, more preferably a blue fluorescent emitting layer, and may be a single layer or a stack of a plurality of layers.

The emitting unit may be a stacked type unit having a plurality of phosphorescent emitting layers or fluorescent emitting layers. In this case, for example, a spacing layer for preventing excitons generated in the phosphorescent emitting layer from diffusing into the fluorescent emitting layer may be provided between the respective light-emitting layers.

As the simple type organic EL device, a device configuration such as anode/emitting unit/cathode can be given.

Examples for representative layer structures of the emitting unit are shown below. The layers in parentheses are provided arbitrarily.
(a) (Hole-injecting layer/) Hole-transporting layer/Fluorescent emitting layer (/Electron- transporting layer/Electron-injecting layer)
(b) (Hole-injecting layer/) Hole-transporting layer/Phosphorescent emitting layer (/Electron-transporting layer/Electron-injecting layer)
(c) (Hole-injecting layer/) Hole-transporting layer/First fluorescent emitting layer/Second fluorescent emitting layer (/Electron-transporting layer/Electron-injecting layer)
(d) (Hole-injecting layer/) Hole-transporting layer/First phosphorescent layer/Second phosphorescent layer (/Electron-transporting layer/Electron-injecting layer)
(e) (Hole-injecting layer/) Hole-transporting layer/Phosphorescent emitting layer/Spacing layer /Fluorescent emitting layer (/Electron-transporting layer/Electron-injecting layer)
(f) (Hole-injecting layer/) Hole-transporting layer/First phosphorescent emitting layer/Second phosphorescent emitting layer/Spacing layer/Fluorescent emitting layer (/Electron-transporting layer/Electron-injecting layer)
(g) (Hole-injecting layer/) Hole-transporting layer/First phosphorescent layer/Spacing layer/ Second phosphorescent emitting layer/Spacing layer/Fluorescent emitting layer (/Electron-transporting layer / Electron-injecting layer)
(h) (Hole-injecting layer/) Hole-transporting layer/Phosphorescent emitting layer/Spacing layer/First fluorescent emitting layer/Second fluorescent emitting layer (/Electron-transporting Layer/Electron-injecting Layer)
(i) (Hole-injecting layer/) Hole-transporting layer/Electron-blocking layer/Fluorescent emitting layer (/Electron-transporting layer/Electron-injecting layer)
(j) (Hole-injecting layer/) Hole-transporting layer/Electron-blocking layer/Phosphorescent emitting layer (/Electron-transporting layer /Electron-injecting layer)
(k) (Hole-injecting layer/) Hole-transporting layer/Exciton-blocking layer/Fluorescent emitting layer (/Electron-transporting layer/Electron-injecting layer)
(l) (Hole-injecting layer/) Hole-transporting layer/Exciton-blocking layer/Phosphorescent emitting layer (/Electron-transporting layer/Electron-injecting layer)
(m) (Hole-injecting layer/) First hole-transporting Layer/Second hole-transporting Layer/ Fluorescent emitting layer (/Electron-transporting layer/electron-injecting Layer)
(n) (Hole-injecting layer/) First hole-transporting layer/Second hole-transporting layer/ Fluorescent emitting layer (/First electron-transporting layer/Second electron-transporting layer /Elec-tron-injection layer)
(o) (Hole-injecting layer/) First hole-transporting layer /Second hole-transporting layer/Phosphorescent emitting layer (/Electron-transporting layer /Electron-injecting Layer)
(p) (Hole-injecting layer/) First hole-transporting layer/Second hole-transporting layer /Phospho-rescent emitting layer (/First electron-transporting Layer/Second electron-transporting layer /Electron-injecting layer)
(q) (Hole-injecting layer/) Hole-transporting layer/Fluorescent emitting layer/Hole-blocking layer (/Electron-transporting layer/Electron-injecting layer)
(r) (Hole-injecting layer /) Hole-transporting layer/Phosphorescent emitting layer/ Hole-blocking layer (/ Electron-transport layer/ Electron-injecting layer)
(s) (Hole-injecting layer/) Hole-transporting layer/Fluorescent emitting layer /Exciton-blocking layer (/Electron-transporting layer/Electron-injecting layer)
(t) (Hole-injecting layer/) Hole-transporting layer/Phosphorescent emitting layer /Exciton- blocking layer (/Electron-transporting layer/Electron-injecting layer)

The layer structure of the organic EL device according to one aspect of the invention is not limited to the examples mentioned above.

For example, when the organic EL device has a hole-injecting layer and a hole-transporting layer, it is preferred that a hole-injecting layer be provided between the hole-transporting layer and the anode. Further, when the organic EL device has an electron-injecting layer and an electron-transporting layer, it is preferred that an electron-injecting layer be provided between the electron-transporting layer and the cathode. Further, each of the hole-injecting layer, the hole-transporting layer, the electron-transporting layer and the electron-injecting layer may be formed of a single layer or be formed of a plurality of layers.

The plurality of phosphorescent emitting layer, and the plurality of the phosphorescent emitting layer and the fluorescent emitting layer may be emitting layers that emit mutually different colors. For example, the emitting unit (f) may include a hole-transporting layer/first phosphorescent layer (red light emission)/ second phosphorescent emitting layer (green light emission)/spacing layer/fluorescent emitting layer (blue light emission)/electron-transporting layer.

An electron-blocking layer may be provided between each light emitting layer and the hole-transporting layer or the spacing layer. Further, a hole-blocking layer may be provided between each emitting layer and the electron-transporting layer. By providing the electron-blocking layer or the hole-blocking layer, it is possible to confine electrons or holes in the emitting layer, thereby to improve the recombination probability of carriers in the emitting layer, and to improve light emitting efficiency.

As a representative device configuration of a tandem type organic EL device, for example, a device configuration such as anode/first emitting unit/intermediate layer/second emitting unit/cathode can be given.

The first emitting unit and the second emitting unit are independently selected from the above-mentioned emitting units, for example.

The intermediate layer is also generally referred to as an intermediate electrode, an intermediate conductive layer, a charge generating layer, an electron withdrawing layer, a connecting layer, a connector layer, or an intermediate insulating layer. The intermediate layer is a layer that supplies electrons to the first emitting unit and holes to the second emitting unit, and can be formed from known materials.

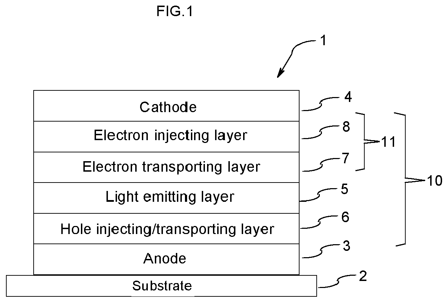

FIG. 1 shows a schematic configuration of one example of the organic EL device of the invention. The organic EL device 1 comprises a substrate 2, an anode 3, a cathode 4 and an emitting unit 10 provided between the anode 3 and the cathode 4. The emitting unit 10 comprises an emitting layer 5 preferably comprising a host material and a dopant. A hole injecting and transporting layer 6 or the like may be provided between the emitting layer 5 and the anode 3 and an electron injecting layer 8 and an electron transporting layer 7 or the like (electron injecting and transporting unit 11) may be provided between the emitting layer 5 and the cathode 4. An electron-barrier layer may be provided on the anode 3 side of the emitting layer 5 and a hole-barrier layer may be provided on the cathode 4 side of the emitting layer 5. Due to such configuration, electrons or holes can be confined in the emitting layer 5, whereby possibility of generation of excitons in the emitting layer 5 can be improved.

**Hereinbelow, an explanation will be made on function, materials, etc. of each layer constituting the organic EL device described in the present specification.**

### (Substrate)

The substrate is used as a support of the organic EL device. The substrate preferably has a light transmittance of 50% or more in the visible light region with a wavelength of 400 to 700 nm, and a smooth substrate is preferable. Examples of the material of the substrate include soda-lime glass, aluminosilicate glass, quartz glass, plastic and the like. As a substrate, a flexible substrate can be used. The flexible substrate means a substrate that can be bent (flexible), and examples thereof include a plastic substrate and the like. Specific examples of the material for forming the plastic substrate include polycarbonate, polyallylate, polyether sulfone, polypropylene, polyester, polyvinyl fluoride, polyvinyl chloride, polyimide, polyethylene naphthalate and the like. Also, an inorganic vapor deposited film can be used.

### (Anode)

As the anode, for example, it is preferable to use a metal, an alloy, a conductive compound, a mixture thereof or the like and having a high work function (specifically, 4.0 eV or more). Specific examples of the material of the anode include indium oxide-tin oxide (ITO: Indium Tin Oxide), indium oxide-tin oxide containing silicon or silicon oxide, indium oxide-zinc oxide, indium oxide containing tungsten oxide or zinc oxide, graphene and the like. In addition, it is also possible to use gold, silver, platinum, nickel, tungsten, chromium, molybdenum, iron, cobalt, copper, palladium, titanium, and nitrides of these metals (e.g. titanium oxide).

The anode is normally formed by depositing these materials on the substrate by a sputtering method. For example, indium oxide-zinc oxide can be formed by a sputtering method by using a target in which 1 to 10 mass% zinc oxide is added relative to indium oxide. Further, indium oxide containing tungsten oxide or zinc oxide can be formed by a sputtering method by using a target in which 0.5 to 5 mass% of tungsten oxide or 0.1 to 1 mass% of zinc oxide is added relative to indium oxide.

As other methods for forming the anode, a vacuum deposition method, a coating method, an inkjet method, a spin coating method or the like can be given. When silver paste or the like is used, it is possible to use a coating method, an inkjet method or the like.

The hole-injecting layer formed in contact with the anode is formed by using a material that allows easy hole injection regardless of the work function of the anode. For this reason, in the anode, it is possible to use a common electrode material, e.g. a metal, an alloy, a conductive compound and a mixture thereof. Specifically, a material having a small work function such as alkaline metals such as lithium and cesium; alkaline earth metals such as calcium and strontium; alloys containing these metals (for example, magnesium-silver and aluminum-lithium); rare earth metals such as europium and ytterbium; and an alloy containing rare earth metals.

### (Hole-transporting layer) / (Hole-injecting layer)

The hole-transporting layer is an organic layer that is formed between the emitting layer and the anode, and has a function of transporting holes from the anode to the emitting layer. If the hole-transporting layer is composed of plural layers, an organic layer that is nearer to the anode may often be defined as the hole-injecting layer. The hole-injecting layer has a function of injecting holes efficiently to the organic layer unit from the anode. Said hole injection layer is generally used for stabilizing hole injection from anode to hole transporting layer which is generally consist of organic materials. Organic material having good contact with anode or organic material with p-type doping is preferably used for the hole injection layer.

p-doping usually consists of one or more p-dopant materials and one or more matrix materials. Matrix materials preferably have shallower HOMO level and p-dopant preferably have deeper LUMO level to enhance the carrier density of the layer. Specific examples for p-dopants are the below mentioned acceptor materials. Suitable matrix materials are the hole transport materials mentioned below, preferably aromatic or heterocyclic amine compounds.

Acceptor materials, or fused aromatic hydrocarbon materials or fused heterocycles which have high planarity, are preferably used as p-dopant materials for the hole injection layer.

Specific examples for acceptor materials are, quinone compounds with one or more electron withdrawing groups, such as F₄TCNQ (2,3,5,6-tetrafluoro-7,7,8,8-tetracyanoquinodimethane), and 1,2,3-tris[(cyano)(4-cyano-2,3,5,6-tetrafluorophenyl)methylene]cyclopropane; hexa-azatri-phenylene compounds with one or more electron withdrawing groups, such as hexa-azatri-phenylene-hexanitrile; aromatic hydrocarbon compounds with one or more electron withdrawing groups; and aryl boron compounds with one or more electron withdrawing groups. Preferred p-dopants are quinone compounds with one or more electron withdrawing groups, such as F₄TCNQ, 1,2,3-Tris[(cyano)(4-cyano-2,3,5,6-tetrafluorophenyl)methylene]cyclopropane.

The ratio of the p-type dopant is preferably less than 20% of molar ratio, more preferably less than 10%, such as 1%, 3%, or 5%, related to the matrix material.

The hole transporting layer is generally used for injecting and transporting holes efficiently, and aromatic or heterocyclic amine compounds are preferably used.

Specific examples for compounds for the hole transporting layer are represented by the general formula (H), 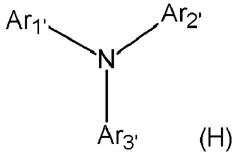 wherein
Ar_{1'} to Ar_{3'} each independently represents substituted or unsubstituted aryl group having 5 to 50 carbon atoms or substituted or unsubstituted heterocyclic group having 5 to 50 cyclic atoms, preferably phenyl group, biphenyl group, terphenyl group, naphthyl group, phenanthryl group, triphenylenyl group, fluorenyl group, spirobifluorenyl group, indenofluorenyl group, carbazolyl
group, dibenzofuranyl group, dibenzothiophenyl group, carbazole substituted aryl group, dibenzofuran substituted aryl group or dibenzothiophene substituted aryl group; two or more substituents selected among Ar_{1'} to Ar_{3'} may be bonded to each other to form a ring structure, such as a carbazole ring structure, or a acridane ring structure.

Preferably, at least one of Ar_{1'} to Ar_{3'} have additional one aryl or heterocyclic amine substituent, more preferably Ar_{1'} has an additional aryl amino substituent, at the case of that it is preferable that Ar_{1'} represents substituted or unsubstituted biphenylene group, substituted or unsubstituted fluorenylene group. Specific examples for the hole transport material are 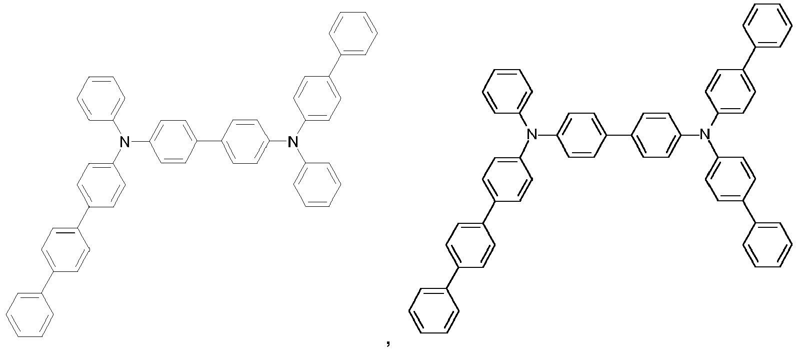 and 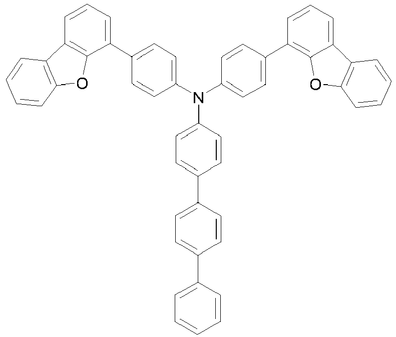 and the like.

A second hole transporting layer is preferably inserted between the first hole transporting layer and the emitting layer to enhance device performance by blocking excess electrons or excitons. Specific examples for second hole transporting layer are the same as for the first hole transporting layer. It is preferred that second hole transporting layer has higher triplet energy to block triplet excitons, especially for phosphorescent devices, such as bicarbazole compounds, biphenyl-amine compounds, triphenylenyl amine compounds, fluorenyl amine compounds, carbazole substituted arylamine compounds, dibenzofuran substituted arylamine compounds, and dibenzothiophene substituted arylamine compounds.

### (Emitting layer)

The emitting layer is a layer containing a substance having a high emitting property (emitter material or dopant material). As the dopant material, various materials can be used. For example, a fluorescent emitting compound (fluorescent dopant), a phosphorescent emitting compound (phosphorescent dopant) or the like can be used. A fluorescent emitting compound is a compound capable of emitting light from the singlet excited state, and an emitting layer containing a fluorescent emitting compound is called a fluorescent emitting layer. Further, a phosphorescent emitting compound is a compound capable of emitting light from the triplet excited state, and an emitting layer containing a phosphorescent emitting compound is called a phosphorescent emitting layer.

Preferably, the emitting layer in the organic EL device of the present application comprises a compound of formula (I) as a dopant material.

The emitting layer preferably comprises at least one dopant material and at least one host material that allows it to emit light efficiently. In some literatures, a dopant material is called a guest material, an emitter or an emitting material. In some literatures, a host material is called a matrix material.

A single emitting layer may comprise plural dopant materials and plural host materials. Further, plural emitting layers may be present.

In the present specification, a host material combined with the fluorescent dopant is referred to as a "fluorescent host" and a host material combined with the phosphorescent dopant is referred to as the "phosphorescent host". Note that the fluorescent host and the phosphorescent host are not classified only by the molecular structure. The phosphorescent host is a material for forming a phosphorescent emitting layer containing a phosphorescent dopant, but does not mean that it cannot be used as a material for forming a fluorescent emitting layer. The same can be applied to the fluorescent host.

In one embodiment, it is preferred that the emitting layer comprises the compound represented by formula (I) according to the present invention (hereinafter, these compounds may be referred to as the "compound (I)"). More preferably, it is contained as a dopant material. Further, it is preferred that the compound (I) be contained in the emitting layer as a fluorescent dopant. Even further, it is preferred that the compound (I) be contained in the emitting layer as a blue fluorescent dopant.

In one embodiment, no specific restrictions are imposed on the content of the compound (I) as the dopant material in the emitting layer. In respect of sufficient emission and concentration quenching, the content is preferably 0.5 to 70 mass%, more preferably 0.8 to 30 mass%, further preferably 1 to 30 mass%, still further preferably 1 to 20 mass%, and particularly preferably 1 to 10 mass%, further particularly preferably 1 to 5 mass%, even further particularly preferably 2 to 4 mass%, related to the mass of the emitting layer.

### (Fluorescent dopant)

As a fluorescent dopant other than the compound (I), a fused polycyclic aromatic compound, a styrylamine compound, a fused ring amine compound, a boron-containing compound, a pyrrole compound, an indole compound, a carbazole compound can be given, for example. Among these, a fused ring amine compound, a boron-containing compound, carbazole compound is preferable.

As the fused ring amine compound, a diaminopyrene compound, a diaminochrysene compound, a diaminoanthracene compound, a diaminofluorene compound, a diaminofluorene compound with which one or more benzofuro skeletons are fused, or the like can be given.

As the boron-containing compound, a pyrromethene compound, a triphenylborane compound or the like can be given.

As a blue fluorescent dopant, pyrene compounds, styrylamine compounds, chrysene compounds, fluoranthene compounds, fluorene compounds, diamine compounds, triarylamine compounds and the like can be given, for example. Specifically, N,N'-bis[4-(9H-carbazol-9-yl)phenyl]-N,N'-diphenylstilbene-4,4'-diamine (abbreviation: YGA2S), 4-(9H-carbazol-9-yl)-4'-(10-phenyl-9-anthryl)triphenyamine (abbreviation: YGAPA), 4-(10-phenyl-9-anthryl)-4'-(9-phenyl-9H-carbazole-3-yl)triphenylamine (abbreviation: PCBAPA) or the like can be given.

As a green fluorescent dopant, an aromatic amine compound or the like can be given, for example. Specifically, N-(9,10-diphenyl-2-anthryl)-N,9-diphenyl-9H-carbazole-3-amine (abbreviation: 2PCAPA), N-[9,10-bis(1,1'-biphenyl-2-yl)-2-anthryl]-N,9-diphenyl-9H-carbazole-3-amine (abbreviation: 2PCABPhA), N-(9,10-diphenyl-2-anthryl)-N,N',N'-triphenyl-1,4-phenylenediamine (abbreviation: 2DPAPA), N-[9,10-bis(1,1'-biphenyl-2-yl)-2-anthryl]-N,N',N'-triphenyl-1,4-phenylenediamine (abbreviation: 2DPABPhA), N-[9,10-bis(1,1'-biphenyl-2-yl)]-N-[4-(9H-carbazole-9-yl)phenyl]-N-phenylanthracene-2-amine (abbreviation: 2YGABPhA), N,N,9-triphenylanthracene-9-amine (abbreviation: DPhAPhA) or the like can be given, for example.

As a red fluorescent dopant, a tetracene compound, a diamine compound or the like can be given. Specifically, N,N,N',N'-tetrakis(4-methylphenyl)tetracene-5,11-diamine (abbreviation: p-mPhTD), 7,14-diphenyl-N,N,N',N'-tetrakis(4-methylphenyl)acenaphtho[1,2-a]fluoranthene-3,10-diamine (abbreviation: p-mPhAFD) or the like can be given.

### (Phosphorescent dopant)

As a phosphorescent dopant, a phosphorescent emitting heavy metal complex and a phosphorescent emitting rare earth metal complex can be given.

As the heavy metal complex, an iridium complex, an osmium complex, a platinum complex or the like can be given. The heavy metal complex is for example an ortho-metalated complex of a metal selected from iridium, osmium and platinum.

Examples of rare earth metal complexes include terbium complexes, europium complexes and the like. Specifically, tris(acetylacetonate)(monophenanthroline)terbium(III) (abbreviation: Tb(acac)₃(Phen)), tris(1,3-diphenyl-1,3-propandionate)(monophenanthroline)europium(III) (abbreviation: Eu(DBM)₃(Phen)), tris[1-(2-thenoyl)-3,3,3-trifluoroacetonate](monophenanthroli-ne)europium(III) (abbreviation: Eu(TTA)₃(Phen)) or the like can be given. These rare earth metal complexes are preferable as phosphorescent dopants since rare earth metal ions emit light due to electronic transition between different multiplicity.

As a blue phosphorescent dopant, an iridium complex, an osmium complex, a platinum complex, or the like can be given, for example. Specifically, bis[2-(4',6'-difluorophenyl)pyridinate-N,C2']iridium(III) tetrakis(1-pyrazolyl)borate (abbreviation: FIr6), bis[2-(4',6'-difluorophenyl) pyri-dinato-N,C2']iridium(III) picolinate (abbreviation: Ir(CF_{3ppy})₂(_{pic})), bis[2-(4',6'-difluorophenyl)pyr-idinato-N,C2']iridium(III) acetylacetonate (abbreviation: Flracac) or the like can be given.

As a green phosphorescent dopant, an iridium complex or the like can be given, for example. Specifically, tris(2-phenylpyridinato-N,C2') iridium(III) (abbreviation: Ir(ppy)₃), bis(1,2-diphenyl-1H-benzimidazolato)iridium(III) acetylacetonate (abbreviation: Ir(pbi)₂(acac)), bis(benzo[h]quino-linato)iridium(III) acetylacetonate (abbreviation: Ir(bzq)₂(acac)) or the like can be given.

As a red phosphorescent dopant, an iridium complex, a platinum complex, a terbium complex, a europium complex or the like can be given. Specifically, bis[2-(2'-benzo[4,5-α]thienyl)pyridinato-N,C3']iridium(III) acetylacetonate (abbreviation: Ir(btp)₂(acac)), bis(1-phenylisoquinolinato-N,C2')iridium(III) acetylacetonate (abbreviation: Ir(piq)₂(acac)), (acetylacetonato)bis[2,3-bis(4-fluorophenyl)quinoxalinato]iridium(III) (abbreviation: Ir(Fdpq)₂(acac)), 2,3,7,8,12,13,17,18-octaethyl-21H,23H-porphyrin platinum(II) (abbreviation PtOEP) or the like can be given.

As mentioned above, the emitting layer preferably comprises at least one compound (I) as a dopant.

### (Host material)

As host material, metal complexes such as aluminum complexes, beryllium complexes and zinc complexes; heterocyclic compounds such as indole compounds, pyridine compounds, pyrimidine compounds, triazine compounds, quinoline compounds, isoquinoline compounds, quinazoline compounds, dibenzofuran compounds, dibenzothiophene compounds, oxadiazole compounds, benzimidazole compounds, phenanthroline compounds; fused polyaromatic hydrocarbon (PAH) compounds such as a naphthalene compound, a triphenylene compound, a carbazole compound, an anthracene compound, a phenanthrene compound, a pyrene compound, a chrysene compound, a naphthacene compound, a fluoranthene compound; and aromatic amine compound such as triarylamine compounds and fused polycyclic aromatic amine compounds can be given, for example. Plural types of host materials can be used in combination.

As a fluorescent host, a compound having a higher singlet energy level than a fluorescent dopant is preferable. For example, a heterocyclic compound, a fused aromatic compound or the like can be given. As a fused aromatic compound, an anthracene compound, a pyrene compound, a chrysene compound, a naphthacene compound or the like are preferable. An anthracene compound is preferentially used as blue fluorescent host.

In the case that compound (I) is employed as at least one dopant material, preferred host materials are substituted or unsubstituted polyaromatic hydrocarbon (PAH) compounds, substituted or unsubstituted polyheteroaromatic compounds, substituted or unsubstituted anthracene compounds, or substituted or unsubstituted pyrene compounds, preferably substituted or unsubstituted anthracene compounds or substituted or unsubstituted pyrene compounds, more preferably substituted or unsubstituted anthracene compounds, most preferably anthracene compounds represented by formula (10), as mentioned above.

As a **phosphorescent host**, a compound having a higher triplet energy level as compared with a phosphorescent dopant is preferable. For example, a metal complex, a heterocyclic compound, a fused aromatic compound or the like can be given. Among these, an indole compound, a carbazole compound, a pyridine compound, a pyrimidine compound, a triazine compound, a quinolone compound, an isoquinoline compound, a quinazoline compound, a dibenzofuran compound, a dibenzothiophene compound, a naphthalene compound, a triphenylene compound, a phenanthrene compound, a fluoranthene compound or the like can be given.

### (Electron-transporting layer) / (Electron-injecting layer)

The electron-transporting layer is an organic layer that is formed between the emitting layer and the cathode and has a function of transporting electrons from the cathode to the emitting layer. When the electron-transporting layer is formed of plural layers, an organic layer or an inorganic layer that is nearer to the cathode is often defined as the electron injecting layer (see for example layer 8 in FIG. 1, wherein an electron injecting layer 8 and an electron transporting layer 7 form an electron injecting and transporting unit 11). The electron injecting layer has a function of injecting electrons from the cathode efficiently to the organic layer unit. Preferred electron injection materials are alkali metal, alkali metal compounds, alkali metal complexes, the alkaline earth metal complexes and the rare earth metal complexes.

According to one embodiment, it is preferred that the electron-transporting layer further comprises one or more layer(s) like a second electron-transporting layer, an electron injection layer to enhance efficiency and lifetime of the device, a hole blocking layer, an exciton blocking layer or a triplet blocking layer.

According to one embodiment, it is preferred that an electron-donating dopant be contained in the interfacial region between the cathode and the emitting unit. Due to such a configuration, the organic EL device can have an increased luminance or a long life. Here, the electron-donating dopant means one having a metal with a work function of 3.8 eV or less. As specific examples thereof, at least one selected from an alkali metal, an alkali metal complex, an alkali metal compound, an alkaline earth metal, an alkaline earth metal complex, an alkaline earth metal compound, a rare earth metal, a rare earth metal complex and a rare earth metal compound or the like can be mentioned.

As the alkali metal, Li (work function: 2.9 eV), Na (work function: 2.36 eV), K (work function: 2.28 eV), Rb (work function: 2.16 eV), Cs (work function: 1.95 eV) and the like can be given. One having a work function of 2.9 eV or less is particularly preferable. Among them, K, Rb and Cs are preferable. Rb or Cs is further preferable. Cs is most preferable. As the alkaline earth metal, Ca (work function: 2.9 eV), Sr (work function: 2.0 eV to 2.5 eV), Ba (work function: 2.52 eV) and the like can be given. One having a work function of 2.9 eV or less is particularly preferable. As the rare-earth metal, Sc, Y, Ce, Tb, Yb and the like can be given. One having a work function of 2.9 eV or less is particularly preferable.

Examples of the alkali metal compound include an alkali oxide such as Li₂O, Cs₂O or K₂O, and an alkali halide such as LiF, NaF, CsF and KF. Among them, LiF, Li₂O and NaF are preferable. Examples of the alkaline earth metal compound include BaO, SrO, CaO, and mixtures thereof such as BaₓSr₁₋ₓO (0<x<1) and BaₓCa₁₋ₓO (0<x<1). Among them, BaO, SrO and CaO are preferable. Examples of the rare earth metal compound include YbF₃, ScF₃, ScO₃, Y₂O₃, Ce₂O₃, GdF₃ and TbF₃. Among these, YbF₃, ScF₃ and TbF₃ are preferable.

The alkali metal complexes, the alkaline earth metal complexes and the rare earth metal complexes are not particularly limited as long as they contain, as a metal ion, at least one of alkali metal ions, alkaline earth metal ions, and rare earth metal ions. Meanwhile, preferred examples of the ligand include, but are not limited to, quinolinol, benzoquinolinol, acridinol, phenanthridi-nol, hydroxyphenyloxazole, hydroxyphenylthiazole, hydroxydiaryloxadiazole, hydroxydiarylthi-adiazole, hydroxyphenylpyridine, hydroxyphenylbenzimidazole, hydroxybenzotriazole, hydroxy-fluborane, bipyridyl, phenanthroline, phthalocyanine, porphyrin, cyclopentadiene, β-diketones, and azomethines.

Regarding the addition form of the electron-donating dopant, it is preferred that the electron-donating dopant be formed in a shape of a layer or an island in the interfacial region. A preferred method for the formation is a method in which an organic compound (a light emitting material or an electron-injecting material) for forming the interfacial region is deposited simultaneously with deposition of the electron-donating dopant by a resistant heating deposition method, thereby dispersing the electron-donating dopant in the organic compound.

In a case where the electron-donating dopant is formed into the shape of a layer, the light-emitting material or electron-injecting material which serves as an organic layer in the interface is formed into the shape of a layer. After that, a reductive dopant is solely deposited by the resistant heating deposition method to form a layer preferably having a thickness of from 0.1 nm to 15 nm. In a case where the electron-donating dopant is formed into the shape of an island, the emitting material or the electron-injecting material which serves as an organic layer in the interface is formed into the shape of an island. After that, the electron-donating dopant is solely deposited by the resistant heating deposition method to form an island preferably having a thickness of from 0.05 nm to 1 nm. As the electron-transporting material used in the electron-transporting layer other than a compound of the formula (I), an aromatic heterocyclic compound having one or more hetero atoms in the molecule may preferably be used. In particular, a nitrogen-containing heterocyclic compound is preferable.

According to one embodiment, it is preferable that the electron-transporting layer comprises a nitrogen-containing heterocyclic metal chelate.

According to the other embodiment, it is preferable that the electron-transporting layer comprises a substituted or unsubstituted nitrogen containing heterocyclic compound. Specific examples of preferred heterocyclic compounds for the electron-transporting layer are, 6-membered azine compounds; such as pyridine compounds, pyrimidine compounds, triazine compounds, pyrazine compounds, preferably pyrimidine compounds or triazine compounds; 6-membered fused azine compounds, such as quinolone compounds, isoquinoline compounds, quinoxaline compounds, quinazoline compounds, phenanthroline compounds, benzoquinoline compounds, benzoisoquinoline compounds, dibenzoquinoxaline compounds, preferably quinolone compounds, isoquinoline compounds, phenanthroline compounds; 5-membered heterocyclic compounds, such as imidazole compounds, oxazole compounds, oxadiazole compounds, triazole compounds, thiazole compounds, thiadiazole compounds; fused imidazole compounds, such as benzimidazole compounds, imidazopyridine compounds, naphthoimidazole compounds, benzimidazophenanthridine compounds, benzimidzobenzimidazole compounds, preferably benzimidazole compounds, imidazopyridine compounds or benzimidazophenanthridine compounds.

According to another embodiment, it is preferable the electron-transporting layer comprises a phosphine oxide compound represented as Arₚ₁Arₚ₂Ar_{P3}P=O.

Arₚ₁ to Arₚ₃ are the substituents of phosphor atom and each independently represent substituted or unsubstituted above mentioned aryl group or substituted or unsubstituted above mentioned heterocyclic group.

According to another embodiment, it is preferable that the electron-transporting layer comprises aromatic hydrocarbon compounds. Specific examples of preferred aromatic hydrocarbon compounds for the electron-transporting layer are, oligo-phenylene compounds, naphthalene compounds, fluorene compounds, fluoranthenyl group, anthracene compounds, phenanthrene compounds, pyrene compounds, triphenylene compounds, benzanthracene compounds, chrysene compounds, benzphenanthrene compounds, naphthacene compounds, and benzochrysene compounds, preferably anthracene compounds, pyrene compounds and fluoranthene compounds.

### (Cathode)

For the cathode, a metal, an alloy, an electrically conductive compound, and a mixture thereof, each having a small work function (specifically, a work function of 3.8 eV or less) are preferably used. Specific examples of a material for the cathode include an alkali metal such as lithium and cesium; an alkaline earth metal such as magnesium, calcium, and strontium; aluminum, an alloy containing these metals (for example, magnesium-silver, aluminum-lithium); a rare earth metal such as europium and ytterbium; and an alloy containing a rare earth metal.

The cathode is usually formed by a vacuum vapor deposition or a sputtering method. Further, in the case of using a silver paste or the like, a coating method, an inkjet method, or the like can be employed.

Moreover, various electrically conductive materials such as silver, ITO, graphene, indium oxide-tin oxide containing silicon or silicon oxide, selected independently from the work function, can be used to form a cathode. These electrically conductive materials are made into films using a sputtering method, an inkjet method, a spin coating method, or the like.

### (Insulating layer)

In the organic EL device, pixel defects based on leakage or a short circuit are easily generated since an electric field is applied to a thin film. In order to prevent this, it is preferred to insert an insulating thin layer between a pair of electrodes. Examples of materials used in the insulating layer include aluminum oxide, lithium fluoride, lithium oxide, cesium fluoride, cesium oxide, magnesium oxide, magnesium fluoride, calcium oxide, calcium fluoride, aluminum nitride, titanium oxide, silicon oxide, germanium oxide, silicon nitride, boron nitride, molybdenum oxide, ruthenium oxide, and vanadium oxide. A mixture thereof may be used in the insulating layer, and a laminate of a plurality of layers that include these materials can be also used for the insulating layer.

### (Spacing layer)

A spacing layer is a layer provided between a fluorescent emitting layer and a phosphorescent emitting layer when a fluorescent emitting layer and a phosphorescent emitting layer are stacked in order to prevent diffusion of excitons generated in the phosphorescent emitting layer to the fluorescent emitting layer or in order to adjust the carrier balance. Further, the spacing layer can be provided between the plural phosphorescent emitting layers.

Since the spacing layer is provided between the emitting layers, the material used for the spacing layer is preferably a material having both electron-transporting capability and hole-transporting capability. In order to prevent diffusion of the triplet energy in adjacent phosphorescent emitting layers, it is preferred that the spacing layer have a triplet energy of 2.6 eV or more. As the material used for the spacing layer, the same materials as those used in the above-mentioned hole-transporting layer can be given.

### (Electron-blocking layer, hole-blocking layer, exciton-blocking layer)

An electron-blocking layer, a hole-blocking layer, an exciton (triplet)-blocking layer, and the like may be provided in adjacent to the emitting layer.

The electron-blocking layer has a function of preventing leakage of electrons from the emitting layer to the hole-transporting layer. The hole-blocking layer has a function of preventing leakage of holes from the emitting layer to the electron-transporting layer. In order to improve hole blocking capability, a material having a deep HOMO level is preferably used. The exciton-blocking layer has a function of preventing diffusion of excitons generated in the emitting layer to the adjacent layers and confining the excitons within the emitting layer. In order to improve triplet block capability, a material having a high triplet level is preferably used.

### (Method for forming a layer)

The method for forming each layer of the organic EL device of the invention is not particularly limited unless otherwise specified. A known film-forming method such as a dry film-forming method, a wet film-forming method or the like can be used. Specific examples of the dry film-forming method include a vacuum deposition method, a sputtering method, a plasma method, an ion plating method, and the like. Specific examples of the wet film-forming method include various coating methods such as a spin coating method, a dipping method, a flow coating method, an inkjet method, and the like.

### (Film thickness)

The film thickness of each layer of the organic EL device of the invention is not particularly limited unless otherwise specified. If the film thickness is too small, defects such as pinholes are likely to occur to make it difficult to obtain a sufficient luminance. If the film thickness is too large, a high driving voltage is required to be applied, leading to a lowering in efficiency. In this respect, the film thickness is preferably 0.1 nm to 10 µm, and more preferably 5 nm to 0.2 µm.

### (Electronic apparatus (electronic equipment))

The present invention further relates to an electronic equipment (electronic apparatus) comprising the organic electroluminescence device according to the present application. Examples of the electronic apparatus include display parts such as an organic EL panel module; display devices of television sets, mobile phones, smart phones, and personal computer, and the like; and emitting devices of a lighting device and a vehicle lighting device.

### EXAMPLES

Next, the invention will be explained in more detail in accordance with the following synthesis examples, examples, and comparative examples, which should not be construed as limiting the scope of the invention.

The percentages and ratios mentioned in the examples below - unless stated otherwise - are % by weight and weight ratios.

### I Synthesis Examples

All experiments are carried out in protective gas atmosphere.

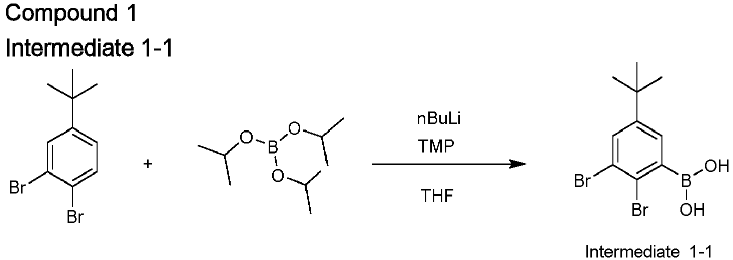

42.0 mL (249.0 mmol) of 2,2,6,6-tetramethylpiperidine (TMP) was dissolved in 250 mL of THF, and the solution was cooled to -78 °C before 100 mL (250 mmol) of 2.5M n-butyllithium in hexane was added dropwise via a cannula for 30 min. The solution was stirred at -78 °C for 30 min. 67.0 mL (290.5 mmol) of triisopropyl borate was added slowly within 30 min, and the mixture was stirred at -78 °C for 1 hour before a solution of 24.24 g (83.0 mmol) of 1,2-dibromo-4-(*tert-*butyl)benzene in 50 mL of THF was added dropwise within 45 min at -78 °C. Then, the mixture was warmed to room temperature overnight. The reaction mixture was poured into 300 mL of ice-cold 1 N HCI, and the aqueous layer was extracted with ethyl acetate. The organic layer was washed with brine, dried over magnesium sulfate, filtered and concentrated. The crude product was used for the next reaction without purification.

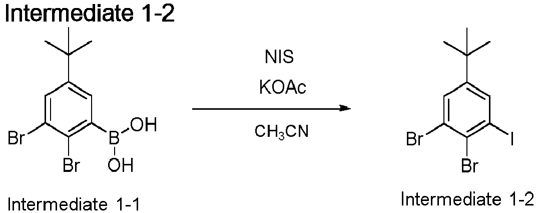

27.86 g (82.96 mmol) of Intermediate 1-1 and 1.63 g (16.59 mmol) of potassium acetate were suspended in 332 mL of acetonitrile. Then, 22.4 g (99.55 mmol) of N-iodosuccinimide was added to the suspension at room temperature, and the mixture was stirred overnight. The reaction mixture was quenched with 300 mL of 10% sodium sulfite. The aqueous layer was extracted with toluene, and the organic layer was washed with brine, dried over magnesium sulfate, filtered and concentrated. The crude product was purified by silica-gel column chromatography using heptane as eluent to give 22.1g (61% yield) of Intermediate 1-2 as a white solid.

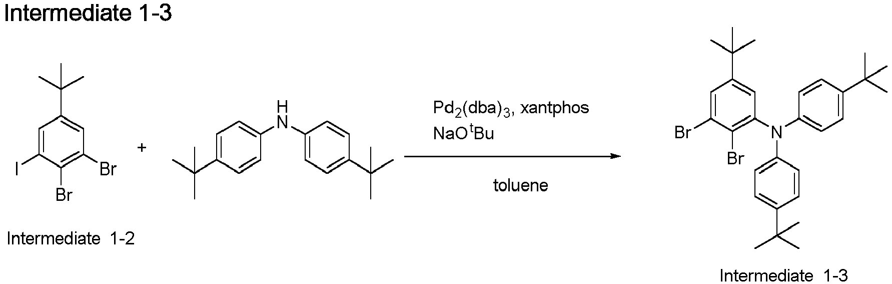

12.41 g (29.70 mmol) of Intermediate 1-2, 7.96 g (28.28 mmol) of bis(4-(*tert*-butyl)phenylamine, and 3.81 g (39.60 mmol) of sodium *tert*-butoxide were added to 190mL of toluene. The suspension was degassed using 3 freeze-pump-thaw cycles, and 777mg (0.85 mmol) of tris(dibenzylideneacetone)dipalladium(0) and 982 mg (1.70 mmol) of xantphos were added to the reaction mixture. After two additional freeze-pump-thaw cycles, the reaction mixture was heated to 90 °C for 19 hours. The reaction was cooled to room temperature and diluted with toluene. The organic extracts were washed with water and dried over magnesium sulfate, filtered, and the solution was concentrated. The residue was purified by silica-gel column chromatography using cyclohexane as eluent to give 8.62g (53% yield) of Intermediate 1-3 as a white solid. LC-MS: 572 [M+H]

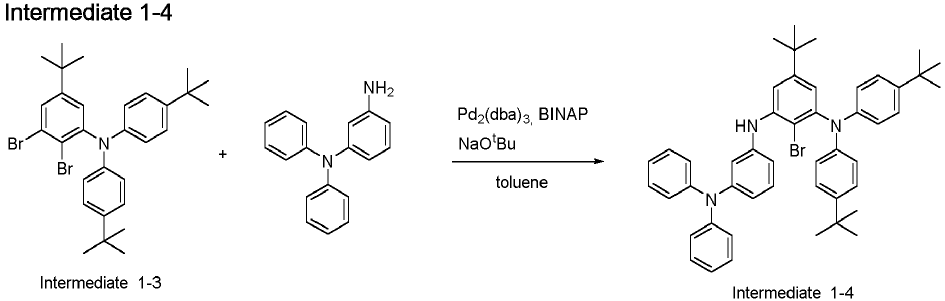

9.5 g (16.62 mmol) of Intermediate 1-3, 4.54 g (17.46 mmol) of *N¹*,*N¹*-diphenyl-1 ,3-benzenedia-mine, and 4.12 g (41.6 mmol) of sodium *tert-*butoxide were added to 190mL of toluene. The suspension was degassed using 3 freeze-pump-thaw cycles, and 156 mg (0.17 mmol) of tris(dibenzylideneacetone)dipalladium(0) and 423 mg (0.67 mmol) of BINAP were added to the reaction mixture. After two additional freeze-pump-thaw cycles, the reaction mixture was heated to 90 °C for 2 hours. The reaction was cooled to room temperature and diluted with toluene. The organic extracts were washed with water and dried over magnesium sulfate, filtered, and the solution was concentrated. The residue was purified by silica-gel column chromatography using a mixed solvent of heptane and dichloromethane as eluent to give 11.8 g (95% yield) of Intermediate 1-4 as a white foam.

LC-MS: 750 [M+H]

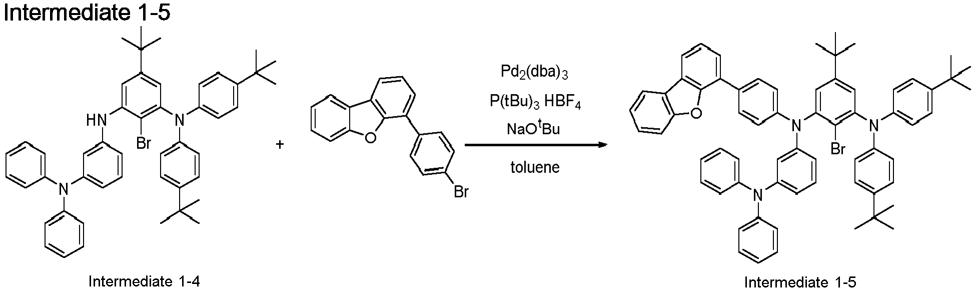

5.40 g (7.19 mmol) of Intermediate 1-4, 2.56 g (7.91 mmol) of 4-(4'-bromophenyl)dibenzofuran, and 0.97 g (10.1 mmol) of sodium *tert-*butoxide were added to 72 mL of toluene. The suspension was degassed using 3 freeze-pump-thaw cycles, and 66 mg (0.07 mmol) of tris(dibenzylideneacetone)dipalladium(0) and 83 mg (0.29 mmol) of tri-*tert*-butylphosphonium tertrafluorobo-rate were added to the reaction mixture. After two additional freeze-pump-thaw cycles, the reaction mixture was heated to 80 °C for 2 hours. The reaction was cooled to room temperature and diluted with toluene. The organic extracts were washed with water and dried over magnesium sulfate, filtered, and the solution was concentrated. The residue was purified by silica-gel column chromatography using a mixed solvent of heptane and dichloromethane as eluent to give 7.83g (91% yield) of Intermediate 1-5 as a white solid.

LC-MS: 994 [M+H]

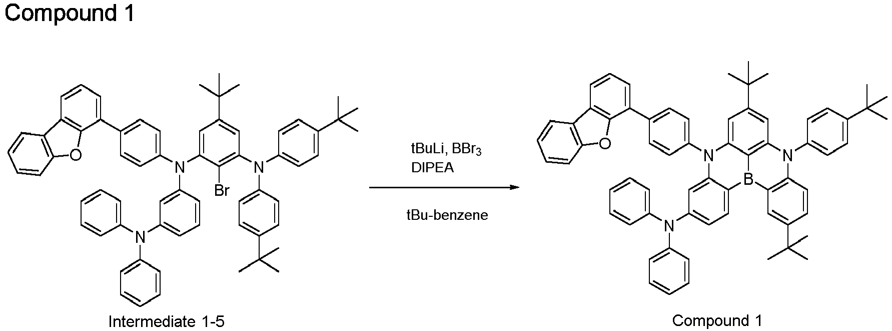

6.72 g (6.43 mmol) of Intermediate 1-5 was added to 86 mL of *tert*-butylbenzene, and the solution was bubbled with argon. 6.77 mL of 1.9 M tert-butyllithium in pentane was added dropwise to the solution at 0 °C, and the reaction mixture was stirred at 0 °C for 1 hour. Then the reaction mixture was warmed to room temperature, and it was stirred for 2 hours. The reaction mixture was cooled at -30 °C, and 1.22 mL (12.86 mmol) of boron tribromide was added, then the reaction mixture was stirred for 45 min. After the reaction mixture was warmed to 0 °C, 2.35 mL (13.5 mmol) of N-ethyl-N-isopropylpropan-2-amine was added, and then the mixture was heated to 145 °C. After 45 min, the reaction mixture was cooled at room temperature, and quenched with 10% sodium acetate aqueous solution. The mixture was diluted with ethyl acetate, and the aqueous layer was extracted with ethyl acetate. The organic layer was washed with water and brine, and dried over magnesium sulfate. It was filtered and concentrated. The residue was purified by silica-gel column chromatography using a mixed solvent of heptane and dichloromethane as eluent to give 1.13g (19% yield) of Compound 1 as a yellow powder. LC-MS: 923 [M+H]

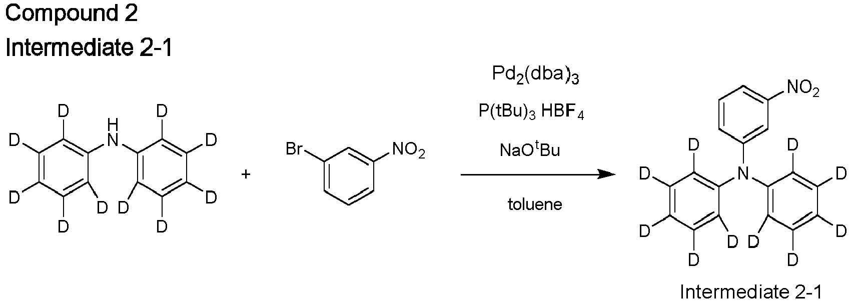

8.02 g (44.5 mmol) of diphenyl amine-*d*₁₀, 9.44 g (46.7 mmol) of 1-bromo-3-nitrobenzene, and 5.99 g (62.3 mmol) of sodium *tert-*butoxide were added to 220mL of toluene. The suspension was degassed using 3 freeze-pump-thaw cycles, and 815 mg (0.89 mmol) of tris(dibenzylideneacetone)dipalladium(0) and 1.03 g (3.56 mmol) of tri-*tert*-butylphosphonium tertrafluorobo-rate were added to the reaction mixture. After two additional freeze-pump-thaw cycles, the reaction mixture was heated to 90 °C for 1.5 hours. The reaction was cooled to room temperature and diluted with toluene. The organic extracts were washed with water and dried over magnesium sulfate, filtered, and the solution was concentrated. The residue was purified by silica-gel column chromatography using a mixed solvent of heptane and toluene as eluent to give 11.0 g (79% yield) of Intermediate 2-1 as an orange solid.

LC-MS: 301 [M+H]

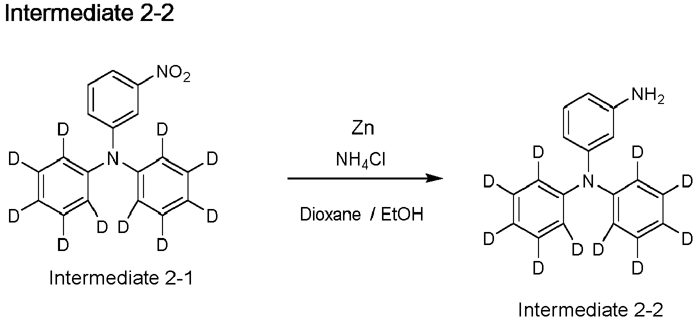

11.0 g (36. 6 mmol) of Intermediate 2-1 and 14.66 g (274 mmol) of ammonium chloride were suspended in 274 mL of dioxane and 91 mL of ethanol. The mixture was stirred at 80 °C for 3 h. After the mixture was cooled at room temperature it was filtrated through a pad of Celite and washed with ethyl acetate and then concentrated. The residue was purified by silica-gel column chromatography using a mixed solvent of heptane and ethyl acetate as eluent to give 7.7 g (77% yield) of Intermediate 2-2 as an orange solid.

LC-MS: 271 [M+H]

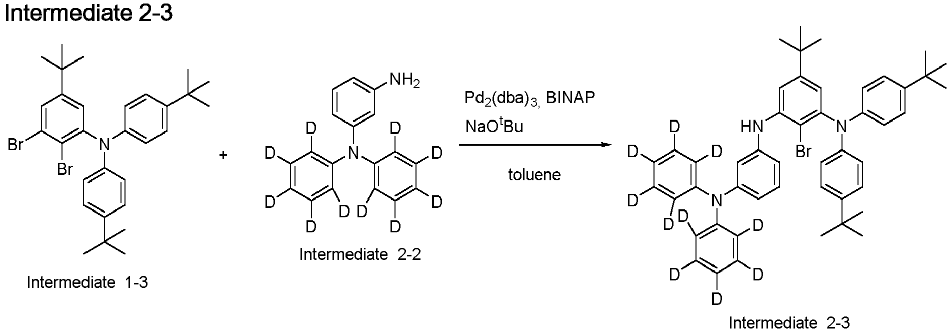

10.0 g (17.50 mmol) of Intermediate 1-3, 4.97 g (18.37 mmol) of Intermediate 2-2, and 3.36 g (35.0 mmol) of sodium *tert-*butoxide were added to 190mL of toluene. The suspension was degassed using 3 freeze-pump-thaw cycles, and 240 mg (0.26 mmol) of tris(dibenzylideneacetone)dipalladium(0) and 327 mg (0.53 mmol) of BINAP were added to the reaction mixture. After two additional freeze-pump-thaw cycles, the reaction mixture was heated to 90 °C for 2 hours. The reaction was cooled to room temperature and diluted with toluene. The organic extracts were washed with water and dried over magnesium sulfate, filtered, and the solution was concentrated. The residue was purified by silica-gel column chromatography using a mixed solvent of cyclohexane and toluene as eluent to give 14.0 g (99% yield) of Intermediate 2-3 as a white foam.

LC-MS: 762 [M+H]

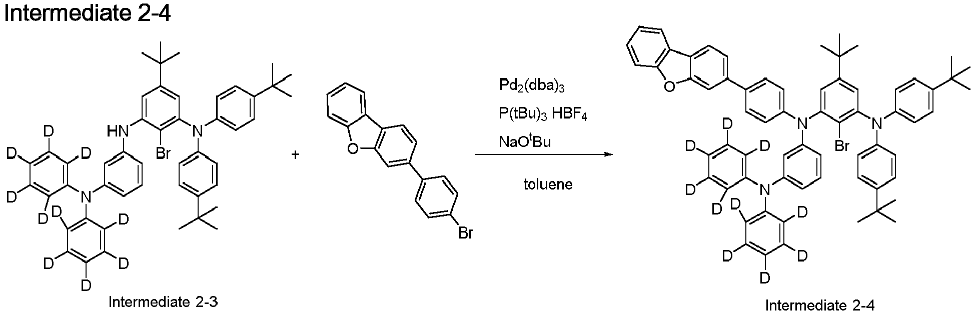

5.47 g (7.19 mmol) of Intermediate 2-3, 2.56 g (7.91 mmol) of 3-(4-bromophenyl)dibenzofuran, and 0.97 g (10.1 mmol) of sodium *tert-*butoxide were added to 72 mL of toluene. The suspension was degassed using 3 freeze-pump-thaw cycles, and 66 mg (0.07 mmol) of tris(dibenzylideneacetone)dipalladium(0) and 83 mg (0.29 mmol) of tri-*tert*-butylphosphonium tertrafluorobo-rate were added to the reaction mixture. After two additional freeze-pump-thaw cycles, the reaction mixture was heated to 80 °C for 2 hours. The reaction was cooled to room temperature and diluted with toluene. The organic extracts were washed with water and dried over magnesium sulfate, filtered, and the solution was concentrated. The residue was purified by silica-gel column chromatography using a mixed solvent of heptane and dichloromethane as eluent to give 6.56g (91 % yield) of Intermediate 2-4 as a white solid.

LC-MS: 1004 [M+H]

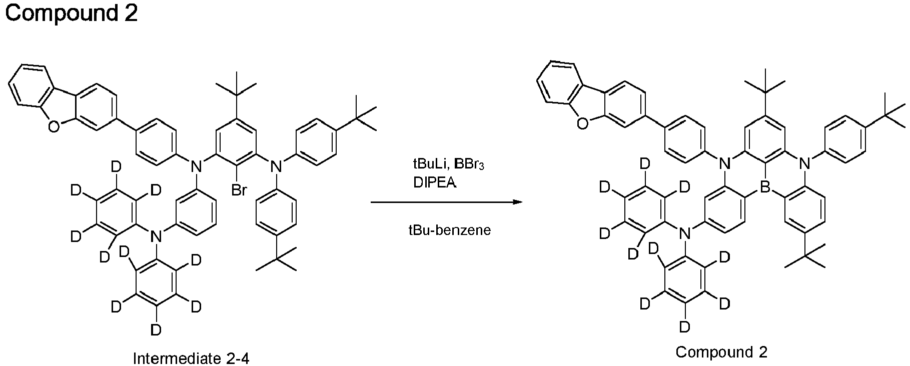

6.45 g (6.43 mmol) of Intermediate 2-4 was added to 86 mL of *tert*-butylbenzene, and the solution was bubbled with argon. 6.77 mL of 1.9 M tert-butyllithium in pentane was added dropwise to the solution at 0 °C, and the reaction mixture was stirred at 0 °C for 1 hour. Then the reaction mixture was warmed to room temperature, and it was stirred for 2 hours. The reaction mixture was cooled at -30 °C, and 1.22 mL (12.86 mmol) of boron tribromide was added, then the reaction mixture was stirred for 45 min. After the reaction mixture was warmed to 0 °C, 2.35 mL (13.5 mmol) of N-ethyl-N-isopropylpropan-2-amine was added, and then the mixture was heated to 145 °C. After 45 min, the reaction mixture was cooled at room temperature, and quenched with 10% sodium acetate aqueous solution. The mixture was diluted with ethyl acetate, and the aqueous layer was extracted with ethyl acetate. The organic layer was washed with water and brine, and dried over magnesium sulfate. It was filtered and concentrated. The residue was purified by silica-gel column chromatography using a mixed solvent of heptane and dichloromethane as eluent to give 684 mg (11% yield) of Compound 2 as a yellow powder.

### Device (invented compound as emitter dopant)

### Preparation and Evaluation of Organic EL Devices

The organic EL devices were prepared and evaluated as follows:

### Application Example 1

A glass substrate with 130 nm-thick indium-tin-oxide (ITO) transparent electrode (manufactured by Geomatec Co., Ltd.) used as an anode was first treated with N2 plasma for 100 sec. This treatment also improved the hole injection properties of the ITO. The cleaned substrate was mounted on a substrate holder and loaded into a vacuum chamber. Thereafter, the organic materials specified below were applied by vapour deposition to the ITO substrate at a rate of approx. 0.2-1 Å/sec at about 10⁻⁶ -10⁻⁸ mbar. As a hole injection layer, 10 nm-thick mixture of Compound HT-1 and 3% by weight of compound HI was applied. Then 80 nm-thick of compound HT-1 and 10 nm of Compound HT-2 were applied as hole-transporting layer 1 and hole-transporting layer 2, respectively. Subsequently, a mixture of 2% by weight of an emitter Compound 1 and 98% by weight of host Compound BH-1 was applied to form a 25 nm-thick fluorescent emitting layer. On the emitting layer, 10 nm-thick Compound ET-1 was applied as an hole-blocking layer and 15 nm of Compound ET-2 as electron-transporting layer. Finally, 1 nm-thick LiF was deposited as an electron-injection layer and 80 nm-thick Al was then deposited as a cathode to complete the device. The device was sealed with a glass lid and a getter in an inert nitrogen atmosphere with less than 1 ppm of water and oxygen. To characterize the OLED, electroluminescence (EL) spectra were recorded at various currents and voltages. EL peak maximum and Full Width at Half Maximum (FWHM) were recorded at 10 mA/cm2. In addition, the current-voltage characteristic were measured in combination with the luminance to determine luminous efficiency and external quantum efficiency (EQE). Driving voltage (Voltage) was given at a current density of 10mA/cm². The device result is shown in Table 1.

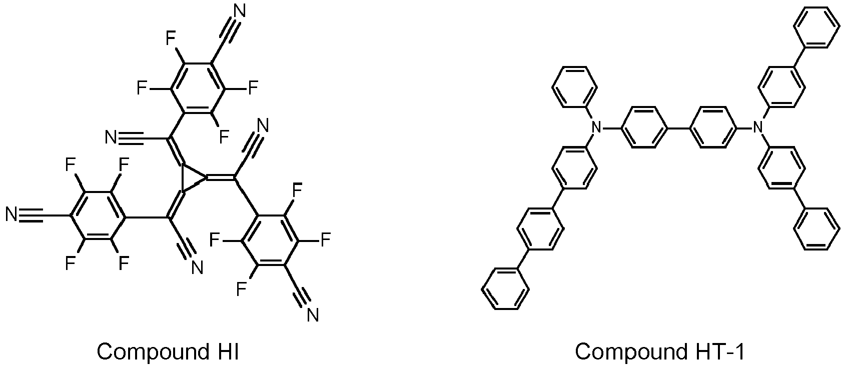

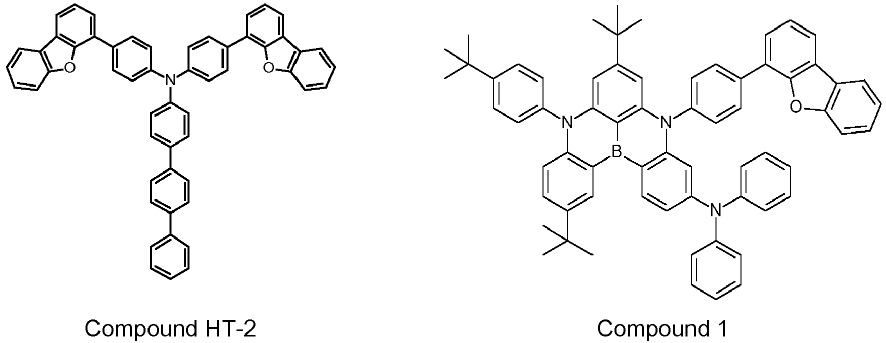

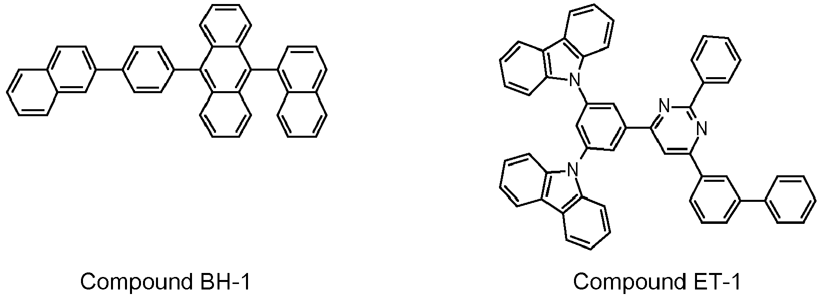

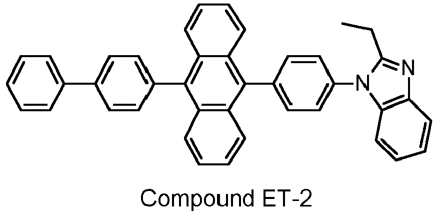

### Application Example 2

Application example 1 was repeated, except Compounds 2 was used instead of Compound 1 as emitter in fluorescent emitting layer. The device result is shown in Table 1.

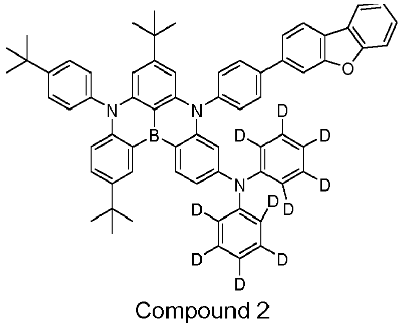

**Table 1**

| Appl. Ex. | Voltage, V | EQE, % | EL max, nm | FWHM, nm |
|---|---|---|---|---|
| Appl. Ex. 1 | 3.63 | 10.0 | 461 | 24.1 |
| Appl. Ex 2 | 3.63 | 10.3 | 461 | 24.1 |

These results demonstrate that the Application Example 1 and 2 give good EQE and narrow spectrum (smaller FWHM), i.e good colour purity when used as fluorescent emitting material in OLED.

## Claims

1. A compound represented by formula (I) 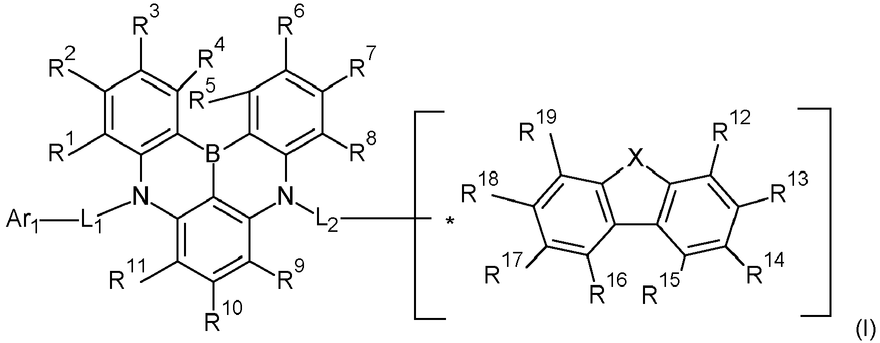 wherein
R¹, R², R³, R⁴, R⁵, R⁶, R⁷, R⁸, R⁹, R¹⁰ and R¹¹ each independently represents hydrogen; an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; NO₂; OR²⁰; SR²¹; C(=O)R²²; COOR²³; SiR²⁴R²⁵R²⁶; NR⁸⁴R⁸⁵, or halogen; preferably hydrogen; an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; CN; NO₂; OR²⁰; SR²¹; C(=O)R²²; COOR²³; SiR²⁴R²⁵R²⁶; NR⁸⁴R⁸⁵, or halogen;
or
two adjacent residues together form a ring structure which is unsubstituted or substituted; wherein at least one of R¹, R², R³, R⁴, R⁵, R⁶, R⁷, R⁸, R⁹ and R¹¹, preferably at least one of R¹, R², R³, R⁴, R⁵, R⁶, R⁷ and R⁸, represents an amino group NR⁸⁴R⁸⁵;
R⁸⁴ and R⁸⁵ each independently represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;
R¹², R¹³, R¹⁴, R¹⁵, R¹⁶, R¹⁷, R¹⁸ and R¹⁹ each independently represents hydrogen; an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; NO₂; OR²⁰; SR²¹; C(=O)R²²; COOR²³; SiR²⁴R²⁵R²⁶; NR⁸⁴R⁸⁵, or halogen;
or
two adjacent residues together form a ring structure which is unsubstituted or substituted:
wherein one of R¹², R¹³, R¹⁴, R¹⁵, R¹⁶, R¹⁷, R¹⁸ and R¹⁹ is a bonding site to L₂;
X is O or S;
L₁ represents a direct bond, an unsubstituted or substituted divalent aromatic hydrocarbon group containing 6 to 30 ring atoms, an unsubstituted or substituted divalent alkyl group having 1 to 20 carbon atoms or an unsubstituted or substituted divalent heteroaromatic group containing 3 to 30 ring atoms;
L₂ represents an unsubstituted or substituted divalent aromatic hydrocarbon group containing 6 to 30 ring atoms, an unsubstituted or substituted divalent alkyl group having 1 to 20 carbon atoms or an unsubstituted or substituted divalent heteroaromatic group containing 3 to 30 ring atoms;
Ar₁ represents an aryl group having from 6 to 60 ring carbon atoms which is unsubstituted or substituted; a heteroaryl group having from 5 to 60 ring atoms which is unsubstituted or
substituted or an alkyl group having from 1 to 20 carbon atoms which is unsubstituted or
substituted;
R²⁰, R²¹, R²² and R²³ each independently represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted;
R²⁴, R²⁵ and R²⁶ each independently represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted or a cycloalkyl group having from 3 to 20 ring carbon atoms which is unsubstituted or substituted.

2. The compound according to claim 1, wherein the amino group NR⁸⁴R⁸⁵ is represented by the following formula NAr₂Ar₃,
wherein
Ar₂ and Ar₃ each independently represents an aryl group having from 6 to 60 ring carbon atoms which is unsubstituted or substituted; a heteroaryl group having from 5 to 60 ring atoms which is unsubstituted or substituted.

3. The compound according to claim 1, wherein at least one of R² and R⁷ represents an amino group NR⁸⁴R⁸⁵, preferably R² and/or R⁷ represent an amino group NR⁸⁴R⁸⁵ and the remaining residues do not represent an amino group NR⁸⁴R⁸⁵.

4. The compound according to claim 2 or 3, wherein the amino group is represented by the following formula NAr₂Ar₃,
wherein
Ar₂ and Ar₃ each independently represents an aryl group having from 6 to 18 ring carbon atoms which is unsubstituted or substituted; a heteroaryl group having from 5 to 18 ring atoms which is unsubstituted or substituted, preferably 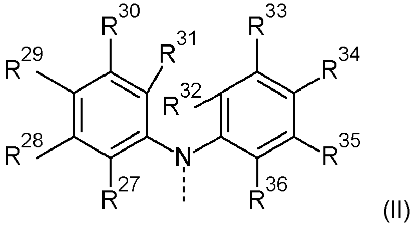 wherein
R²⁷, R²⁸, R²⁹, R³⁰, R³¹, R³², R³³, R³⁴, R³⁵ and R³⁶ each independently represents hydrogen, an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted, or halogen, SiR²⁴R²⁵R²⁶ or CN; or
two adjacent residues R²⁷, R28, R²⁹, R³⁰ and R³¹ and/or two adjacent residues R³², R³³, R³⁴, R³⁵ and R³⁶ together form a ring structure which is unsubstituted or substituted, preferably
R²⁷, R²⁸, R²⁹, R³⁰, R³¹, R³², R³³, R³⁴, R³⁵ and R³⁶ each independently represents hydrogen, an aryl group having from 6 to 10 ring carbon atoms which is unsubstituted or substituted, or
two adjacent residues R²⁷, R²⁸, R²⁹, R³⁰ and R³¹ and/or two adjacent residues R³², R³³, R³⁴, R³⁵ and R³⁶ together form a ring structure of the following formula (A) 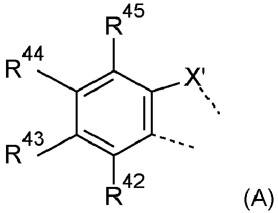 wherein
X' represents O, S or CR⁶⁸R^{69,} NR⁸⁶;
R⁴², R⁴³, R⁴⁴ and R⁴⁵ each independently represents hydrogen, an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted, halogen, SiR²⁴R²⁵R²⁶ or CN; or
two adjacent residues together form a ring structure which is unsubstituted or substituted, wherein the dotted lines are bonding sites;
R⁶⁸ and R⁶⁹ each independently represents hydrogen; an aryl group having from 6 to 60 ring carbon atoms which is unsubstituted or substituted; a heteroaryl group having from 5 to 60 ring atoms which is unsubstituted or substituted or an alkyl group having from 1 to 20 carbon atoms which is unsubstituted or substituted;
or
R⁶⁸ and R⁶⁹ together form an aromatic ring structure having from 3 to 13 ring atoms which is unsubstituted or substituted or an aliphatic ring structure having from 3 to 9 ring atoms which is unsubstituted or substituted;
R⁸⁶ represents an aryl group having from 6 to 60 ring carbon atoms which is unsubstituted or substituted; a heteroaryl group having from 5 to 60 ring atoms which is unsubstituted or substituted.

5. The compound according to any one of claims 1 to 4, wherein L₁ is a direct bond.

6. The compound according to any one of claims 1 to 5, wherein Ar₁ represents an aryl group having from 6 to 60 ring carbon atoms which is unsubstituted or substituted, preferably 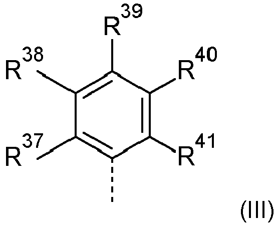 wherein
R37, R³⁸, R³⁹, R⁴⁰ and R⁴¹ each independently represents hydrogen, an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted, halogen, SiR²⁴R²⁵R²⁶ or CN,
or
two adjacent residues together form a ring structure which is unsubstituted or substituted, wherein the dotted line is a bonding site;
more preferably 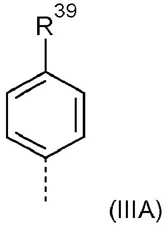 wherein
R³⁹ represents hydrogen, an aryl group having from 6 to 60 ring carbon atoms which is unsubstituted or substituted; a heteroaryl group having from 5 to 60 ring atoms which is unsubstituted or substituted or an alkyl group having from 1 to 20 carbon atoms which is unsubstituted or substituted, halogen, SiR²⁴R²⁵R²⁶ or CN;
wherein the dotted line is a bonding site.

7. The compound according to any one of claims 1 to 6, wherein L₂ represents an unsubstituted or substituted divalent aromatic hydrocarbon group containing 6 to 30 ring atoms, preferably an unsubstituted or substituted phenylene group, more preferably an unsubstituted phenylene group.

8. The compound according to any one of claims 1 to 7, wherein
0, 1, 2, 3 or 4 of R¹, R², R³, R⁴, R⁵, R⁶, R⁷, R⁸, R⁹, R¹⁰ and R¹¹ each independently represents an aryl group having from 6 to 60 ring carbon atoms which is unsubstituted or substituted; a heteroaryl group having from 5 to 60 ring atoms which is unsubstituted or substituted; an aralkyl group having from 7 to 60 carbon atoms which is unsubstituted or substituted; an alkyl group having from 1 to 20 carbon atoms which is unsubstituted or substituted; an alkylhalide group having from 1 to 20 carbon atoms which is unsubstituted or substituted; an alkenyl group having from 2 to 20 carbon atoms which is unsubstituted or substituted; an alkynyl group having from 2 to 20 carbon atoms which is unsubstituted or substituted; a cycloalkyl group having from 3 to 20 ring carbon atoms which is unsubstituted or substituted; CN; NO₂; OR²⁰; SR²⁰; C(=O)R²¹; COOR²²; SiR²⁴R²⁵R²⁶ or halogen; or
two adjacent residues together form a ring structure which is unsubstituted or substituted,
and the remaining residues of R¹, R², R³, R⁴, R⁵, R⁶, R⁷, R⁸, R⁹, R¹⁰ and R¹¹ are hydrogen; wherein at least one of R¹, R², R³, R⁴, R⁵, R⁶, R⁷, R⁸, R⁹ and R¹¹, preferably at least one of R¹, R², R³, R⁴, R⁵, R⁶, R⁷ and R⁸, more preferably R² and/or R⁷ represents an amino group NR⁸⁴R⁸⁵;
preferably 0, 1, 2, 3 or 4 of R¹, R², R³, R⁴, R⁵, R⁶, R⁷, R⁸, R⁹, R¹⁰ and R¹¹ each independently represents an aryl group having from 6 to 60 ring carbon atoms which is unsubstituted or substituted; a heteroaryl group having from 5 to 60 ring atoms which is unsubstituted or substituted; an alkyl group having from 1 to 20 carbon atoms which is unsubstituted or substituted,
or
two adjacent residues together form a ring structure which is unsubstituted or substituted, and the remaining residues of R¹, R², R³, R⁴, R⁵, R⁶, R⁷, R⁸, R⁹, R¹⁰ and R¹¹ are hydrogen, wherein at least one of R¹, R², R³, R⁴, R⁵, R⁶, R⁷, R⁸, R⁹ and R¹¹, preferably at least one of R¹, R², R³, R⁴, R⁵, R⁶, R⁷ and R⁸, more preferably R² and/or R⁷ represents an amino group NR⁸⁴R⁸⁵.

9. The compound according to any one of claims 1 to 8, wherein the compound is represented by one of the following formulae

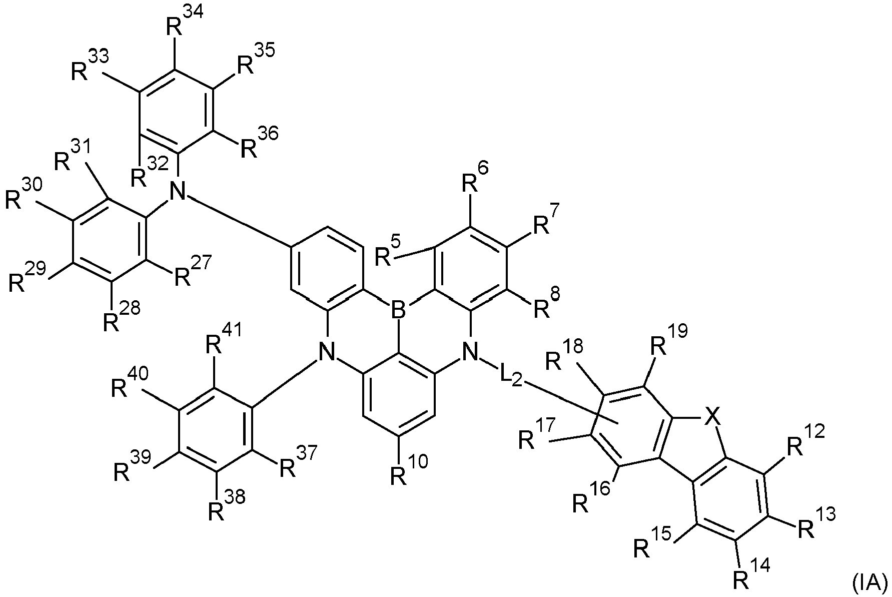

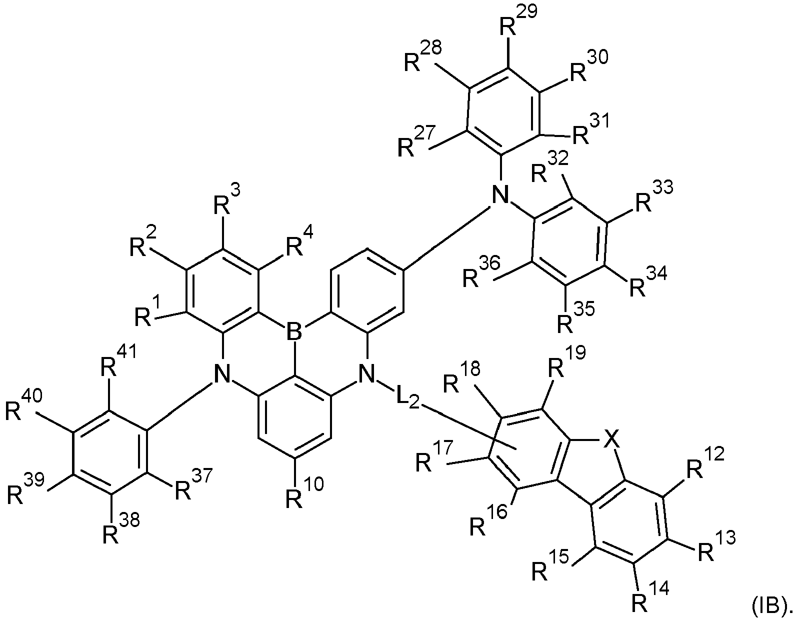

10. The compound according to claim 9, wherein the compound is represented by one of the following formulae 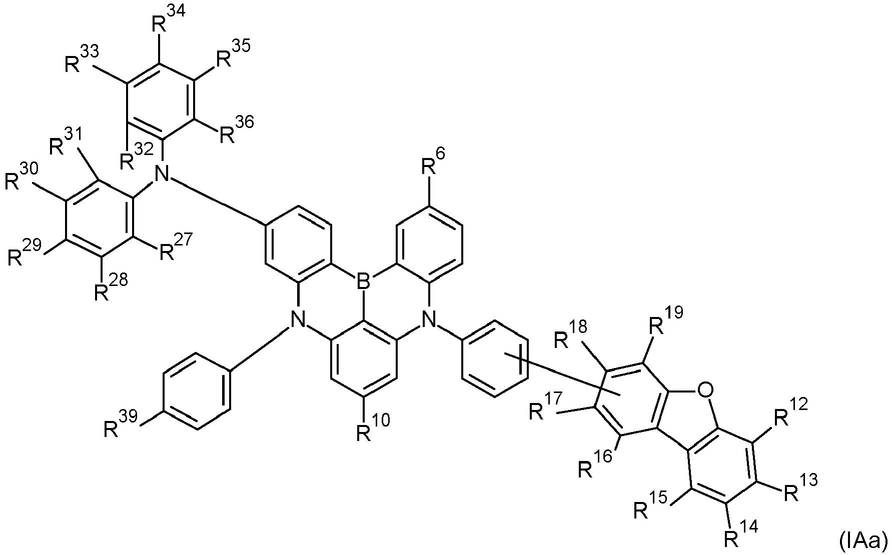 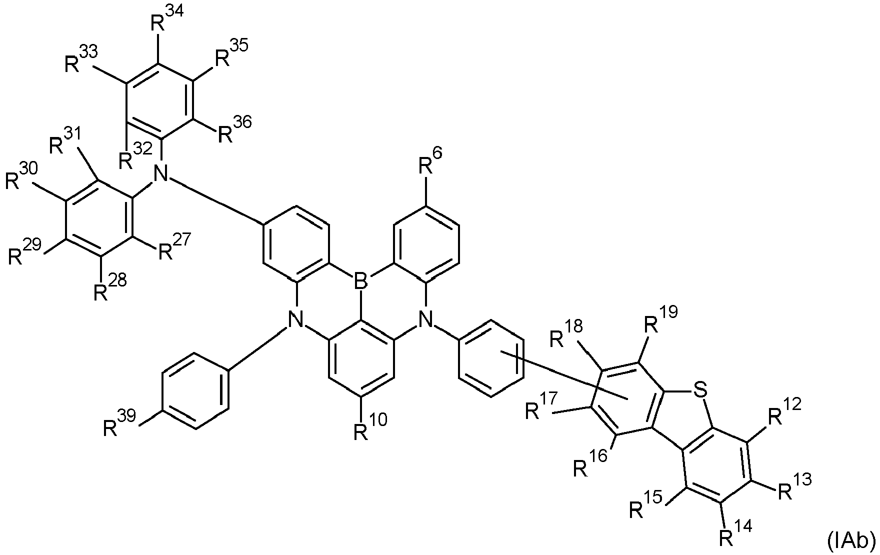 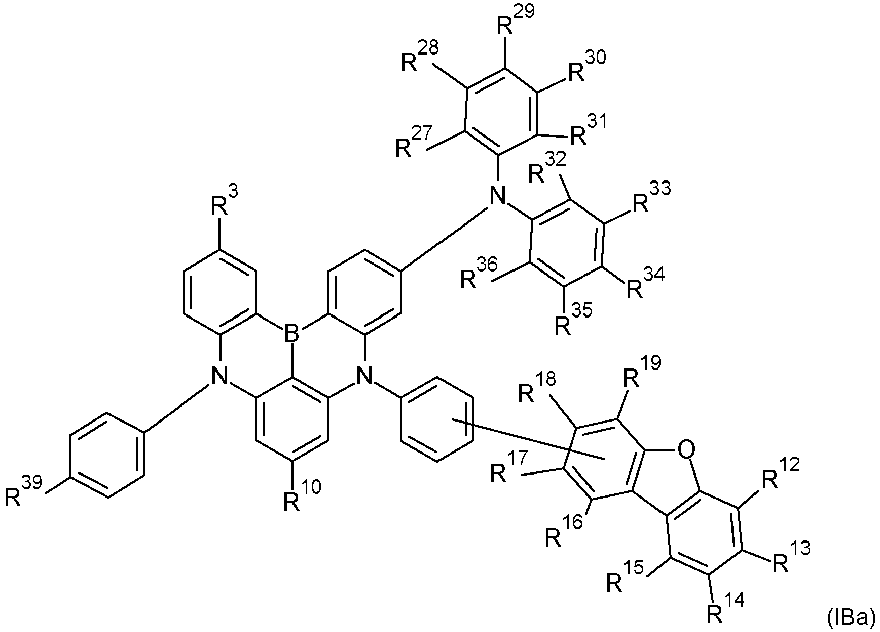 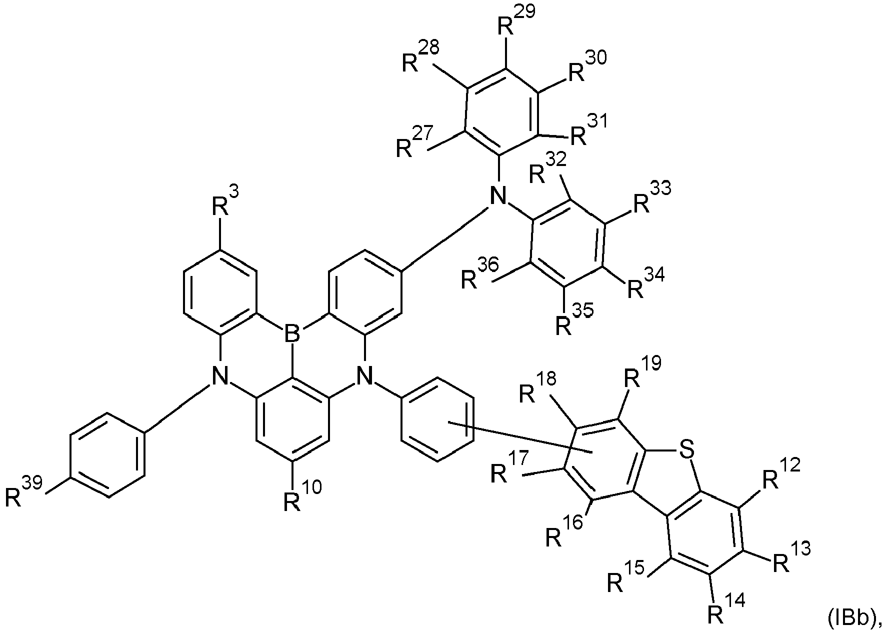 preferably (IBa) or (IBb), most preferably (IBa).

11. A material, preferably an emitter material, for an organic electroluminescence device, comprising at least one compound according to any one of claims 1 to 10.

12. An organic electroluminescence device comprising at least one compound according to any one of claims 1 to 10.

13. The organic electroluminescence device according to claim 12, comprising a cathode, an anode and one or more organic thin film layers comprising an emitting layer disposed between the cathode and the anode, wherein at least one layer of the organic thin film layers comprises at least one compound according to any one of claims 1 to 10.

14. The organic electroluminescence device according to claim 13, wherein the light emitting layer comprises at least one compound according to any one of claims 1 to 10.

15. The organic electroluminescence device according to claim 14, wherein the light emitting layer comprises at least one host and at least one dopant, wherein the dopant comprises at least one compound according to any one of claims 1 to 10.

16. The organic electroluminescence device according to claim 15, wherein the host comprises at least one substituted or unsubstituted fused aromatic hydrocarbon compound and/or at least one substituted or unsubstituted anthracene compound.

17. The organic electroluminescence device according to claim 16, wherein the anthracene compound is represented by the following formula (10): 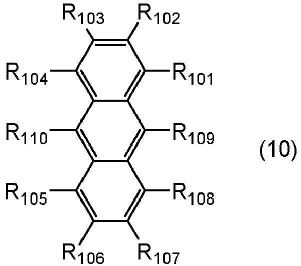 wherein
one or more pairs of two or more adjacent R₁₀₁ to R₁₁₀ may form a substituted or unsubstituted, saturated or unsaturated ring;
R₁₀₁ to R₁₁₀ that do not form the substituted or unsubstituted, saturated or unsaturated ring are independently a hydrogen atom, a substituted or unsubstituted alkyl group including 1 to 50 carbon atoms, a substituted or unsubstituted haloalkyl group including 1 to 50 carbon atoms, a substituted or unsubstituted alkenyl group including 2 to 50 carbon atoms, a substituted or unsubstituted alkynyl group including 2 to 50 carbon atoms, a substituted or unsubstituted cycloalkyl group including 3 to 50 ring carbon atoms, a substituted or unsubstituted alkoxy group including 1 to 50 carbon atoms, a substituted or unsubstituted alkylene group including 1 to 50 carbon atoms, a substituted or unsubstituted aryloxy group including 6 to 50 ring carbon atoms, a substituted or unsubstituted arylthio group including 6 to 50 ring carbon atoms, a substituted or unsubstituted aralkyl group including 7 to 50 carbon atoms, -Si(R₁₂₁)(R₁₂₂)(R₁₂₃), -C(=O)R₁₂₄, -COOR₁₂₅, -N(R₁₂₆)(R₁₂₇), a halogen atom, a cyano group, a nitro group, a substituted or unsubstituted aryl group including 6 to 50 ring carbon atoms, a substituted or unsubstituted monovalent heterocyclic group including 5 to 50 ring atoms, or a group represented by the following formula (31);
R₁₂₁ to R₁₂₇ are independently a hydrogen atom, a substituted or unsubstituted alkyl group including 1 to 50 carbon atoms, a substituted or unsubstituted cycloalkyl group including 3 to 50 ring carbon atoms, a substituted or unsubstituted aryl group including 6 to 50 ring carbon atoms or a substituted or unsubstituted monovalent heterocyclic group including 5 to 50 ring atoms; when each of R₁₂₁ to R₁₂₇ is present in plural, each of the plural R₁₂₁ to R₁₂₇ may be the same or different;
provided that at least one of R₁₀₁ to R₁₁₀ that do not form the substituted or unsubstituted, saturated or unsaturated ring is a group represented by the following formula (31). If two or more groups represented by the formula (31) are present, each of these groups may be the same or different; -
L₁₀₁-Ar₁₀₁ (31)
wherein in the formula (31),
L₁₀₁ is a single bond, a substituted or unsubstituted arylene group including 6 to 30 ring carbon atoms or a substituted or unsubstituted divalent heterocyclic group including 5 to 30 ring atoms;
Ar₁₀₁ is a substituted or unsubstituted aryl group including 6 to 50 ring carbon atoms or a substituted or unsubstituted monovalent heterocyclic group including 5 to 50 ring atoms.

18. An electronic equipment comprising the organic electroluminescence device according to any one of claims 12 to 17.

19. A light emitting layer comprising at least one host and at least one dopant, wherein the dopant comprises at least one compound according to any one of claims 1 to 10.

20. Use of a compound of formula (I) according to any one of claims 1 to 10 in an organic electroluminescence device.
